(19) **Europäisches Patentamt**
**European Patent Office**
**Office européen des brevets**

(11)   **EP 2 805 348 B1**

(12)   **EUROPEAN PATENT SPECIFICATION**

(45) Date of publication and mention
of the grant of the patent:
**12.07.2017   Bulletin 2017/28**

(21) Application number: **13752216.5**

(22) Date of filing: **19.02.2013**

(51) Int Cl.:
*H01L 21/461* (2006.01)     *G06K 19/07* (2006.01)
*G06K 19/077* (2006.01)     *G06K 19/08* (2006.01)
*G06K 7/08* (2006.01)     *G11B 5/008* (2006.01)
*H01L 25/00* (2006.01)     *H05K 1/18* (2006.01)
*H01L 25/065* (2006.01)

(86) International application number:
**PCT/US2013/026746**

(87) International publication number:
**WO 2013/126349 (29.08.2013 Gazette 2013/35)**

(54) **Device and method for detecting an external object by means of a capacitive sensor and an inductive sensor in a card**

Vorrichtung und Verfahren zum Detektieren eines externen Objektes mittels eines kapazitiven Sensors und eines induktiven Sensors in einer Karte

Dispositif et procédé pour détecter un objet externe au moyen d'un détecteur capacitif et d'un détecteur inductif dans une carte

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.02.2012   US 201261600950 P**
**29.06.2012   US 201261666553 P**
**29.10.2012   US 201261719703 P**
**19.12.2012   US 201261739614 P**
**20.12.2012   US 201261740173 P**
**18.01.2013   US 201361754424 P**

(43) Date of publication of application:
**26.11.2014   Bulletin 2014/48**

(73) Proprietor: **Dynamics Inc.**
**Cheswick, PA 15024 (US)**

(72) Inventors:
• **MULLEN, Jeffrey, D**
**Pittsburgh, PA 15232 (US)**
• **O'SHEA, Norman, E**
**Seven Fields, PA 16046 (US)**
• **HARTWICK, David, J.**
**Aliquippa, PA 15001 (US)**

• **BATRA, Gautam**
**Pittsburgh, PA 15215 (US)**
• **WORKLEY, James, H.**
**Imperial, PA 15126 (US)**
• **BRUNER, Kevin, D.**
**Pittsburgh, PA 15232 (US)**
• **SHIPPEE, Geoffrey, D.**
**Edgeworth, PA 15143 (US)**
• **BOWERS, Allen, D.**
**Aspinwall, PA 15215 (US)**
• **VETER, Andrew**
**Pittsburgh, PA 15238 (US)**

(74) Representative: **Rooney, John-Paul**
**Withers & Rogers LLP**
**4 More London Riverside**
**London SE1 2AU (GB)**

(56) References cited:
**US-A- 5 866 949     US-A1- 2004 179 718**
**US-A1- 2006 231 611     US-A1- 2009 159 663**
**US-A1- 2010 230 793     US-B2- 7 122 447**
**US-B2- 8 011 577**

**EP 2 805 348 B1**

**Description**

Background of the Invention

This invention relates to powered cards and devices and related systems.

US 2004/0179718 A1 discloses a card-type biometric identification device and method. US 2009/0159663 A1 discloses payment cards and devices operable to receive point of sale actions before point of sale and forward actions at point of sale.

Summary of the Invention

A card may include a dynamic magnetic communications device, which may take the form of a magnetic encoder or a magnetic emulator. A magnetic encoder, for example, may be utilized to modify information that is located on a magnetic medium, such that a magnetic stripe reader may then be utilized to read the modified magnetic information from the magnetic medium. A magnetic emulator, for example, may be provided to generate electromagnetic fields that directly communicate data to a read-head of a magnetic stripe reader. A magnetic emulator, for example, may communicate data serially to a read-head of the magnetic stripe reader. A magnetic emulator, for example, may communicate data in parallel to a read-head of the magnetic stripe reader.

All, or substantially all, of the front surface, as well as the rear surface, of a card may be implemented as a display (e.g., bi-stable, non bi-stable, LCD, or electrochromic display). Electrodes of a display may be coupled to one or more touch sensors, such that a display may be sensitive to touch (e.g., using a finger or a pointing device) and may be further sensitive to a location of the touch. The display may be sensitive, for example, to objects that come within a proximity of the display without actually touching the display.

A dynamic magnetic stripe communications device may be implemented on a multiple layer board (e.g., a two-layer flexible printed circuit board). A coil for each track of information that is to be communicated by the dynamic magnetic stripe communications device may then be provided by including wire segments on each layer and interconnecting the wire segments through layer interconnections to create a coil. For example, a dynamic magnetic stripe communications device may include two coils such that two tracks of information may be communicated to two different read-heads included in a read-head housing of a magnetic stripe reader. A dynamic magnetic communications device may include, for example, three coils such that three tracks of information may be communicated to three different read-heads included in a read-head housing of a magnetic stripe reader.

Input and/or output devices may be included on a card, for example, to facilitate data exchange with the card. For example, an integrated circuit (IC) may be included on a card and exposed from the surface of the card. Such a chip (e.g., an EMV chip) may communicate information to a chip reader (e.g., an EMV chip reader). An RFID antenna or module may be included on a card, for example, to send and/or receive information between an RFID writer/reader and the RFID included on the card.

One or more detectors may be provided on a card, for example, to sense the presence of an external object, such as a person or device, which in turn, may trigger the initiation of a communication sequence with the external object. The sensed presence of the external object may then be communicated to a processor of the card, which in turn may direct the exchange of information between a card and the external object. Accordingly, timing aspects of the information exchange between an external object and the various I/O devices provided on a card may also be determined by circuitry (e.g., a processor) provided on a card.

The sensed presence of the external object or device may include the type of object or device that is detected and, therefore, may then determine the type of communication that is to be used with the detected object or device. For example, a detected object may include a determination that the object is a read-head housing of a magnetic stripe reader. Such an identifying detection, for example, may activate a dynamic magnetic stripe communications device so that information may be communicated to the read-head of the magnetic stripe reader. Information may be communicated by a dynamic magnetic stripe communications device, for example, by re-writing magnetic information on a magnetic medium that is able to be read by a magnetic stripe reader or electromagnetically communicating data to the magnetic stripe reader.

One or more read-head detectors, for example, may be provided on a card. The one or more read-head detectors may be provided as, for example, conductive pads that may be arranged along a length of a card having a variety of shapes. A property (e.g., a capacitance magnitude) of one or more of the conductive pads may, for example, change in response to contact with and/or the presence of an object.

A card may, for example, be formed as a laminate structure of two or more layers. A card may, for example, include top and bottom layers of a plastic material (e.g., a polymer). Electronics package circuitry (e.g., one or more printed circuit boards, a dynamic magnetic stripe communications device, a battery, a display, a stacked-die processor, other stacked-die components, wire-bond interconnects, ball grid array interconnects, and buttons) may be sandwiched between top and bottom layers of a laminate structure of a card. A material (e.g., a polyurethane-based or silicon-based substance) may be injected between top and bottom layers and cured (e.g., solidified by an exposure to light, chemicals, or air) to form a hardened card that may include a flexible laminate structure having stacked structures sandwiched between layers of laminate.

A processor, application specific integrated circuit (ASIC), or other circuitry may, for example, be implemented on a semiconductor die. Such a die may, for example, be made to be thinner than its original thickness (e.g., by utilizing a grinding and/or polishing process). A die may, for example, be modified to a thickness of between approximately 20 microns and 0.010 inches. A die may, for example, be modified to a preferable thickness of between approximately 0.00025 inches and 0.004 inches.

Modifying a thickness (e.g., via a grinding or polishing process) of a die may, for example, render a modified die having flexibility attributes. For example, a thinner die may exhibit a minimum bend radius or maximum bend angle without damaging the components on the die. Accordingly, for example, a flexible die may be encapsulated between two flexible sheets of lamination to form a flexible card or device, which may be flexed to a minimum bend radius without damaging the die. In so doing, for example, the flexible die may be rolled to a maximum bend angle without damaging the die. Alternately, for example, such flexible die may be arranged on a tape reel and rolled for storage. Once needed, a machine (e.g., a pick-and-place machine) may retrieve the flexible die by unrolling the tape reel and extracting the die from the tape reel to apply them to a mechanical carrier (e.g., a printed circuit board).

An operation of a flexible card or device may be altered when the card or device is flexed. For example, bending a card or device while the card or device is in operation may cause the card or device to function differently (e.g., an oscillator on the card or device may oscillate at a slightly different frequency as compared to operation when the card or device is not being flexed). A processor on the card or device (e.g., a software routine executing on the processor) may detect the change in operation and may cause a reactive change to occur based on the change in operation.

Alternately, for example, a piezoelectric device may be used to detect flexing and a software component on the card or device may drive the resultant change in operation of a flexible card or device. Other alternatives may, for example, use redundant components (e.g., geographically spaced oscillators or piezoelectric devices) to detect portions of a card or device that are being flexed (e.g., components in the flexed area change their operation) and other portions of the card or device that are not being flexed (e.g., components in the non-flexed area do not change their operation). Still other alternatives may, for example, utilize thicker, non-flexible components and thinner, flexible components and compare the difference in operation between the flexible and non-flexible components to detect that a card or device may be flexing.

Decreasing a thickness of a die may, for example, allow two or more die to be stacked on top of one another without exceeding a height limit of the card or device. For example, multiple die may be ground to a thickness of between approximately 0.003 inches and 0.005 inches (e.g., approximately 0.004 inches) and may be stacked on top of one another. Accordingly, for example, two die may be stacked together to form a stacked assembly having a thickness of between approximately 0.006 and 0.010 inches (e.g., approximately 0.008 inches). Alternately, for example, three die may be stacked together to form a stacked assembly having a thickness of between approximately 0.010 and 0.014 inches (e.g., approximately 0.012 inches).

Stacked die may be arranged on a mechanical carrier (e.g., a PCB) from bottom to top in order of decreasing diameters. For example, a bottom die may exhibit a larger diameter than a die that is stacked on top of the bottom die. Accordingly, for example, interconnections (e.g., wire bonds) may be extended from the top die to the bottom die, from the bottom die to the underlying PCB and/or from the top die to the underlying PCB. Alternately, for example, chip-to-chip interconnections (e.g., flip-chip ball grid arrays) may be used to interconnect the stacked die and/or the underlying PCB.

A card may include a dynamic magnetic communications device. Such a dynamic magnetic communications device may take the form of a magnetic encoder or a magnetic emulator. A magnetic encoder may change the information located on a magnetic medium such that a magnetic stripe reader may read changed magnetic information from the magnetic medium. A magnetic emulator may generate electromagnetic fields that directly communicate data to a magnetic stripe reader. Such a magnetic emulator may communicate data serially to a read-head of the magnetic stripe reader. A magnetic emulator may include one or more coils. Each coil may be utilized to communicate a particular track of magnetic stripe data to a magnetic stripe track read-head of a magnetic stripe reader. For example, two coils may be utilized to communicate two tracks of magnetic stripe data to two read-heads inside a read-head housing.

A dynamic magnetic stripe communications device may be fabricated and assembled on one board at one facility (e.g., as a component of a card) while a different facility may fabricate and assemble a different board with, for example, a card's processor, dynamic magnetic communications device driver circuitry, user interfaces, read-head detectors, light emitting devices, displays, batteries, and any other type of sensor, device, or associated circuitry. The facility fabricating the board having a card's primary circuitry may receive the board having the dynamic magnetic stripe communications device from a different facility and a battery, and may assemble the two boards and the battery together.

The combined electronics package may then, for example, be provided to a lamination facility for lamination.

Alternatively, for example, lamination may occur at the facility that assembled the dynamic magnetic stripe communications device board and the primary circuit board together. The laminated card may then be provided to a personalization facility for personalization. During personalization, for example, a customer's personal data may be placed on the exterior of the card (e.g., printed, embossed, or laser etched) as well as programmed into a processor's memory.

The primary circuit boards for different types of cards may be manufactured independently of the dynamic magnetic communications devices. Accordingly, different facilities may be dedicated to manufacturing different types of cards. One facility, for example, may be dedicated to the manufacture of primary card boards for payment cards having displays. Another facility, for example, may be dedicated to the manufacture of primary card boards for security cards not having any displays. In this manner, dynamic magnetic stripe communications devices may be fabricated at dedicated facilities in high volume. These dynamic magnetic stripe communication devices may then be shipped to the various other facilities fabricating the primary boards for different types of cards.

In manufacturing multiple boards dedicated to particular functions, and later assembling these multiple boards together, for example, the reliability of the different boards may be tested separately before assembling. Additionally, for example, the dynamic magnetic communication device boards may be fabricated in a higher volume than the boards for the circuitry of any one card. In doing so, the costs associated with the fabrication of dynamic magnetic communication device boards may be decreased.

A primary circuit board may include multiple layers (e.g., three layers) and may be configured to support multiple devices. For example, a multi-layer circuit board may include a processor, a display, driving circuitry, buffer circuitry, buttons, a memory, a battery, a radio frequency identification (RFID) chip (and associated circuitry), an integrated circuit (IC) chip (and associated circuitry), external connectors, ports, antennas, electromagnetic field generators (and associated circuitry), read-head detectors and/or the like.

The buttons (e.g., one or more buttons) may be part of the primary circuit board and/or may be separate components. The buttons may each be associated with a different transaction account or feature. Alternatively, for example, a card may include a single button, but that single button may be used to, for example, toggle between multiple products.

The processor may be any type of processing device and may include on-board memory for storing information. Any number of components may communicate with the processor. For example, one or more displays may be coupled to the processor. A display driver circuit may be coupled between the display and the processor. A memory may be coupled to the processor. The memory may store data such as discretionary data codes associated with buttons of a card. Discretionary data codes may be recognized by remote servers to effect particular actions. For example, a discretionary data code may be stored in the memory and may be used to cause a third party service feature to be performed by a remote server.

A card may include any number of reader communication devices. For example, a card may include an IC chip (which may be implemented by the processor), an RFID chip and/or a magnetic stripe communications device. The IC chip (e.g., an EMV chip) may be used to communicate information to an IC chip reader through a connector (contact) or antenna (contactless). The RFID chip may be used to communicate information to an RFID reader via an antenna. The magnetic stripe communications device may be included to communicate information to a magnetic stripe reader. For example, a magnetic stripe communications device may provide electromagnetic signals to a magnetic stripe reader.

The multiple layer circuit board may include read head detectors configured to sense the presence of a magnetic stripe reader (e.g., a read-head housing of a magnetic stripe reader). Information sensed by the read-head detectors may be communicated to the processor to cause the processor to communicate information serially from electromagnetic generators to magnetic stripe track receivers in a read-head housing of a magnetic stripe reader. Driving circuitry may be utilized by the processor, for example, to control the electromagnetic generators.

A circuit board with multiple layers may include devices distributed across the layers in order to maintain thickness targets, avoid and/or prevent interference between components, improve device performance and/or the like. For example, a first layer of a circuit board may include an RFID chip, buttons, a processor, an IR transceiver, an application specific integrated circuit associated with a dynamic magnetic stripe communications device, battery pads, a test/communication port (e.g., a JTAG port), an EMV buffer, supporting circuitry, backers and/or the like. A second layer may include copper supports for the port, a copper pad operable as a die foundation for the on-board wire bonded ASIC of the first layer, head readers (e.g., e-sense pads), supporting circuitry, backers and/or the like. A third layer may include an external connector (e.g., an EMV connector), an RFID antenna, supporting circuitry, backers and/or the like.

Each of the layers of the circuit board may be differently shaped, include cutouts and/or may be of different sizes. For example, the first layer of the circuit board may be generally sized proportionally to a card and may include cutouts (e.g., cutouts, etched portions, and/or the like) for a magnetic stripe communications device and a battery. A border may remain around the cutout for the magnetic stripe communications device. The cutout for the battery may not include a border and may result in an "L" shaped layer. The second layer may be a middle layer of the circuit board that is generally sized proportionally to a card and may include a cutout for a battery. The second layer may be, for example, "L" shaped layer. The third layer of the circuit board may generally be rectangular and may be sized smaller than a card.

Prior to or during lamination, the first and second layers may be aligned such that the magnetic stripe communication device cutout of the first layer is aligned to the read head detectors of the second layer, and such that the battery cutouts of the first and second layers are aligned. The third layer may be positioned to overlap the first and second layers including the battery cutout (e.g., may provide a base for the battery), but may not extend into a region including the cutout for the magnetic stripe communication device and the read head detectors. The antenna of the third layer may be along the entire perimeter of the third layer and may be aligned so as not to interfere with the magnetic stripe communication device.

According to at least one example embodiment, the first and second layer may be on opposite sides of a top sheet, for example, a polyimide sheet. The cutout of the first layer may be a removal and/or absence of the first layer such that the sheet is exposed. A magnetic stripe communications device may be on the sheet. The third layer may be on, for example, a separate, bottom sheet (e.g., polyimide sheet). As one example, the second layer (e.g., a portion of the second layer) may be directly on the bottom sheet surface (e.g., no coverlay and/or the like) and the third layer may be on an opposite side of the bottom sheet from the second layer. The third layer and the bottom sheet may be a size of a portion of a card not including a magnetic stripe communications device. An antenna may occupy some or all of the bottom sheet as part of the third layer.

A multiple layer primary circuit board configuration may decrease a circuit board thickness in the magnetic stripe communication device region (which may be designed as thin as possible), may increase and/or maximize an RFID antenna size to improve communication gain, facilitate the inclusion of three or more reader communication devices in a single card, and improve overall communication performance of the reader communication devices.

Multiple boards may be soldered together. Different boards may also be mechanically and electrically coupled together, for example, via an epoxy or conductive tape. The various components of a card may be part of different circuit boards and/or separate components attached to the circuit boards. The separate components of each card may be, for example, assembled onto the boards. For example, a microprocessor die may be coupled to contacts of a portion of a board. The electronics package may then be laminated. Such a lamination may occur, for example, in an injection molding process (e.g., a reaction injection molding process) and/or the like. A laminate may be, for example, a silicon-based material or a polyurethane-based material.

Cards may be personalized using various types of wireless signals. For example, a card may include an infrared sensor. A personalization machine may include an IR transmitter. The IR transmitter may communicate personal data, such as one or more credit and/or debit card numbers, to an IR sensor located on the card. Similarly, a visible light sensor may be provided on a card for receiving visible light pulses from a visible light transmitter that are indicative of personal data for a card. Alternatively or additionally, for example, a wire-based signal may be provided to a card for personalization. For example, a card may include an IC chip that has contacts exposed on the surface of the card. Electrical connections may be made to such exposed contacts to provide personal data into the chip. Contacts may be placed on the card and connected to an embedded, non-exposed microprocessor such that the microprocessor may receive programming data from a wire-based connection.

An adapter may be provided that includes an infrared or visible light transmitter. Such an adapter may be provided over a contact for an IC chip communications device. Accordingly, an IC chip communications device may provide electronic signals to program, for example, an IC-chip card. However, an adapter may convert, for example, these electronic signals into visible or infrared bursts of light. Accordingly, an IC chip programmer may be utilized to program a card having an infrared or visible light sensor. Furthermore, for example, an adapter may be placed over a magnetic stripe encoder or an RFID signal generator that generates infrared or visible light pulses in response to magnetic stripe encoding signals or RFID programming signals. Where a card uses multiple reader communication devices, a processor may couple each device such that data may be communicated to the card only once during personalization.

Systems and methods are provided for detecting a read-head of a card reader using multiple types of read-head sensors on a powered card.

A card may include a dynamic magnetic communications device. Such a dynamic magnetic communications device may take the form of a magnetic encoder or an electromagnetic generator. A magnetic encoder may change the information located on a magnetic medium such that a magnetic stripe reader may read changed magnetic information from the magnetic medium. An electromagnetic generator may generate electromagnetic fields that directly communicate data to a magnetic stripe reader. Such an electromagnetic generator may communicate data serially to a read-head of the magnetic stripe reader.

A card may include one or more displays (e.g., bi-stable, non bi-stable, LCD, LED, or electrochromic displays) to display card numbers, verification codes and/or bar codes. All, or substantially all, of one or more surfaces of a card may be a display. Electrodes of the display may be coupled to one or more capacitive touch sensors such that a display may be provided as a touch-screen display. Any type of touch-screen display may be utilized. Such touch-screen displays may be operable of determining multiple points of touch. Accordingly, a barcode may be displayed across all, or substantially all, of a surface of a card. In doing so, computer vision equipment such as barcode readers may be less susceptible to errors in reading a displayed barcode.

A card may include a number of output devices to output dynamic information. For example, a card may include one or more RFIDs and/or IC chips to communicate to one or more RFID readers or IC chip readers, respectively. According to some example embodiments, a card may include three or more different types of output devices. A card may include devices to receive information. For example, an RFID and IC chip may both receive information and communicate information to an RFID and IC chip reader, respectively.

A device for receiving wireless information signals may be provided. A light sensing device and/or sound sensing device may be utilized to receive information wirelessly.

A card may include a central processor that communicates data through one or more output devices simultaneously (e.g., an RFID, IC chip, and a dynamic magnetic stripe communications device). The central processor may receive information from one or more input devices simultaneously (e.g., an RFID, IC chip, dynamic magnetic stripe devices, light sensing device, and a sound sensing device). A processor may be coupled to surface contacts such that the processor may perform the processing capabilities of, for example, an EMV chip. The processor may be laminated over and not exposed such that such a processor is not exposed on the surface of the card.

A card may be provided with a button in which the activation of the button causes a code to be communicated through a dynamic magnetic stripe communications device (e.g., the subsequent time a read-head detector on the card detects a read-head). The code may be indicative of, for example, a feature (e.g., a payment feature). The code may be received by the card via manual input (e.g., onto buttons of the card) or via a wireless transmission (e.g., via light, electromagnetic communications, sound, or other wireless signals). A code may be communicated from a webpage (e.g., via light and/or sound) to a card. A card may include a display such that a received code may be visually displayed to a user. In doing so, the user may be provided with a way to select, and use, the code via both an in-store setting (e.g., via a magnetic stripe reader) or an online setting (e.g., by reading the code from a display and entering the code into a text box on a checkout page of an online purchase transaction). According to at least one example embodiment, the code may indicate which of multiple buttons of a card is pressed. Such a code may be stored in a memory of the card prior to issuance to a user.

A remote server, such as a payment authorization server, may receive the code and may process a payment differently based on the code received. For example, a code may be a security code to authorize a purchase transaction. A code may provide a payment feature such that a purchase may be made with points, debit, credit, installment payments, or deferred payments via a single payment account number (e.g., a credit card number) to identify a user and a payment feature code to select the type of payment a user desires to utilize. A code may indicate which button is pressed by a user and additional features may be provided to a user (e.g., additional to the payment transaction). For example, additional features may include rewards for use of a card.

A dynamic magnetic stripe communications device may include an electromagnetic generator that comprises an inductor (e.g., a coil). Current may be provided through this inductor to create an electromagnetic field operable to communicate with the read-head of a magnetic stripe reader. The drive circuit may vary the amount of current travelling through the coil such that a track of magnetic stripe data may be communicated to a read-head of a magnetic stripe reader. A switch (e.g., a transistor) may be provided to enable or disable the flow of current according to, for example, a frequency/double-frequency (F2F) encoding algorithm. In doing so, bits of data may be communicated.

Electronics may be embedded between two layers of a polymer (e.g., a PVC or non-PVC polymer). One or more liquid polymers may be provided between these two layers. The liquid polymer(s) may, for example, be hardened via a reaction between the polymers (or other material), temperature, and/or via light (e.g., an ultraviolet or blue spectrum light) such that the electronics become embedded between the two layers of the polymer and a card is formed.

A card may include a plurality of types of sensors used to detect a read-head of a card reader. The types of sensors may be, for example, capacitive, inductive, photoelectric, sonic, magnetic and/or thermal.

A capacitive sensor may be a low power sensor including one or more conductive pads. An inductive sensor may be a high power sensor including one or more coils or portions of one or more coils. The one or more coils may include, for example, a coil of a dynamic magnetic stripe communications device and/or one or more coils separate from the dynamic magnetic stripe communications device.

Multiple types of read-head sensors may be used to improve the reliability of read-head detection, and to improve data security, without significantly increasing power consumption. For example, a capacitive sensor may detect any object in proximity to the sensor using little or no power. An inductive sensor may only detect objects that significantly change a coupling between a coil (or coil portion) and another coil (or another coil portion), and may use relatively high power (e.g., relative to capacitive sensing). For example, an inductive sensor may only detect conductive materials and therefore the read-head detection accuracy of an inductive sensor may be greater than a capacitive sensor. Accordingly, by activating an inductive sensor after a capacitive sensor detects an object, and for a relatively short period of time, a combination of sensors may be used to decrease false read-head detections and decrease erroneous data transmission without unduly increasing power consumption.

In an inductive sensor, a magnitude of a current or voltage across a detection coil may be used to discriminate between objects detected by the inductive sensor. For example, the greater the conductivity of an object, the greater an increase or decrease in the current or voltage across the detection coil. Therefore, the inductive sensor may be used to determine whether an object is an expected object based on conductivity. For example, an inductive sensor may detect relatively little current or voltage change in the presence of organic matter (e.g., a finger) and relatively high current or voltage change (e.g., a decrease in current or voltage) in the presence of a read-head. Further, a current or voltage change may be different even between types of read-heads (e.g., due to geometry, material types, etc.). Thus, an inductive sensor may be used to detect known types of read-heads, and detect unknown types of read-heads (e.g., skimmers) based on a detection signal. If a detection by a card does not match an expected detection, the card may not energize a dynamic magnetic stripe communications device to communicate data.

Additional and/or alternative sensors may be included in a card to increase the accuracy of detection and increase data security. For example, a card may include a photoelectric sensor to determine whether a card is within a card reader or exposed to ambient environmental conditions.

A sequence of events may be used to increase data security. For example, a sequence of detections of sensors on a card may indicate whether a card experiences an expected set of events, such as sequential detection by different types of sensors during a card swipe. If a sequence of detections by a card does not match an expected sequence, the card may not energize a dynamic magnetic stripe communications device to communicate data.

A dynamic magnetic stripe communications device may be implemented on a multiple layer board (e.g., a two-layer flexible printed circuit board). A coil for each track of information that is to be communicated by the dynamic magnetic stripe communications device may then be provided by including wire segments on each layer and interconnecting the wire segments through layer interconnections to create a coil. For example, a dynamic magnetic stripe communications device may include two coils such that two tracks of information may be communicated to two different read-heads included in a read-head housing of a magnetic stripe reader. A dynamic magnetic communications device may include, for example, three coils such that three tracks of information may be communicated to three different read-heads included in a read-head housing of a magnetic stripe reader.

Input and/or output devices may be included on a card, for example, to facilitate data exchange with the card. For example, an integrated circuit (IC) may be included on a card and exposed from the surface of the card. Such a chip (e.g., an EMV chip) may communicate information to a chip reader (e.g., an EMV chip reader). An RFID antenna or module may be included on a card, for example, to send and/or receive information between an RFID reader and the RFID included on the card.

One or more detectors may be provided, for example, to sense the presence of an external object, such as a person or device, which in turn, may trigger a communication sequence with the external object. Accordingly, for example, timing aspects of an information exchange between an external object and the various I/O devices implemented on a card may be determined by a processor of a card.

A sensed presence of an external object or device may include the type of object or device that is detected and, therefore, may then determine the type of communication that is to be used with the detected object or device. For example, a detected object may include a determination that the object is a read-head housing of a magnetic stripe reader. Such an identifying detection, for example, may activate a dynamic magnetic stripe communications device so that information may be communicated (e.g., electromagnetically communicated) to the read-head of the magnetic stripe reader.

One or more read-head detectors, for example, may be provided on a card. The one or more read-head detectors may be provided as, for example, conductive pads that may be arranged along a length of a card having a variety of shapes. A property (e.g., a capacitance magnitude) of one or more of the conductive pads may, for example, change in response to contact with and/or the proximity of an object.

A card may, for example, be swiped across a read-head of a magnetic stripe reader, such that a series of conductive pads arranged along a length of the card may be used to sequentially detect the presence of the read-head as the read-head moves in relation to the card. In doing so, for example, a series of detections (e.g., the capacitance magnitude of a series of conductive pads may increase and/or decrease) which may be indicative of a direction of a card swipe, a velocity of a card swipe and/or an acceleration of a card swipe.

In some instances, a width of a read-head may be wider than a single conductive pad (e.g., a read-head may span a width that may be substantially equal to a width of two conductive pads). As a result, more than one conductive pad may exhibit a change in capacitance magnitude when, for example, a read-head comes into contact with two or more conductive pads or when a read-head is positioned proximate to two or more conductive pads.

Nevertheless, rules may be implemented, for example, whereby a property change (e.g., an increased and/or decreased capacitance magnitude) detected in any one conductive pad during a first measurement period may not be allowed to affect a property change (e.g., an increased and/or decreased capacitance magnitude) detected in the same conductive pad during a second measurement period. Accordingly, for example, the accuracy of position, velocity and/or acceleration detections may not be affected by an analysis of property changes induced within one conductive pad over multiple periods of time. In so doing, a speed of a card swipe, for example, may be increased without sacrificing a detection accuracy of the card swipe (e.g., without losing the ability to detect a location, velocity and/or acceleration of a read head or contact with a read head in relation to a card being swiped through the read-head housing).

False alarm detection may be implemented to reduce occurrences of false alarms. For example, certain objects (e.g., a finger) may cause a processor of a card to detect, for example, a presence of a read-head housing of a magnetic stripe reader when, in fact, no read-head housing is present. In such instances, knowledge of, for example, a previously detected card swipe and associated direction may allow a second detection to be made, whereby a second read-head detection that is consistent with the originally detected card swipe direction may enable verification of a legitimate card swipe and, therefore, may enable a successful communication sequence with a magnetic stripe reader whose presence has been detected and verified.

For example, an analysis of a capacitance magnitude change of one or more conductive pads of a first row of conductive pads may be performed to determine, for example, a presence of a read-head and a direction of movement that the read-head exhibits relative to the first row of conductive pads. A subsequent analysis of a capacitance magnitude change of one or more conductive pads along a second row of conductive pads in the same direction as previously detected may serve to legitimize a first detection of a read-head and, therefore, may increase a probability that a successful communication sequence between the card and the magnetic stripe reader may transpire.

Systems and methods are provided for detecting a read-head of a card reader using multiple types of read-head sensors on a powered card.

A card may include a dynamic magnetic communications device. Such a dynamic magnetic communications device may include a magnetic encoder or an electromagnetic field generator. A magnetic encoder may change the information located on a magnetic medium such that a magnetic stripe reader may read changed magnetic information from the magnetic medium. An electromagnetic field generator may generate electromagnetic fields that directly communicate data to a magnetic stripe reader. Such an electromagnetic field generator may communicate data serially to a read-head of the magnetic stripe reader.

A card may include one or more displays (e.g., bi-stable, non bi-stable, LCD, LED, or electrochromic displays) to display card numbers, verification codes and/or bar codes. All, or substantially all, of one or more surfaces of a card may be a display. Electrodes of the display may be coupled to one or more capacitive touch sensors such that a display may be provided as a touch-screen display. Any type of touch-screen display may be utilized. Such touch-screen displays may be operable of determining multiple points of touch. Accordingly, a barcode may be displayed across all, or substantially all, of a surface of a card. In doing so, computer vision equipment such as barcode readers may be less susceptible to errors in reading a displayed barcode.

A card may include a number of output devices to output dynamic information. For example, a card may include one or more RFIDs and/or IC chips to communicate to one or more RFID readers or IC chip readers, respectively. According to some example embodiments, a card may include three or more different types of output devices. A card may include devices to receive information. For example, an RFID and IC chip may both receive information and communicate information to an RFID and IC chip reader, respectively.

A device for receiving wireless information signals may be provided. A light sensing device and/or sound sensing device may be utilized to receive information wirelessly.

A card may include a central processor that communicates data through one or more output devices simultaneously (e.g., an RFID, IC chip, and a dynamic magnetic stripe communications device). The central processor may receive information from one or more input devices simultaneously (e.g., an RFID, IC chip, dynamic magnetic stripe devices, light sensing device, and/or a sound sensing device). A processor may be coupled to surface contacts such that the processor may perform the processing capabilities of, for example, an EMV chip. The processor may be laminated over and not exposed such that such a processor is not exposed on the surface of the card.

A card may be provided with a button in which the activation of the button causes a code to be communicated through a dynamic magnetic stripe communications device (e.g., the subsequent time a read-head detector on the card detects a read-head). The code may be indicative of, for example, a feature (e.g., a payment feature). The code may be received by the card via manual input (e.g., onto buttons of the card) or via a wireless transmission (e.g., via light, electromagnetic communications, sound, or other wireless signals). A code may be communicated from a webpage (e.g., via light and/or sound) to a card. A card may include a display such that a received code may be visually displayed to a user. In doing so, the user may be provided with a way to select, and use, the code via both an in-store setting (e.g., via a magnetic stripe reader) or an online setting (e.g., by reading the code from a display and entering the code into a text box on a checkout page of an online purchase transaction). According to at least one example embodiment, the code may indicate which of multiple buttons of a card is pressed. Such a code may be stored in a memory of the card prior to issuance to a user.

A remote server, such as a payment authorization server, may receive the code and may process a payment differently based on the code received. For example, a code may be a security code to authorize a purchase transaction. A code may provide a payment feature such that a purchase may be made with points, debit, credit, installment payments, or deferred payments via a single payment account number (e.g., a credit card number) to identify a user and a payment feature code to select the type of payment a user desires to utilize. A code may indicate which button is pressed by a user and additional features may be provided to a user (e.g., additional to the payment transaction). For example, additional features may include rewards for use of a card.

A dynamic magnetic stripe communications device may include an electromagnetic field generator that comprises an inductor (e.g., a coil). Current may be provided through this inductor to create an electromagnetic field operable to communicate with the read-head of a magnetic stripe reader. The drive circuit may vary the amount of current travelling through the coil such that a track of magnetic stripe data may be communicated to a read-head of a magnetic stripe reader. A switch (e.g., a transistor) may be provided to enable or disable the flow of current according to, for example, a frequency/double-frequency (F2F) encoding algorithm. In doing so, bits of data may be communicated.

Electronics may be embedded between two layers of a polymer (e.g., a PVC or non-PVC polymer). One or more liquid polymers may be provided between these two layers. The liquid polymer(s) may, for example, be hardened via a reaction between the polymers (or other material), temperature, and/or via light (e.g., an ultraviolet or blue spectrum light) such that the electronics become embedded between the two layers of the polymer and a card is formed.

A card may include a plurality of types of sensors used to detect a read-head of a card reader. The types of sensors may be, for example, capacitive, inductive, photoelectric, sonic, magnetic and/or thermal.

A capacitive sensor may be a low power sensor including one or more conductive pads. An inductive sensor may be a high power sensor including one or more coils or portions of one or more coils. The one or more coils may include, for example, a coil of a dynamic magnetic stripe communications device and/or one or more coils separate from the dynamic magnetic stripe communications device.

An electromagnetic field generator may include a coil. According to some example embodiments, the coil may include bonding pads, connection pads and bonding wires. The connection pads may connect the bonding pads, for example, on a substrate in one direction. The bonding wire may bond to and connect the bonding pads, for example, in a second direction. The first and second directions may be tailored to a desired structure and/or desired electromagnetic characteristic. The bonding and/or connection pads may be, for example, deposited, etched and/or the like. According to at least one example embodiment, the bonding and/or connection pads may be circuit traces of a flexible printed circuit board.

According to some example embodiments, a coil may not include a bonding wire. A coil may include multiple substrates bonded to each other. Each substrate may include bonding pads connected by connection pads. The bonding pads on different substrates may be connected using, for example, a conductive adhesive. The connection pads may connect the bonding pads in different directions for different substrates. The different directions may be tailored to a desired structure and/or electromagnetic characteristic.

The electromagnetic field generator may include a core material to change characteristics of the electromagnetic field. The core material may be coated (e.g., coated with an insulator) and/or shaped (e.g., by beveling edges and/or forming a shaped core material). According to at least one example embodiment, the core material may be on connection pads and connected to a substrate by an adhesive in spaces between the connection pads.

The structure of the electromagnetic field generator may be encapsulated. One or more encapsulant materials and/or layers may be used. An encapsulating material may be deposited, for example, before wire bonding, after wire bonding and/or before and after wire bonding.

A device may, for example, be formed as a laminate structure of two or more layers. A device may, for example, include top and bottom layers of a plastic material (e.g., a polymer). Electronics package circuitry (e.g., one or more printed circuit boards, a dynamic magnetic stripe communications device, a battery, a display, a stacked-die processor, other stacked-die components, wire-bond interconnects, ball grid array interconnects, and buttons) may be sandwiched between top and bottom layers of a laminate structure of a device. A material (e.g., a polyurethane-based or silicon-based substance) may be injected between top and bottom layers and cured (e.g., solidified by an exposure to light, chemicals, or air) to form a hardened device that may include a flexible laminate structure having stacked structures sandwiched between layers of laminate.

A processor, application specific integrated circuit (ASIC), or other circuitry may, for example, be implemented on a semiconductor die. Such a die may, for example, be made to be thinner than its original thickness (e.g., by utilizing a grinding and/or polishing process). Modifying a thickness (e.g., via a grinding or polishing process) of a die may, for example, render a modified die having flexibility attributes. For example, a thinner die may exhibit a minimum bend radius or maximum bend angle without damaging the components of the die. Accordingly, for example, a flexible die may be encapsulated between two flexible sheets of lamination to form a flexible device, which may be flexed to a minimum bend radius without damaging the die.

A component of a flexible device (e.g., a thinned die) may be flexibly adhered to a flexible substrate (e.g., a flexible printed circuit board) with a flexible adhesive. The flexible adhesive may be non-anaerobic and low ionic. The use of a flexible adhesive may decrease a minimum bend radius or maximum bend angle of a flexible device (e.g., a flexible processor based device) by reducing the transfer of force between the flexible substrate and the die. For example, force transferred from a flexible substrate to a die may be due to device bending, material differences and/or imperfections (e.g., wrinkles) in thin flexible substrates, for example, polyimide substrates.

An operation of a flexible device may be altered when the device is flexed. For example, bending a device while the device is in operation may cause the device to function differently (e.g., an oscillator on the device may oscillate at a slightly different frequency as compared to operation when the device is not being flexed). A processor on the device (e.g., a software routine executing on the processor), or an application specific integrated circuit, may detect device flexure and may alert a user as to a degree of the flexure and/or change the operation of flexed devices. For example, a user may be alerted to a degree of flexure by a light source. The light source may indicate when the flexible device exceeds various bend angles (e.g., yellow light for potential damage, red light for likely damage). As another example, the operation of flexed devices may be changed by, for example, changing an amount of current passing through a component based on a degree of flexure to compensate for flexure induced changes of operation.

Flexure may be detected by a detector, for example, a piezoelectric device, a MEMS (e.g., a MEMS capacitor that changes capacitance during flexure), and/or the like. According to some example embodiments, a difference in operation between components (e.g., flexible and non-flexible components) may be used to detect that a device is being flexed.

Components may be stacked. For example, components (e.g., stacked die) may be arranged on a flexible substrate (e.g., a PCB) from bottom to top in order of decreasing diameters. A bottom component may exhibit a larger diameter than a component that is stacked on top of the bottom component. Interconnections (e.g., wire bonds) may be extended from the top component to the bottom component, from the bottom component to the underlying PCB and/or from the top component to the underlying PCB. According to some example embodiments, chip-to-chip interconnections (e.g., flip-chip ball grid arrays) may be used to interconnect the stacked components and/or the underlying PCB.

Stacked components may be flexibly adhered to each other with a flexible, low-ionic, non-anaerobic adhesive. The use of a flexible adhesive may decrease a minimum bend radius or maximum bend angle of a flexible device by reducing the transfer of force between the stacked components, and between the stacked components and a flexible substrate.

Brief Description of the Drawings

The principles and advantages of the present invention can be more clearly understood from the following detailed description considered in conjunction with the following drawings, in which the same reference numerals denote the same structural elements throughout, and in which:

FIG. 1 is an illustration of a card constructed in accordance with the principles of the present invention;
FIG. 2 is an illustration of a card constructed in accordance with the principles of the present invention;
FIG. 3 is an illustration of a card constructed in accordance with the principles of the present invention;
FIG. 4 is an illustration of a system constructed in accordance with the principles of the present invention;
FIG. 5 is an illustration of a system constructed in accordance with the principles of the present invention;
FIG. 6 is an illustration of process flow charts constructed in accordance with the principles of the present invention;
FIG. 7 shows cards and architectures constructed in accordance with the principles of the present invention;
FIGS. 8-10 show card layers constructed in accordance with the principles of the present invention;
FIG. 11 shows overlaid card layers constructed in accordance with the principles of the present invention;
FIG. 12 and 13 show cards in accordance with the principles of the present invention;
FIG. 14 is an illustration of a card and architecture constructed in accordance with the principles of the present invention;
FIG. 15 is an illustration of a card constructed in accordance with the principles of the present invention;
FIG. 16 is an illustration of a capacitive read-head sensor constructed in accordance with the principles of the present invention;
FIG. 17 is an illustration of an inductive read-head sensor constructed in accordance with the principles of the present invention;
FIG. 18 is an illustration of an inductive read-head sensor constructed in accordance with the principles of the present invention;
FIG. 19 is an illustration of a card constructed in accordance with the principles of the present invention;
FIG. 20 is an illustration of a process flow in accordance with the principles of the present invention; and
FIG. 21 is an illustration of an inductive read-head sensor constructed in accordance with the principles of the present invention;
FIG. 22 is an illustration of a card constructed in accordance with the principles of the present invention;
FIG. 23 is an illustration of a card constructed in accordance with the principles of the present invention;
FIG. 24 is an illustration of circuitry, and associated waveforms, constructed in accordance with the principles of the present invention;
FIG. 25 is an illustration of a card constructed in accordance with the principles of the present invention;

FIG. 26 is an illustration of a card constructed in accordance with the principles of the present invention;

FIG. 27 is an illustration of process flow charts constructed in accordance with the principles of the present invention;

FIG. 28 shows a card and architecture constructed in accordance with the principles of the present invention;

FIG. 29 shows a plan view of electromagnetic field generators constructed in accordance with the principles of the present invention;

FIG. 30 shows a cross-sectional view taken along line III-III' of FIG. 23;

FIG. 31 shows plan views of electromagnetic field generators constructed in accordance with the principles of the present invention;

FIG. 32 shows a cross-sectional view of an electromagnetic field generator constructed in accordance with the principles of the present invention;

FIG. 33 shows plan views of electromagnetic field generators constructed in accordance with the principles of the present invention;

FIG. 34 shows a partial cross-section of an electromagnetic field generator constructed in accordance with the principles of the present invention;

FIG. 35 shows partial cross-sections of electromagnetic field generators constructed in accordance with the principles of the present invention;

FIG. 36 shows a cross-sectional view of an electromagnetic field generator that may be included in a dynamic magnetic stripe communication device constructed in accordance with the principles of the present invention;

FIG. 37 is an illustration of a card constructed in accordance with the principles of the present invention;

FIG. 38 is an illustration of a flexible assembly constructed in accordance with the principles of the present invention;

FIG. 39 is an illustration of a device constructed in accordance with the principles of the present invention;

FIG. 40 is an illustration of a flexible assembly constructed in accordance with the principles of the present invention;

FIG. 41 is an illustration of a flexible assembly constructed in accordance with the principles of the present invention; and

FIG. 42 illustrates process flow charts constructed in accordance with the principles of the present invention.

Detailed Description of the Invention

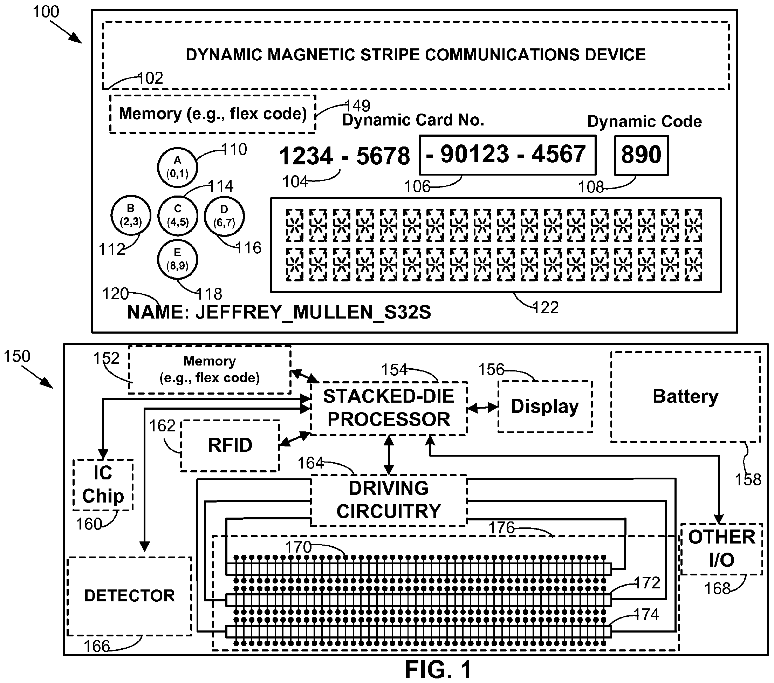

FIG. 1 shows card 100 that may include, for example, a dynamic number that may be entirely, or partially, displayed using a display (e.g., display 106). A dynamic number may include a permanent portion such as, for example, permanent portion 104 and a dynamic portion such as, for example, dynamic portion 106. Card 100 may include a dynamic number having permanent portion 104 and permanent portion 104 may be incorporated on card 100 so as to be visible to an observer of card 100. For example, labeling techniques, such as printing, embossing, laser etching, etc., may be utilized to visibly implement permanent portion 104.

Card 100 may include a second dynamic number that may be entirely, or partially, displayed via a second display (e.g., display 108). Display 108 may be utilized, for example, to display a dynamic code such as a dynamic security code. Card 100 may also include third display 122 that may be used to display graphical information, such as logos and barcodes. Third display 122 may also be utilized to display multiple rows and/or columns of textual and/or graphical information.

Persons skilled in the art will appreciate that any one or more of displays 106, 108, and/or 122 may be implemented as a bi-stable display. For example, information provided on displays 106, 108, and/or 122 may be stable in at least two different states (e.g., a powered-on state and a powered-off state). Any one or more of displays 106, 108, and/or 122 may be implemented as a non-bi-stable display. For example, the display is stable in response to operational power that is applied to the non-bi-stable display. Other display types, such as LCD or electrochromic, may be provided as well.

Other permanent information, such as permanent information 120, may be included within card 100, which may include user specific information, such as the cardholder's name or username. Permanent information 120 may, for example, include information that is specific to card 100 (e.g., a card issue date and/or a card expiration date). Information 120 may represent, for example, information that includes information that is both specific to the cardholder, as well as information that is specific to card 100.

Card 100 may accept user input data via any one or more data input devices, such as buttons 110-118. Buttons 110-118 may be included to accept data entry through mechanical distortion, contact, or proximity. Buttons 110-118 may be responsive to, for example, induced changes and/or deviations in light intensity, pressure magnitude, or electric and/or magnetic field strength. Such information exchange may then be determined and processed by a processor of card 100 as data input.

Card 100 may be flexible. Card 100 may, for example, contain hardware and/or software (e.g., flex code stored in memory 152) that when executed by a processor of card 100 may detect when card 100 is being flexed. Flex code 152 may, for example, provide processor executable applications that may detect a change in operation of card 100 based on the flexed condition of card 100 and may alter functions of card 100 based on the detected change in operation.

FIG. 1 shows architecture 150, which may include one or more processors (e.g., in stacked-die processor arrangement 154). Stacked-die processor 154 may be configured to utilize external memory 152, internal memory of stacked-die processor 154, or a combination of external memory 152 and internal memory for dynamically storing information, such as executable machine language (e.g., flex code), related dynamic machine data, and user input data values. Stacked-die processor 154 may, for example, execute code contained within memory 152 to detect when a card (e.g., card 100 of FIG. 1) is being flexed. The executed code may, for example, change the operation of a card (e.g., card 100 of FIG. 1) based on the detected change in operation.

Stacked-die processor 154 may be a combination of two or more die stacked on top of one another. The stacked arrangement may, for example, be attached to a mechanical carrier (e.g., a PCB) where a bottom die may exhibit a larger diameter than a die stacked on top of the bottom die. Accordingly, for example, interconnections (e.g., wire bonds) may be placed from one die to another die and/or from each die to the underlying PCB. Alternately, for example, stacked-die processor 154 may be a flip-chip combination, where die-to-die and/or die-to-PCB connections may be established using through-die connections and associated interconnections (e.g., a ball grid array). In so doing, for example, each of the stacked die may exhibit the same or different diameters.

One or more of the components shown in architecture 150 may be configured to transmit information to stacked-die processor 154 and/or may be configured to receive information as transmitted by stacked-die processor 154. For example, one or more displays 156 may be coupled to receive data from stacked-die processor 154. The data received from stacked-die processor 154 may include, for example, at least a portion of dynamic numbers and/or dynamic codes.

One or more displays 156 may be, for example, touch sensitive and/or proximity sensitive. For example, objects such as fingers, pointing devices, etc., may be brought into contact with displays 156, or in proximity to displays 156. Detection of object proximity or object contact with displays 156 may be effective to perform any type of function (e.g., transmit data to stacked-die processor 154). Displays 156 may have multiple locations that are able to be determined as being touched, or determined as being in proximity to an object.

Input and/or output devices may be implemented on architecture 150. For example, integrated circuit (IC) chip 160 (e.g., an EMV chip) may be included within architecture 150, that may communicate information to a chip reader (e.g., an EMV chip reader). Radio frequency identification (RFID) module 162 may be included within architecture 150 to enable the exchange of information with an RFID reader/writer.

Other input and/or output devices 168 may be included within architecture 150, for example, to provide any number of input and/or output capabilities. For example, other input and/or output devices 168 may include an audio device capable of receiving and/or transmitting audible information.

Other input and/or output devices 168 may include a device that exchanges analog and/or digital data using a visible data carrier. Other input and/or output devices 168 may include a device, for example, that is sensitive to a non-visible data carrier, such as an infrared data carrier or an electromagnetic data carrier.

Persons skilled in the art will appreciate that a card (e.g., card 100 of FIG. 1) may, for example, contain stacked-die components on a mechanical carrier (e.g., a PCB) other than stacked-die processor 154. RFID 162, IC chip 160, memory 153, and/or other I/O 168 may, for example, each be implemented on a semiconductor die. Two or more of such components may be stacked and interconnected via wire-bonding, ball grid array, or other connection types. Accordingly, for example, surface area on the PCB may be conserved by adding components in vertical fashion rather than adding components laterally across the surface area of the PCB.

Persons skilled in the art will further appreciate that a card (e.g., card 100 of FIG. 1) may, for example, be a self-contained device that derives its own operational power from one or more batteries 158. Furthermore, one or more batteries 158 may be included, for example, to provide operational power for a period of time (e.g., approximately 2-4 years). One or more batteries 158 may be included, for example, as rechargeable batteries.

Electromagnetic field generators 170-174 may be included within architecture 150 to communicate information to, for example, a read-head of a magnetic stripe reader via, for example, electromagnetic signals. For example, electromagnetic field generators 170-174 may be included to communicate one or more tracks of electromagnetic data to read-heads of a magnetic stripe reader. Electromagnetic field generators 170-174 may include, for example, a series of electromagnetic elements, where each electromagnetic element may be implemented as a coil wrapped around one or more materials (e.g., a magnetic material and/or a non-magnetic material). Additional materials may be placed outside the coil (e.g., a magnetic material and/or a non-magnetic material).

Electrical excitation by stacked-die processor 154 of one or more coils of one or more electromagnetic elements via, for example, driving circuitry 164 may be effective to generate electromagnetic fields from one or more electromagnetic elements. One or more electromagnetic field generators 170-174 may be utilized to communicate electromagnetic information to, for example, one or more read-heads of a magnetic stripe reader.

Timing aspects of information exchange between architecture 150 and the various I/O devices implemented within architecture 150 may be determined by stacked-die processor 154. Detector 166 may be utilized, for example, to sense the proximity and/or actual contact, of an external device, which in turn, may trigger the initiation of a communication sequence. The sensed presence and/or touch of the external device may then be communicated to a controller (e.g., stacked-die processor 154), which in turn may direct the exchange of information between architecture 150 and the external device. The sensed presence and/or touch of the external device may be effective to, for example, determine the type of device or object detected.

For example, the detection may include the detection of, for example, a read-head of a magnetic stripe reader. In response, stacked-die processor 154 may activate one or more electromagnetic field generators 170-174 to initiate a communications sequence with, for example, one or more read-heads of a magnetic stripe reader. The timing relationships associated with communications between one or more electromagnetic field generators 170-174 and one or more read-heads of a magnetic stripe reader may be provided through use of the detection of the magnetic stripe reader.

Persons skilled in the art will appreciate that stacked-die processor 154 may provide user-specific and/or card-specific information through utilization of any one or more of buttons 110-118, RFID 162, IC chip 160, electromagnetic field generators 170-174, and other input and/or output devices 168.

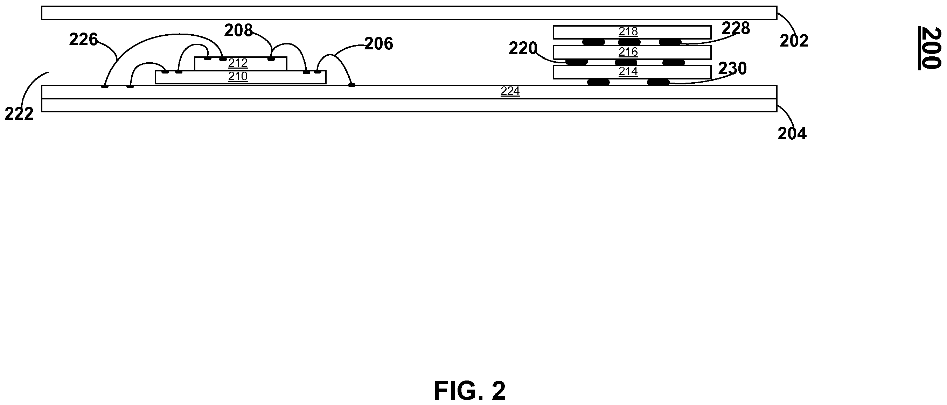

FIG. 2 shows card 200. Card 200 may, for example, include a layer of plastic (e.g., polymer layer 202) that may be approximately between 0.003 inches and 0.007 inches (e.g., approximately 0.005 inches) thick. Card 200 may, for example, include a layer of plastic (e.g., polymer layer 204) that may be approximately between 0.003 inches and 0.007 inches (e.g., approximately 0.005 inches) thick.

Card 200 may include stacked-die components 210-218. Stacked-die components 210-218 may, for example, include processors, ASICs, mixed-signal devices, transistor devices, and any other device. Stacked-die components 210-218 may, for example, be thinned (e.g., via a grinding or polishing process). Such a thinning process may reduce a thickness of stacked-die components 210-218 to a thickness of between approximately 20 microns and 0.010 inches. A thickness of a die may be thinned to approximately between 0.00025 inches and .008 inches (e.g., approximately 0.004 inches). Stacked-die components 210-218 may be attached to a mechanical carrier (e.g., PCB 224).

Mechanical and/or electrical interconnections between die 210 and die 212 may, for example, include wire-bonds 208. Mechanical and/or electrical interconnections between die 210 and PCB 224 may, for example, include wire-bonds 206. Mechanical and/or electrical interconnections between die 212 and PCB 224 may, for example, include wire-bonds 226. Die 212 may exhibit a smaller diameter as compared to die 210. Accordingly, for example, wire-bond connections between die 210 and 212, between die 210 and PCB 224, and between die 212 and PCB 224 may be facilitated. A top-down (e.g., birds-eye) view (not shown) of die 210, die 212, and PCB 224 may, for example, illustrate that interconnect pads associated with wire bonds 206, 208, and 226 may be staggered so as to substantially reduce a possibility of shorting bonding wires to interconnect pads not associated with such bonding wires.

Electrical and/or mechanical interconnections between die 214 and die 216 may, for example, include flip-chip solder balls 220 of a ball grid array. Electrical and/or mechanical interconnections between die 216 and die 218 may, for example, include flip-chip solder balls 228 of a ball grid array. Electrical and/or mechanical interconnections between die 214 and PCB 224 may, for example, include flip-chip solder balls 230 of a ball grid array. Accordingly, for example, die 214, 216, and 218 may exhibit the same, or different, diameters.

Through-die vias may, for example, provide electrical connectivity between any one or more die 214-218 and PCB 224. For example, electrical signals may be communicated between die 218 and 216, between die 218 and 214, between die 216 and 214 and between any one or more of die 214-218 and PCB 224 using conductive vias that may extend through die 214-218 and may be electrically interconnected via solder balls 220, 228 and/or 230 of their respective ball grid arrays.

Card 200 may include an encapsulant, which may include a layer of material 222 (e.g., a material formed from one or more polyurethane-based or silicon-based substances). Material 222 may be a substance that changes its physical state (e.g., changes from a liquid substance to a solid substance) when cured by one or more conditions (e.g., air, heat, pressure, light, or chemicals) for a period of time. Accordingly, for example, card 200 may be hardened, but may remain flexible, so that card 200 may be flexed to exhibit either of a convex or concave shape, while returning to a substantially flat orientation once flexing ceases.

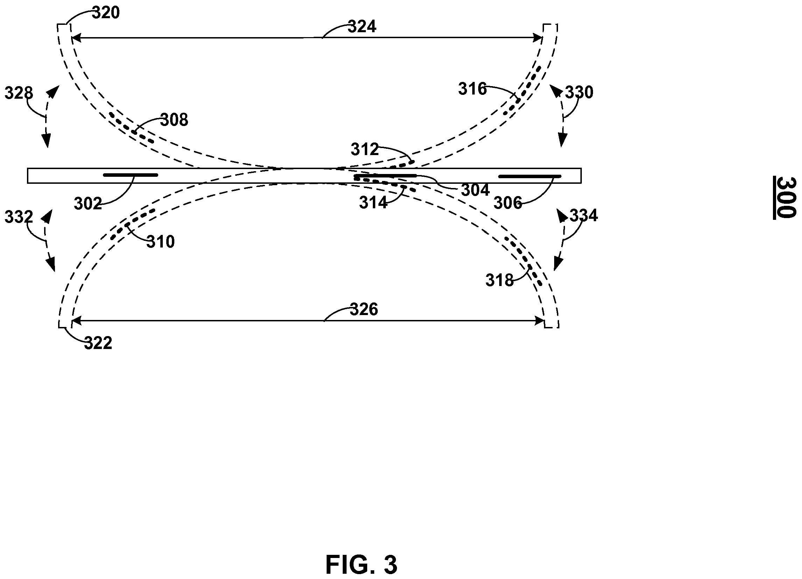

FIG. 3 shows card or device 300. Card or device 300 may, for example, be a laminated assembly, which may include top and bottom layers of a plastic (e.g., polymer top and bottom layers) with components 302, 304 and 306 encapsulated there between. An encapsulant of card or device 300 may be cured (e.g., hardened) such that card or device 300 may be rigid, yet flexible.

Components 302-306 may be electrical devices (e.g., stacked or non-stacked die) and/or mechanical devices (e.g., buttons) that may be flexible, such that when card or device 300 is flexed, components 302-306 may also flex. Card or device 300 may, for example, include other devices (not shown) that may not be flexible. Accordingly, for example, those devices of card or device 300 that may flex when card or device is flexed may also change their operation as compared to those devices that do not flex. In so doing, for example, detectors (not shown) may be placed within card or device 300 to detect such a change in operation and may take some action based upon such a detected change in operation.

Card or device 300 may be flexed in direction 328 and/or 330 to bend card or device 300 into a concave orientation having minimum bend radius 324. Components 302-306 may assume positions 308, 312 and 316, respectively, as a result of such flexing. Components 302-306 may exhibit an adequately reduced thickness (e.g., via a grinding or polishing process) such that flexing does not destroy the operation of components 302-306 and may or may not change the operation of components 302-306.

Card or device 300 may be flexed in direction 332 and/or 334 to bend card or device 300 into a convex orientation having minimum bend radius 326. Components 302-306 may assume positions 310, 314, and 318, respectively, as a result of such flexing. Components 302-306 may exhibit an adequately reduced thickness (e.g., via a grinding or polishing process) such that flexing does not destroy the operation of components 302-306 and may or may not change the operation of components 302-306.

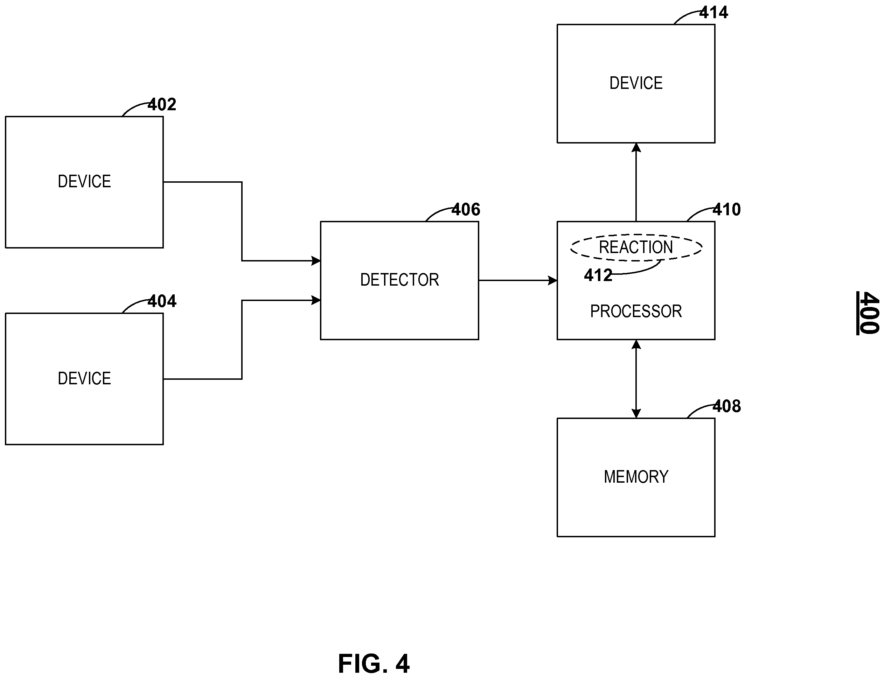

FIG. 4 shows system 400 of a card or device, which may include devices 402 and 404, detector 406, processor 410, memory 408, reaction process 412, and device 414. Devices 402 and 404 may, for example, be devices that may be geographically spaced apart from one another on a card or device. Devices 402 and 404 may, for example, be devices whose operation may change when flexed. For example, devices 402 and 404 may be provided on one or more die, where each die may exhibit a thickness between approximately 0.00025 inches and 0.007 inches (e.g., approximately 0.004 inches). Further, devices 402 and 404 may be mounted on a mechanical carrier (e.g., a PCB) that may also be flexible. Accordingly, for example, devices 402 and 404 may be flexed during operation of system 400. In so doing, for example, the operation of devices 402 and 404 may change based upon such flexing.

Detector 406 may, for example, sample an output of device 402 and/or device 404 to determine whether device 402 and/or device 404 are being flexed during operation. Device 402 and/or device 404 may, for example, be provided as an oscillating device (e.g., an oscillator or piezoelectric device). Accordingly, for example, an oscillation frequency of such devices may change and such a change in oscillation frequency may be detected by detector 406.

The detected change in operation may, for example, be reported to processor 410, which may be executing code (e.g., flex code), which may be resident within memory 408. Accordingly, for example, a software process (e.g., reaction process 412) executing on processor 410 may receive a detected change in operation from detector 406 that may be based upon a detected flexing of system 400 (e.g., the operation of device 402 and/or device 404 may change when a card or device is flexed) and may initiate a reaction (e.g., a reaction initiated by reaction process 412) that may be based upon the detected change in operation. Reaction process 412 may, for example, control an operation of device 414 based upon the detected change in operation of device 402 and/or device 404.

A geographic separation of device 402 and device 404 on a card or device may, for example, allow detector 406 to determine whether specific geographic regions of a card or device are being flexed. For example, detector 406 may detect a change in operation of device 402, but may detect no change in operation of device 404 while the card or device is being flexed. Accordingly, for example, reaction process 412, as executed by processor 410, may determine that the geographic region of device 402 is being flexed while the geographic region of device 404 is not being flexed. In so doing, for example, reaction process 412 may effect a change in operation of a device (e.g., device 414) based upon a change in operation of device 402.

In an alternate example, device 402 and device 404 may exist in the same geographic region of a card or device. Device 402 may, for example, be a non-flexible device. Device 404 may, for example, be a flexible device. Accordingly, for example, while a card or device is being flexed, an operation of device 402 may not change while an operation of device 404 may change. Such a difference in operation may be detected by detector 406. In so doing, for example, reaction process 412, as executed by processor 410, may determine that a difference in operation between devices 402 and 404 exists and may alter an operation of a device (e.g., device 414) based upon such a difference in operation.

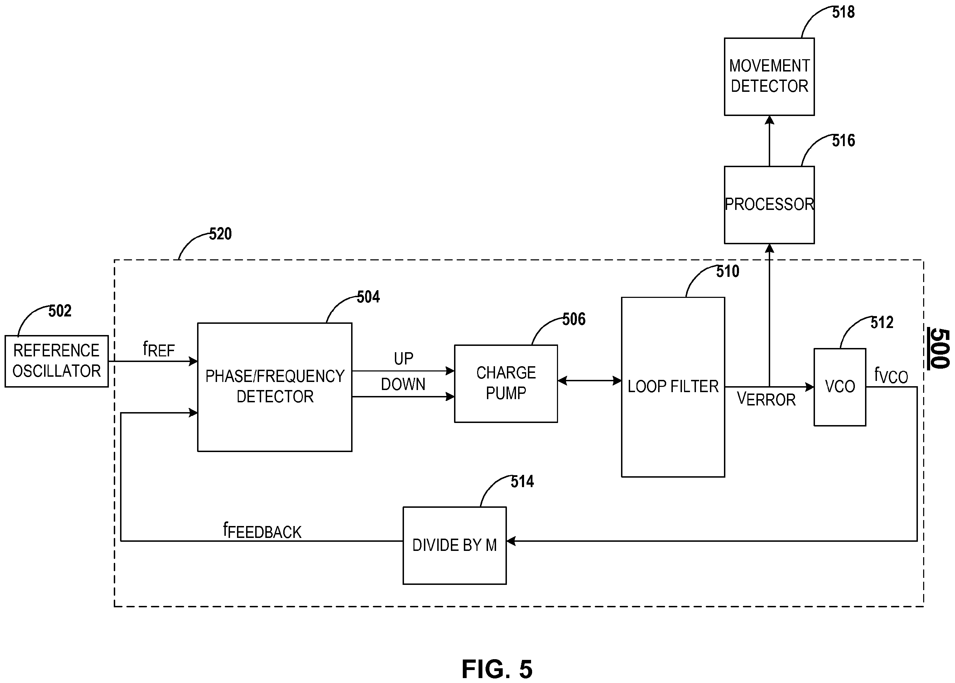

FIG. 5 shows system 500 that may, for example, provide a detected change in operation of a flexed component (e.g., reference oscillator 502) of a flexed card or device. System 500 may include a phase locked loop (e.g., PLL 520) that may include phase/frequency detector 504, charge pump 506, loop filter 510, VCO 512, and divider 514. PLL 520 may, for example, be implemented on a die that may not flex (e.g., PLL 520 may be implemented on a thicker die as compared to a thickness of a die that reference oscillator 502 may be implemented upon). Accordingly, for example, the operation of PLL 520 may not change when the card or device that PLL 520 is implemented upon may flex. Further, for example, the operation of reference oscillator 502 may change when the card or device that reference oscillator 502 is implemented upon may flex.

In operation, phase/frequency detector 504 may provide signals (e.g., UP and DOWN), which may correspond to the phase/frequency error between $f_{REF}$ and $f_{FEEDBACK}$. For example, if the phase/frequency of the output of divider 514 is lagging signal $f_{REF}$, then a pulse width of signal UP may increase and a pulse width of signal DOWN may decrease to cause the phase/frequency of VCO 512 to be advanced in phase/frequency. Conversely, if the phase/frequency of the output of divider 514 is advanced with respect to signal $f_{REF}$, then the pulse width of signal UP may decrease and the pulse width of signal DOWN may increase to cause the phase/frequency of VCO 512 to be retarded in phase/frequency.

Charge pump 506 may react to signals UP and/or DOWN by generating an error signal. For example, if the pulse width of signal UP is increased, the magnitude of the error signal may also increase. If the pulse width of signal DOWN is increased, for example, then the magnitude of the error signal may also decrease. The error signal may, for example, be filtered by loop filter 510 and provided to VCO 512 to set the output phase/frequency, $f_{VCO}$, of VCO 512. Through negative feedback, the phase/frequency error between $f_{REF}$ and $f_{FEEDBACK}$ may be tracked and cancelled by PLL 520.

A phase/frequency error between $f_{REF}$ and $f_{FEEDBACK}$ may, for example, occur when a flexing of a card or device causes reference oscillator 502 to change its operation (e.g., to change a phase or frequency of operation of reference oscillator 502). Such a phase/frequency error may be detected by processor 516, for example, by monitoring a magnitude of signal $V_{ERROR}$. Accordingly, for example, processor 516 may detect when a component of a card or device (e.g., reference oscillator 502) changes its operation when flexed. In so doing, for example, a software application executed by processor 516 may receive the detected change in operation and may implement a reactive change in operation of another component (e.g., movement detector 518) of a card or device.

Movement detector 518 may include an orientation of conductive pads, whereby one or more conductive pads may be arranged along a length of a card or device. Movement detector 518 may, for example, detect a location of an object (e.g., a read head of a magnetic card reader) by detecting a characteristic change (e.g., a capacitance change) in relation to the conductive pads of movement detector 518. In addition, by monitoring a characteristic change (e.g., a capacitance change) associated with one or more of the conductive pads and by comparing a characteristic change of neighboring conductive pads, a position and/or velocity and/or acceleration estimate of an object moving in relation to such conductive pads may be obtained.

A frequency at which a capacitance change in the conductive pads of movement detector 518 may be sampled may, for example, be adjusted based upon a detected change in operation of reference oscillator 502. Accordingly, for example, if a decrease in a phase/frequency of operation of reference oscillator 502 is detected by processor 516 in relation to a flex event of a card or device, then processor 516 may increase a sampling frequency of movement detector 518 to compensate. Alternately, for example, if an increase in a phase/frequency of operation of reference oscillator 502 is detected by processor 516 in relation to a flex event of a card or device, then processor 516 may decrease a sampling frequency of movement detector 518 to compensate.

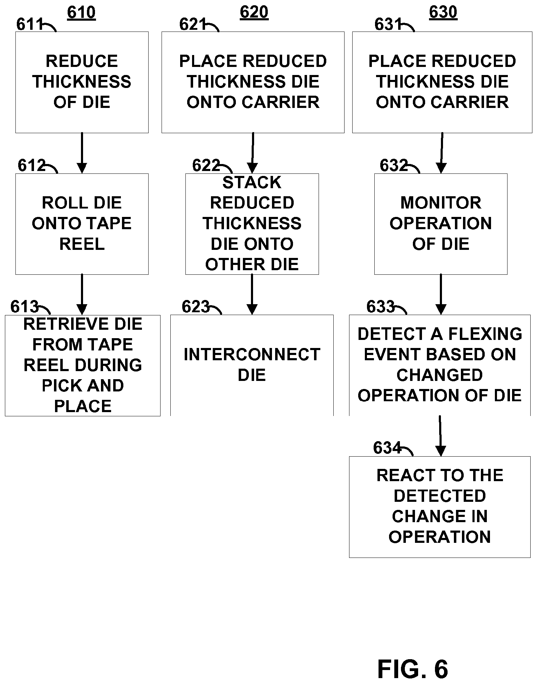

A flow diagram of process sequences is shown in FIG. 6. Step 611 of sequence 610 may, for example, reduce a thickness of one or more die by utilizing a thinning process (e.g., a grinding or polishing process). A thickness of a die may, for example, be reduced to approximately between 20 microns and 0.010 inches (e.g., approximately 0.004 inches). Such a reduced thickness die may, for example, contain components such as processors, ASICs, and mixed-mode circuitry (e.g., analog and digital circuitry). Such a reduced thickness die may, for example, exhibit increased flexibility, such that the die may be flexed to a minimum bend radius (e.g., rolled) or to a maximum bend angle. Accordingly, for example, such flexible die may be rolled onto a tape reel (e.g., as in step 612). In so doing, for example, the flexible die be retrieved from the tape reel and placed onto a mechanical carrier (e.g., a PCB) during a pick-and-place production operation (e.g., as in step 613) to produce devices, such as a powered card, a telephonic device (e.g., a cell phone), an electronic tablet, a watch, or any other device.

Step 621 of sequence 620 may, for example, place reduced thickness die onto a mechanical carrier (e.g., a PCB). One or more reduced thickness die may be stacked onto the die placed in step 621 (e.g., as in step 622). For example, a die containing a processor may be placed onto a mechanical carrier (e.g., a PCB) and another die containing an ASIC may be stacked on top of the die containing the processor. Yet another die (e.g., a die containing mixed-mode electronics or other circuitry) may be stacked onto the die containing the ASIC to yield a three-die stack. Accordingly, for example, by stacking die, surface area of the PCB may be conserved. Such a stacked-die arrangement may be used to produce devices, such as a powered card, a telephonic device (e.g., a cell phone), an electronic tablet, a watch, or any other device. Such a stacked-die arrangement may be encapsulated between two layers of laminate material (e.g., polymer material), injected with an encapsulant, and hardened to produce a rigid, yet flexible card or device.

Each of the stacked die may be interconnected to each other and/or one or more of the stacked die may be interconnected to signal traces on the PCB (e.g., as in step 623). By way of example, such interconnections may be implemented via wire bonds, whereby wires may be attached to interconnect pads of each die. Such wire bonding may be facilitated by placing larger diameter die at the bottom of the stack while placing smaller diameter die in order of decreasing diameter on top of the larger diameter die. In addition, interconnect pads may be staggered (e.g., no interconnect pads of any die or substrate may be directly adjacent to one another from a bird's eye perspective) to reduce a possibility that wire bonds may make electrical contact with interconnect pads not intended for that wire bond. Alternately, for example, each stacked die may be substantially the same diameter and may be interconnected to each other and the PCB using through-die vias and ball grid array interconnections.

Step 631 of sequence 630 may, for example, place one or more reduced thickness die onto a mechanical carrier, such as a PCB or substrate. Detection circuitry may, for example, monitor operation of the reduced thickness die to detect that the mechanical carrier (and the reduced thickness die mounted onto the mechanical carrier) may be flexed (e.g., as in step 633).

For example, reduced thickness die may be placed at different geographical regions of the mechanical carrier. Accordingly, for example, by detecting a changed operation of a flexed die (e.g., as in step 633), a processor may determine which geographical location of the mechanical carrier is being flexed.

As per another example, both a flexible die and a non-flexible die may be placed onto a mechanical carrier. By monitoring operation of both die, a flex event may be detected (e.g., as in step 633) by detecting a difference in operation between the flexible die and the non-flexible die.

In step 634, a processor of a card or device may react to a changed operation of a flexed die. For example, a card or device may be flexed such that a reference oscillator on the card or device changes frequency. A software application executed by a processor of the card or device may, for example, react to the changed frequency by adjusting an operation of another component of the card or device. As per another example, a dynamic magnetic stripe communications device may not communicate magnetic stripe data having an adequate magnitude when the associated card or device is being flexed. Accordingly, for example, a drive current provided to the dynamic magnetic stripe communications device may be increased by a software application executed by a processor of the card or device (e.g., as in step 634) based upon the detected flexing of step 633.

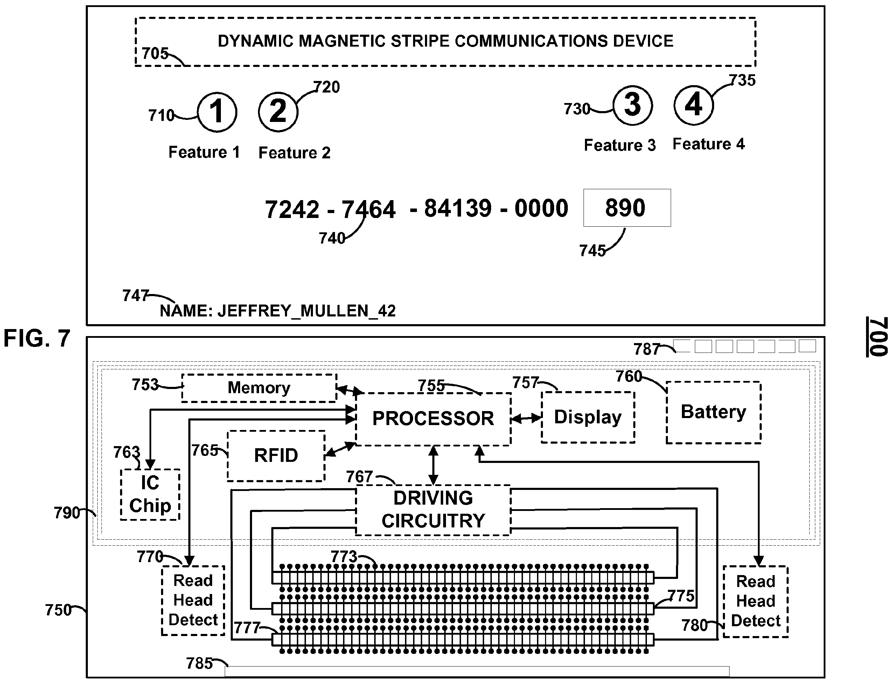

FIG. 7 shows cards and architectures according to example embodiments. Referring to FIG. 7, card 700 may include, for example, dynamic magnetic stripe communications device 705, one or more displays (e.g., dynamic code display 745), permanent information 747, one or more buttons (e.g., buttons 710, 720, 730 and 735) and/or information 740. Information 740 may be, for example, a transaction number (e.g., account number), and may be permanent and/or information in a display. In the case of information 740 that is permanent, information 740 may be, for example, printed, embossed and/or laser etched on card 700.

Permanent information 747 may include, for example, information specific to a user (e.g., a user's name and/or username) and/or information specific to a card (e.g., a card issue date and/or a card expiration date).

Buttons 710-735 may be mechanical buttons, capacitive buttons, or a combination of mechanical and capacitive buttons. Button 710 may be used, for example, to communicate information through dynamic magnetic stripe communications device 705 indicative of a user's desire to communicate a single track of magnetic stripe information. Persons skilled in the art will appreciate that pressing a button (e.g., button 710) may cause information to be communicated through device 705 when an associated read-head detector detects the presence of a read-head of a magnetic stripe reader. Buttons 720, 730 and 735 may be utilized to communicate (e.g., after a button is pressed and after a read-head detects a read-head of a reader) information indicative of a user selection (e.g., to communicate two or more tracks of magnetic stripe data, to communicate different track data, to modify tracks of data and/or the like).

Buttons 710-735 may each be used to associate a feature to a transaction. For example, each of buttons 710-735 may be associated to different service provider applications. Each service provider application may be associated to a different service provider feature (e.g., different rewards). A user may, for example, press one or more of buttons 710-735 to choose one or more features for a particular transaction.

A user may associate applications to buttons and/or features to applications, for example, on a graphical user interface (GUI). The graphical user interface may be, for example, an application manager provided by one or more entities (e.g., an application manager provider). The associations may be changed, for example, at any time, periodically, and/or upon the occurrence of an event. According to some example embodiments, a user may associate applications to buttons and/or features to applications by telephone, by electronic mail and/or any other communication method.

Associations between buttons and service provider applications may be maintained by an ecosystem provider, for example, within an ecosystem of applications, transactional methods and types of transactions. When a transactional method (e.g., card 700) is used by a user, the ecosystem provider may receive transactional data and information indicative of a button selected by the user. The ecosystem provider may determine the identity of an application associated to the button, and may communicate some or all of the information and/or transactional data to the application and/or the service provider. The service provider and/or the application may provide a feature associated with the application based on the information and/or transactional data.

Different features may be provided based on the use of different transactional methods and/or transaction types. For example, suppose a service provider provides a reward feature based on the use of a particular payment method (e.g., a reward for using a particular credit card). A user may purchase an item using the particular payment method (e.g., may select a particular credit account using buttons 710-735). When the purchase is performed, the reward may be communicated to the user. As another example, suppose a service provider provides a reward feature based on a type of transaction. For example, a reward may be provided for a sale of a commodity using a particular transaction processor (e.g., issuer, acquirer and/or payment network). A user may sell a commodity using a the particular transaction processor (e.g., the ecosystem provider) and upon completion of the sale a reward may be communicated to the user.

Selection of a feature may or may not have a cost associated with it. If a cost is associated with the feature, for example, the cost may be added to a customer's statement (e.g., added to a credit or debit purchase) for a particular transaction. A fixed-fee and/or variable-fee (e.g., a percentage of the transaction) may then be removed from the fee charged to the user and distributed among particular parties, for example, distributed among a card issuer, application manager provider, ecosystem provider, device provider, service provider and/or one or more other entities. Persons skilled in the art in possession of example embodiments will appreciate that many different fee arrangements are possible, and that the various providers may be the same and/or different from each other.

A cost may be associated to a feature selection, but may not be a cost to a user. For example, the cost may be a cost to a service provider (e.g., a third party service provider). The cost may be provided to other entities, for example, the device provider, card issuer, card processor, and/or any other entity (e.g., a card network). For example, a feature provided to a user acting as a merchant may be an instant rebate provided to the customer of the user, and a cost of the instant rebate may be a cost to the rebate provider.

Display 745 may display, for example, a dynamic verification code (e.g., a card verification value (CVV) and/or card identification number (CID)). The dynamic number displayed on display 745 may change according to various schemes as a security measure against fraudulent transactions. Any and/or all of the information provided by a card 700 may be provided via a display. For example, information 740 may be a dynamic number provided via a display. The dynamic numbers may change periodically and/or upon the occurrence of an event such that a previously recorded number may become unusable. According to at least one example embodiment, one or both sides of a card 700 may be entirely a display.

Card 700 and/or a user may communicate a dynamic number to a processing facility. The processing facility may validate the dynamic number (e.g., a dynamic credit card number and/or a dynamic security code). A user may purchase items using a dynamic card and a processing facility may authorize the purchases upon determining that the dynamic number is valid. Although example embodiments may be described with respect to numbers, the scope of example embodiments includes any distinguishing representation of a security code and/or account, by any sensory method (e.g., sight, sound, touch and/or the like). Characters, images, sounds, textures, letters and/or any other distinguishable representations are contemplated by example embodiments.

Architecture 750 may be utilized with any card (e.g., any card 700). Architecture 750 may include, for example, processor 755, display 757, driving circuitry 767, memory 753, battery 760, radio frequency identification (RFID) 765, integrated circuit (IC) chip 763, electromagnetic field generators 773, 775, and 777, read-head detectors 770 and 780, port 787 (e.g., a joint test action group (JTAG) port), and an RFID antenna 790.

Processor 755 may be any type of processing device, for example, a central processing unit (CPU), an analog signal processor and/or a digital signal processor (DSP). Processor 755 may be, for example, an application specific integrated circuit (ASIC). Processor 755 may include on-board memory for storing information (e.g., drive code). Any number of components may communicate to processor 755 and/or receive communications from processor 755. For example, one or more displays (e.g., display 757) may be coupled to processor 755. Persons skilled in the art will appreciate that components may be placed between particular components and processor 755. For example, a display driver circuit may be coupled between display 757 and processor 755.

Memory 753 may be coupled to processor 755. Memory 753 may store data, for example, data that is unique to a particular card. Memory 753 may store any type of data. For example, memory 753 may store discretionary data codes associated with each of buttons 710-735 of card 700. Discretionary data codes may be recognized by remote servers to effect particular actions. For example, a discretionary data code may be stored in memory 753 and may be used to cause a third party service feature to be performed by a remote server (e.g., a remote server coupled to a third party service such as an online voucher and/or coupon provider).

Different third party features may be, for example, associated with different buttons and a particular feature may be selected by pressing an associated button. According to at least one example embodiment, a user may select a type of payment on card 700 via manual input interfaces. The manual input interfaces may correspond to displayed options (not illustrated) and/or may be independent buttons. Selected information may be communicated to a magnetic stripe reader via a dynamic magnetic stripe communications device, an RFID antenna and/or the like. Selected information may also be communicated to a device (e.g., a mobile telephonic device) including a capacitive sensor and/or other type of touch sensitive sensor.

Architecture 750 may include any number of reader communication devices. For example, architecture 750 may include at least one of IC chip 763, RFID 765 and a magnetic stripe communications device. IC chip 763 may be used to communicate information to an IC chip reader (not illustrated) using, for example, RFID antenna 790 and/or contact conductive fingers (e.g., 6 or 8 contact gold fingers). IC chip 752 may be, for example, an EMV chip. RFID 751 may be used to communicate information to an RFID reader using RFID antenna 790. RFID 751 may be, for example, a RFID tag. A magnetic stripe communications device may be included to communicate information to a magnetic stripe reader. For example, a magnetic stripe communications device may provide electromagnetic signals to a magnetic stripe reader.

Different electromagnetic signals may be communicated to a magnetic stripe reader to provide different tracks of data. For example, architecture 750 may include electromagnetic field generators 773, 775 and 777 to communicate separate tracks of information to a magnetic stripe reader. Electromagnetic field generators 773, 775 and 777 may include a coil (e.g., each may include at least one coil) wrapped around one or more materials (e.g., a soft-magnetic material and a non-magnetic material). Each electromagnetic field generator may communicate information, for example, serially and/or in parallel to a receiver of a magnetic stripe reader for a particular magnetic stripe track.

Architecture 750 may include read head detectors 770 and 780. Read-head detectors 770 and 780 may be configured to sense the presence of a magnetic stripe reader (e.g., a read-head housing of a magnetic stripe reader). A read-head detector may include, for example, e-sense pads. Information sensed by the read-head detectors 770 and 780 may be communicated to processor 755 to cause processor 755 to communicate information serially from electromagnetic generators 773, 775, and 777 to magnetic stripe track receivers in a read-head housing of a magnetic stripe reader.

According to at least one example embodiment, a magnetic stripe communications device may change the information communicated to a magnetic stripe reader at any time. Processor 755 may, for example, communicate user-specific and card-specific information using RFID 765, IC chip 763, and/or electromagnetic generators 773, 775, and 777 to card readers coupled to remote information processing servers (e.g., purchase authorization servers). Driving circuitry 767 may be utilized by processor 755, for example, to control electromagnetic generators 773, 775 and 777.

Architecture 750 may include, for example, a light sensor (not illustrated). Architecture 750 may receive information from a light sensor. Processor 755 may determine information received by a light sensor.

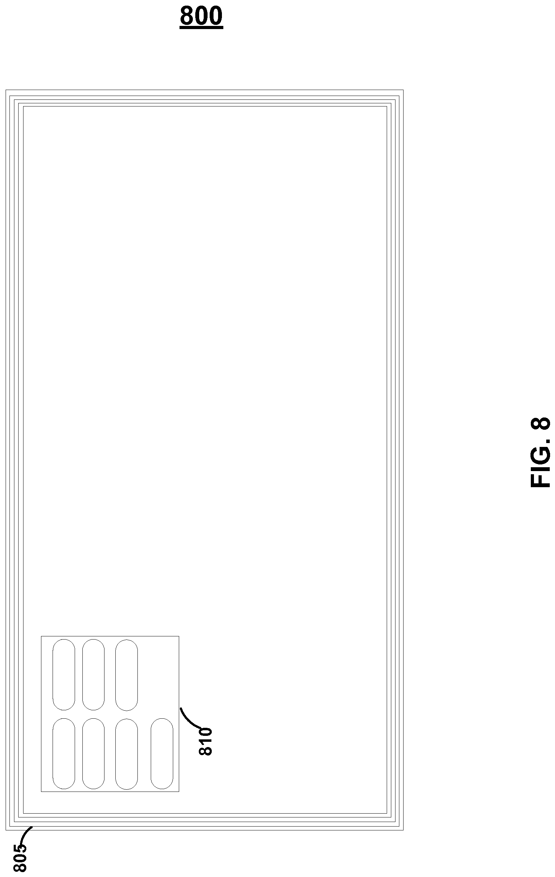

FIGS. 8-10 show card layers constructed in accordance with the principles of the present invention. Referring to FIG. 8, layer 800 of a printed circuit board may include, for example, RFID antenna 805 and EMV connector 810. Layer 800 may be about 1-3 mils thick (a mil being 1/1000 of an inch), for example, about 2 mils thick. Persons of ordinary skill in the art will appreciate that layer 800 may also include various circuit traces, fill materials, supports, components, via connections and/or the like which may not be illustrated for clarity of explanation.

According to at least one example embodiment, layer 800 may be one side of a sheet, for example, one side of a polyimide sheet (e.g., a Kapton sheet). A side of a sheet including RFID antenna 805 and EMV connector 810 may be a bottom layer of a printed circuit board. A second side of the sheet may include a different layer. The different layer (not shown) from layer 800 may include routing traces and/or other elements. According to at least one example embodiment, the second side of the sheet may not include a different layer and/or metallization (e.g., copper), for example, may be bare polyimide.

An RFID antenna may, for example, be a series of conductive loops on a border of layer 800. RFID antenna 805 may be operable to communicate information provided by a processor externally to a distance of about, for example, 100 millimeters. For example, a processor may communicate with an RFID device using RFID antenna 805. RFID antenna 805 may be utilized to communicate, for example, payment card information (e.g., credit card information) to a reader. Although RFID antenna 805 is described with respect to RFID, persons of ordinary skill in the art will appreciate that near field communications provided by an antenna may be used for various other technologies, for example, contactless EMV.

RFID antenna 805 may communicate an electromagnetic signal in response to a signal provided by, for example, an RFID chip (e.g., an application specific integrated circuit (ASIC) and/or the like). A size of the conductive loops may be large (e.g., as large as possible) and may be along edge portions of layer 800 to maximize and/or increase a size of RFID antenna 805. Persons of ordinary skill in the art in possession of example embodiments will appreciate that increased antenna size may correspond to increased gain. RFID antenna 805 may be monostatic and/or bistatic, and may be tuned (or tunable) to a specific range of carrier frequencies. Although FIG. 8 illustrates a helical antenna, other configurations are contemplated by example embodiments (e.g., patch, crossed dipole and/or the like).

EMV connector 810 may be used to connect an EMV chip to an external device (e.g., an EMV device). For example, EMV connector 810 may include contact pads and/or the like used to connect a payment card to an EMV device during a transaction. An EMV chip (e.g., a processor) may be connected to EMV connector 810 via one or more circuit traces and a buffer, for example, a buffer that provides electrostatic discharge (ESD) protection and/or bi-directional control (not illustrated). A card may be operable to provide contactless EMV communications and, for example, an EMV chip may be connected by circuit traces to RFID antenna 805 alternatively to and/or additionally to EMV connector 810. An EMV chip may be a component added to a circuit board including layer 800 and/or may be part of a circuit board layer.

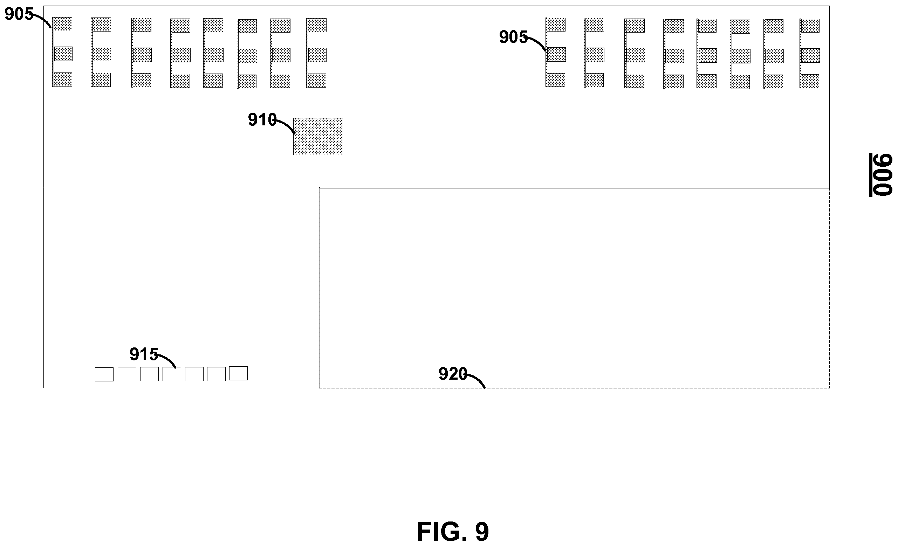

Referring to FIG. 9, layer 900 may include, for example, read head detectors 905, pad 910, supports 915 and/or component cutout 920. Persons of ordinary skill in the art will appreciate that layer 900 may also include various circuit traces, fill materials, supports, components, vias, via connections and/or the like which may not be illustrated for clarity of explanation. A thickness of layer 900 may be, for example, about 1-4 mils (e.g., about 2 mils).

Persons skilled in the art will appreciate that a read-head housing of a magnetic stripe reader may be provided with one, two, or three active read-heads that are each operable to couple with a separate magnetic track of information. A reader may also have more than one read-head housing and each read-head housing may be provided with one, two, or three active read-heads that are operable to each couple with a separate magnetic track including information. Such read-head housings may be provided on different surfaces of a magnetic stripe reader. For example, the read-head housings may be provided on opposite walls of a trough sized to accept payment cards. Accordingly, the devices on the opposite sides of the trough may be able to read a credit card regardless of the direction that the credit card was swiped.

A magnetic emulator may be provided and may be positioned on card such that when card is swiped through a credit card reader, the magnetic emulator passes underneath, or in the proximity of, a read-head for a particular magnetic track. An emulator may be large enough to simultaneously pass beneath, or in the proximity of, multiple read-heads. Information may be transmitted, for example, serially to one or more read-heads. Information from different tracks of data may also be transmitted serially and the magnetic stripe reader may determine the different data received by utilizing the starting and/or ending sentinels that define the information for each track. A magnetic emulator may also transmit a string of leading and/or ending zeros such that a magnetic reader may utilize such a string of zeros to provide self-clocking. In doing so, for example, information may be transmitted serially at high speeds to a magnetic stripe reader. For example, credit card information may be transmitted to a magnetic stripe reader at speeds up to, and/or greater than, about 30Khz.

Different emulators may be provided, and positioned, on a card to each couple with a different read-head and each emulator may provide different track information to those different read-heads. Read-head detectors may be utilized to detect when a read-head is over an emulator such that an emulator is controlled by a processor to operate when a read-head detector detects the appropriate presence of a read-head. Power may be saved. The read-head detector may detect how many read-heads are reading the card and, accordingly, only communicate with the associated emulators. Power may be conserved.

Read-head detectors 905 may be, for example, provided as a circuit that detects changes in capacitance and/or mechanical coupling to a conductive material. Read head detectors 905 may be, for example, e-sense pads and/or the like. A processor may be provided to, for example, receive information from read-head detectors 905. Read head detectors 905 may be connected to the processor via circuit traces and/or the like.

Pad 910 may be, for example, a die foundation of a chip. For example, pad 910 may be a copper pad used to support a wire bonded on-board ASIC chip. Supports 915 may be, for example, supports for an external connector (e.g., a JTAG port). As one non-limiting example, supports 915 may be copper pads. Component cutout 920 may indicate the absence of symmetry in layer 900. For example, component cutout 920 may be an area not including layer 900 (e.g., not including layer 900 and/or a polyimide support layer). Although example embodiments may describe a component cutout, layer 900 may be formed without a portion corresponding to component cutout 920, may be an etched, milled, and/or ablated portion, and/or the like. A component, for example, a battery, may occupy some or all of a space provided by component cutout 920.

According to at least one example embodiment, layer 900 may be one side of a sheet, for example, one side of a polyimide sheet (e.g., a Kapton sheet). Layer 900 may be a middle layer of a printed circuit board. A different side of the sheet from the layer 900 may include a different layer, for example, a top layer. The different layer (not shown) from layer 900 may include, for example, an infrared (IR) transceiver, a component cutout, buttons, a processor, at least one circuit, leads, an EMV buffer, an RFID chip, a port and/or a component cutout. According to at least one example embodiment, layer 900 may be a standalone layer, for example, the only layer of a sheet.

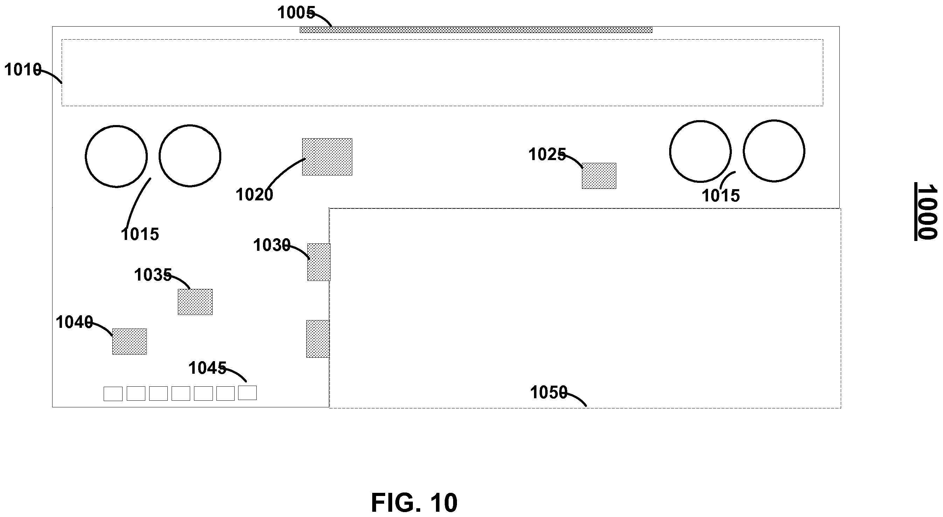

Referring to FIG. 10, layer 1000 may include, for example, infrared (IR) transceiver 1005, magnetic stripe region 1010, buttons 1015, processor 1020, circuit 1025, leads 1030, EMV buffer 1035, RFID chip 1040, port 1045 and/or component cutout 1050. Persons of ordinary skill in the art will appreciate that layer 1000 may also include various circuit traces, fill materials, supports, components, via connections and/or the like which may not be illustrated for clarity of explanation. A thickness of layer 1000 may be, for example, about 1-4 mils (e.g., about 2.7 mils).

IR transceiver 1005 may include, for example, an IR emitter and an IR receiver. The IR emitter may be, for example, a light emitting diode configured to emit IR light upon excitation (e.g., application of a voltage across the diode). The IR receiver may be, for example, a transistor configured to generate a current in the presence of IR light. For example, the IR receiver may be a bipolar transistor. According to at least one example embodiment, IR transceiver 1005 may not be a transceiver and may be a transmitter-receiver. IR transceiver 1005 may be connected to, for example, processor 1020 via one or more circuit traces (not illustrated). IR transceiver 1005 may communicate information to/from an external IR reader and/or to/from processor 1020. For example, IR transceiver 1005 may communicate a card account number to an IR card reader.

Magnetic stripe region 1010 may indicate the absence of a portion of layer 1000. For example, magnetic stripe region 1010 may indicate an area of a sheet (e.g., a polyimide sheet) not including any metallization (e.g., no copper, coverlay and/or the like). As another example, magnetic stripe region 1010 may indicate the absence of any material. Although example embodiments may include a component cutout as a magnetic stripe region, layer 1000 may be formed without a portion corresponding to magnetic stripe region 1010, an etched, milled, and/or ablated portion, and/or the like. A component, for example, a magnetic stripe communication device, may occupy some or all of a space provided by magnetic stripe region 1010 (e.g. directly on a polyimide sheet).

Buttons 1015 may be mechanical buttons, capacitive buttons, or a combination of mechanical and capacitive buttons. Buttons 1015 may be connected to processor 1020 via one or more circuit traces (not illustrated).

Processor 1020 may be, for example, a central processing unit. For example, processor 1020 may be an ultra-low-power mixed signal microprocessor. Processor 1020 may provide various functions to a powered card including a layer 1000. For example, a card EMV protocol may use processor 1020. Processor 1020 may include on-board memory for storing information (e.g., drive code). Any number of components may communicate to processor 1020 and/or receive communications from processor 1020. For example, one or more displays (not illustrated) and/or one or more memories may be coupled to processor 1020. Persons skilled in the art will appreciate that components may be placed between particular components and processor 1020. For example, a buffer circuit may be coupled between processor 1020 and an EMV connector.

Circuit 1025 may be, for example, an ASIC. Circuit 1025 may be associated with a magnetic stripe communication device. Leads 1030 may be, for example, battery terminal leads to connect a thin film, flexible battery to power various circuits (e.g., circuitry or components of various layers including layer 1000). EMV buffer 1035 may be connected between, for example, an EMV connector and processor 1020. EMV buffer 1035 may provide electrostatic discharge (ESD) protection and/or bi-directional control. RFID chip 1040 may be, for example, connected to an RFID antenna (not illustrated) and may be operable to communicate, for example, payment card information (e.g., credit card information) to a reader. Port 1045 may be, for example, a JTAG port connected to processor 1020 and/or leads 1030 via circuit traces (not illustrated).

Component cutout 1050 may indicate the absence of symmetry in layer 1000. For example, component cutout 1050 may be an area not including layer 1000. Although example embodiments may describe a component cutout, layer 1000 may be formed without a portion corresponding to component cutout 1050, may be an etched or otherwise removed portion and/or the like. A component, for example, a battery, may occupy some or all of a space provided by component cutout 1050.

Persons skilled in the art in possession of example embodiments will appreciate that components of various layers of a circuit board may be distributed in various ways and remain within the scope of example embodiments.

According to at least one example embodiment, layer 1000 may be one side of a sheet, for example, one side of a polyimide sheet (e.g., a Kapton sheet). Layer 1000 may be a top layer of a printed circuit board. A different side of the sheet from the layer 1000 may include a different layer, for example, a middle layer. The different layer (not shown) from layer 1000 may include, for example, read head detectors, one or more pads, supports and/or component cutouts. According to at least one example embodiment, layer 1000 may be a standalone layer, for example, the only layer of a sheet.

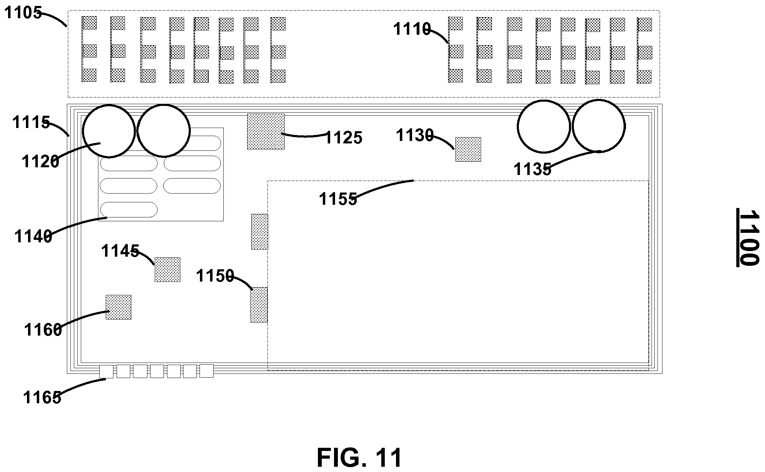

FIG. 11 shows overlaid card layers constructed in accordance with the principles of the present invention. Referring to FIG. 11, a printed circuit board may include multiple layers, for example, three layers including magnetic stripe cutout 1105, read head detectors 1110, antenna 1115, buttons 1120 and 1135, processor 1125, circuit 1130, EMV connector 1140, EMV buffer 1145, leads 1150, RFID chip 1160, port 1165 and/or component cutouts 1155. Persons of ordinary skill in the art will appreciate that circuit board 1100 may include various circuit traces, fill materials, supports, components, via connections and/or the like which may not be illustrated for clarity of explanation. Components, such as a magnetic stripe communication device, battery, backers and/or buttons, may or may not be part of circuit board 1100 (e.g., may be separate components).

A first layer may include, for example, component cutouts 1105 and/or 1155, buttons 1120 and 1135, processor 1125, circuit 1130, EMV buffer circuit 1145, leads 1150, RFID chip 1160 and port 1165. A second layer may include, for example, read head detectors 1110, a connector (not illustrated), supports (not illustrated) and/or component cutout 1155. A third layer may include, for example, RFID antenna 1115 and/or EMV connector 1140.

According to at least one example embodiment, the first and second layers may be on opposite sides of a same sheet (e.g., a Kapton sheet). The third layer may be on a different sheet. The different sheet may only include the third layer and an opposite side of the sheet from the third layer may not include metallization (e.g., no coverlay). According to at least one other example embodiment the opposite side of the sheet from the third layer may include routing traces, elements, and/or the like (e.g., a fourth layer). According to at least one example embodiment, each layer of a circuit board may be associated with a different substrate layer.

Circuit board 1100 may include a cutout 1155 that may extend through the first and second layers. A component such as a battery may be on the third layer and pass through the first and second layers.

The third layer may extend to about a portion of the printed circuit board 1100 including read head detectors 1110 of the second layer and/or a magnetic stripe communication device (not illustrated). For example, a magnetic stripe communication device may be a component on a polyimide sheet over read head detectors 1110 of the second layer and in magnetic stripe cutout 1105 of the first layer. Magnetic stripe region 1105 may indicate, for example, the absence of elements on the first layer opposite the read head detectors 1110. The third layer may not extend into a region including read head detectors 1110 and/or a magnetic stripe communication device. According to at least one example embodiment, a sheet including the third layer may not extend into a region including read head detectors 1110 and/or a magnetic stripe communication device. The sheet may be between the third layer and the second layer.

Accordingly, interference between an RFID antenna 1115 and a magnetic stripe communication device and/or read head detectors may be reduced. RFID antenna 1115 may surround an area of a circuit board 1100 not including the magnetic stripe communication device. A thickness of circuit board 1100 may be reduced in an area including a magnetic stripe communication device and a size of an RFID antenna increased, as compared to, for example, a circuit board not including three or more layers. Communications using an RFID antenna 1115 and/or a magnetic stripe communication device may be improved. For example, circuit board 1100 may provide improved gain.

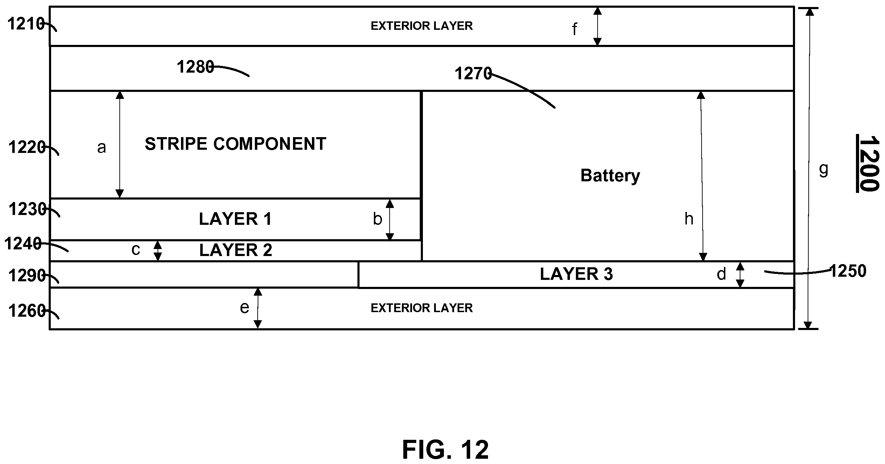

FIG. 12 shows a card in accordance with the principles of the present invention. FIG. 12 may be an example cross-sectional representation of a card taken in a thickness direction. Referring to FIG. 12, a card 1200 may include, for example, first exterior layer 1210, magnetic stripe communications device 1220, first layer 1230, second layer 1240, third layer 1250, second exterior layer 1260, battery 1270, region 1280 and fill 1290.

Magnetic stripe communications device 1220 may be on first layer 1230 (e.g., on a sheet including layer 1230). A thickness "g" of card 1200 may be, for example, about 25-40 mils (25-40 thousandths of an inch). For example, card 1200 may be about 30-33 mils thick. Card 1200 may include layers, components and/or the like with thicknesses "a"-"f" and "h".

Each of thicknesses "e" and "f" of exterior layers 1210 and 1260 may be, for example, about 3-8 mils (e.g., about 6 mils). Exterior layers 1210 and 1260 may include a polymer, for example, polyethelene terephthalate. A thickness "d" of third layer 1250 may be about 1-3 mils (e.g., 2 mils). Thicknesses "b" and "c" of first and second layers 1230 and 1240 combined may be about 2-7 mils (e.g., about 4.7 mils). A thickness "h" of battery 1270 may be about 14-20 mils (e.g., about 17 mils).

Region 1280 may be a region including a material (e.g., an adhesive) and/or various elements (e.g., wire traces and/or the like). According to some example embodiments, region 1280 may not be present or may be present as a fill material, and first layer 1230 and/or battery 1270 may extend to first exterior layer 1210. Thickness "a" of the magnetic stripe communications device portion 1220 may be, for example, a thickness of thickness "g" minus the combined thicknesses "a"-"f" and a thickness (if any) of region 1280. Fill 1290 may indicate a region of card 1200 into which the third layer 1250 does not extend. For example, the third layer 1250 may include an RFID antenna and may not extend into a region of card 1200 including a magnetic stripe communication device 1220 or may only partially extend into a region of card 1200 including a magnetic stripe communication device 1220. Fill 1290 may include, for example, epoxy.

As one non-limiting example, to fabricate a card that is about 30-33 mils thick, for example, exterior layers 1210 and 1260 may each be about 4-7 mils (e.g., 5 mils). A magnetic stripe communication device may be about 18-22 mils. A circuit board may be less than about 10-20 mils (e.g., less than about 16 mils). The magnetic stripe communication device may be on a portion of a circuit board layer with a thickness of about 1-3 mils (e.g., about 2 mils). Accordingly, for example, an area of region 1280 between a magnetic stripe communications device and an exterior layer may be a thickness such that a magnetic stripe communications device, a circuit board layer (e.g., layer 1240) on the magnetic stripe communication device, and exterior layers 1210 and 1260, are together about 30-33 mils thick. For example, region 1280 may be about 0-10 mils thick (e.g., about 2 mils).

Persons of ordinary skill in the art will appreciate that the relative sizes of elements shown in FIG. 12 are representative only and depend on, for example, specific design and/or specific components. For example, magnetic stripe component 1220 may be thicker than battery 1270. Further, relative dimensioning may not be to scale in order to illustrate relative positioning in FIG. 12.

The volume of the electronics package of a powered card may be, for example, less than about two tenths of a cubic square inch (e.g., about less than one tenth of a cubic square inch). Such an electronics package may include multiple flexible boards, a battery, dynamic magnetic stripe communications device, magnetic stripe communications device drive circuitry, and multiple light emitting diodes, for example. There may be no copper pour in card 1200. A thickness of card 1200 may be uniform or may vary (e.g., a flexible card).

Persons skilled in the art will appreciate that a protective layer may be placed over exterior layers 1210 and 1260. Such a layer may be about 0.5-2 mils thick (e.g., about 1 mil thick). Accordingly, for example, the combined thickness of two protective layers may be about 2 mils, the combined thickness of two exterior layers may be about 8 mils, the thickness of a circuit board layer including read heads may be 2 mils and the thickness of a magnetic stripe communication device may be about 18 mils. In order to maintain a target thickness of about 30 mils (e.g., with a maximum thickness of about 32 mils including personalization) for a card 1200, a third layer (e.g., including an antenna) may not overlap a region of card 1200 including a magnetic stripe communication device.

Persons skilled in the art will appreciate that different components and layers may be of different thicknesses based on the design of a card, and that example embodiments may be applied in a wide variety of scenarios to maintain a critical thickness. Persons skilled in the art will appreciate that an injection molding process of a substance may allow a substance to fill into the groove and gaps of an electronics package such that the laminate may reside, for example, between components of an electronics package.

Card 1200 may include a permanent magnet that may be, for example, provided as part of an assembled magnetic stripe communication device 1220. First through third layers 1230-1250 may include, for example, capacitive read-head detectors. Battery 1270 may be any type of battery, such as, for example, a flexible lithium polymer battery. Circuitry may be included (not illustrated), for example, one or more driver circuits (e.g., for a magnetic communications device), RFIDs, IC chips, light sensors and light receivers (e.g., for sending and communicating data via optical information signals), sound sensors and sound receivers, or any other component or circuitry for card 1200. Read-head detectors for detecting the read-head of a magnetic stripe reader may be provided, for example, on layer 1240 as capacitive touch sensors (e.g., capacitive-sensing contact plates).

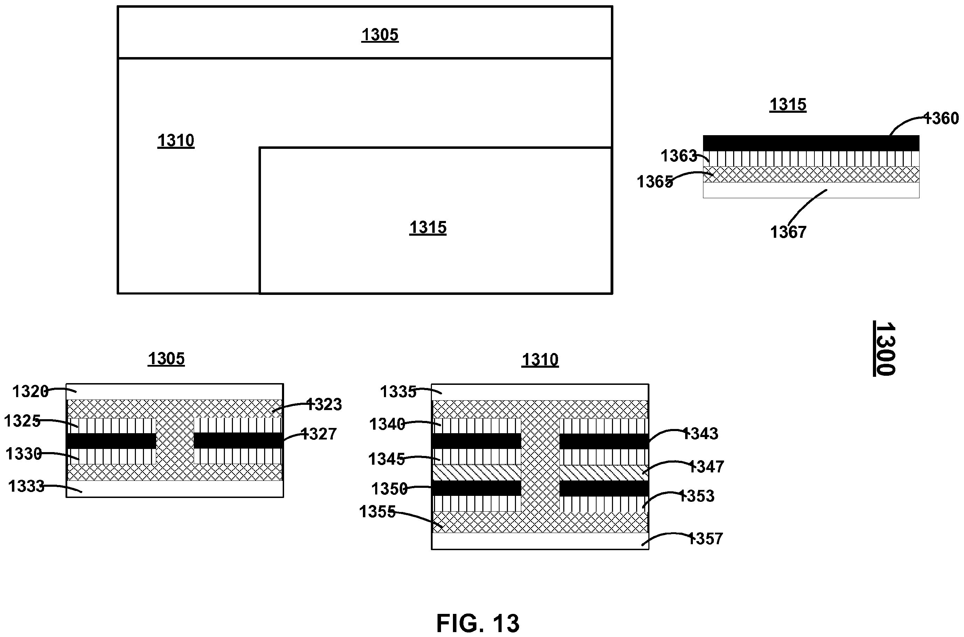

FIG. 13 shows a card in accordance with the principles of the present invention. FIG. 13 may include an example plan view of card 1300 including regions 1305, 1310 and 1315, and cross-sections corresponding to the regions.

Referring to FIG. 13, card 1300 may include regions 1305, 1310 and 1315. Region 1305 may include, for example, first mask 1320, first conductor 1323, second conductor 1325, substrate 1327, third conductor 1330 and second mask 1333. Substrate 1330 may be, for example, polyimide (e.g., Kapton). Second conductor 1325 and third conductor 1330 may be on opposite sides of substrate layer 1330. Second conductor 1325 and third conductor 1330 may include, for example, electrically deposited metal (e.g., ED copper). First conductor 1323 may be on exposed portions of substrate 1327, second conductor 1325 and third conductor 1330, and may fill vias, depressions and/or the like. First conductor 1323 may be, for example, metal plating (e.g., copper plating). Mask 1320 and mask 1333 may be on first conductor 1323. Mask 1320 and mask 1333 may be, for example, top and bottom solder masks (e.g., coverlay), respectively.

Region 1310 of card 1300 may include, for example, first mask 1335, first conductor 1355, second conductor 1340, first substrate 1343, third conductor 1345, bonding material 1347, second substrate 1350, fourth conductor 1353 and second mask 1357. First substrate 1343 and second substrate 1350 may be, for example, polyimide (e.g., Kapton). Second conductor 1340 and third conductor 1345 may be on opposite side surfaces of first substrate 1343. Fourth conductor 1353 may be on a side surface (e.g., bottom surface) of substrate 1350. Second conductor 1340, third conductor 1345 and fourth conductor 1353 may include, for example, electrically deposited metal (e.g., ED copper). Bonding material 1347 may be between substrate 1350 and third conductor 1345. Bonding material 1347 may be, for example, a bonding sheet.

First conductor 1355 may be on exposed portions of substrate second conductor 1340, first substrate 1343, third conductor 1345, bonding material 1347, second substrate 1350 and fourth conductor 1353. First conductor 1355 may fill vias, depressions and/or the like. First conductor 1355 may be, for example, metal plating (e.g., copper plating). First mask 1335 and second mask 1357 may be on first conductor 1355. First mask 1335 and second mask 1357 may be, for example, top and bottom solder masks (e.g., coverlay), respectively.

Region 1315 of card 1300 may include, for example, substrate 1360, first conductor 1363, second conductor 1365 and mask 1367. A top surface of substrate 1360 may be exposed. Substrate 1360 may be, for example, a polyimide. First conductor 1363 may be on an opposite side of substrate 1360 from the exposed top surface. First conductor 1363 may be, for example, electrically deposited copper. Second conductor 1365 may be on first conductor 1363. Second conductor 1365 may be, for example, copper plating. Mask 1367 may be on second conductor 1365. Mask 1367 may be a solder mask (e.g., coverlay).

Persons skilled in the art will understand that although regions 1305, 1310 and 1315 may be shown with different conductors, substrates and masks, according to some example embodiments materials may be common between regions. Persons skilled in the art will understand that regions 1305, 1310 and 1315 may not be internally contiguous. For example, region 1305 may include a magnetic stripe communication device cutout, and within such a cutout, substrate 1327 may be exposed.

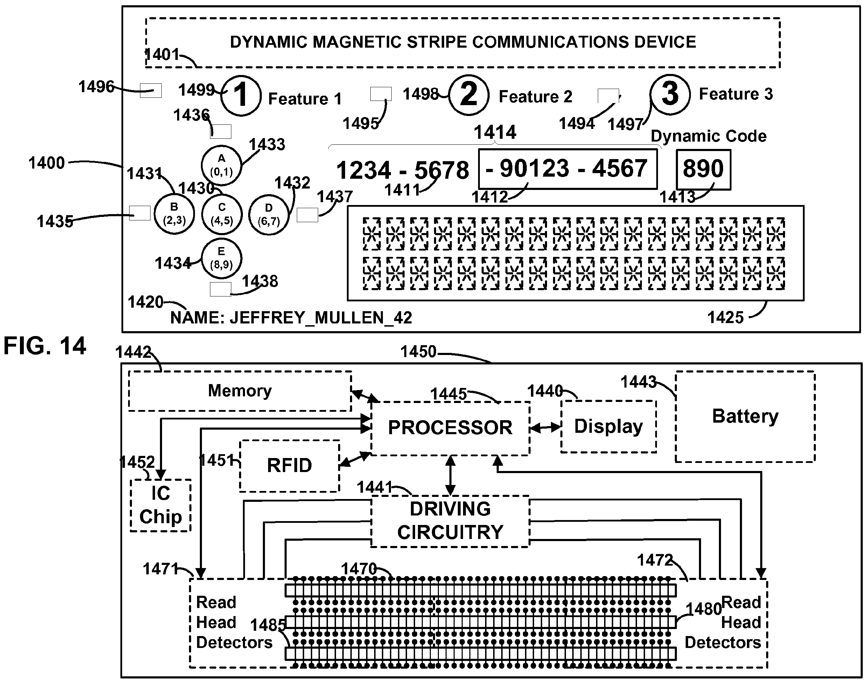

FIG. 14 shows card 1400 that may include, for example, dynamic magnetic stripe communications device 1401, one or more displays (e.g., displays 1412, 1413 and 1425)), permanent information 1420, one or more buttons (e.g., buttons 1430-1434 and 1497-1499), lights 1435-1438 and 1494-1496, and dynamic number 1414 which may include a permanent portion 1411. Permanent portion 1411 may be, for example, printed, embossed and/or laser etched on card 1400.

Multiple displays may be provided on card 1400 for various purposes. For example, display 1412 may display a dynamic number entirely, and/or partially. Display 1413 may be utilized to display a dynamic code (e.g., a dynamic security code). Display 1425 may display logos, barcodes, and/or one or more lines of information (e.g., may display a coupon code).

Card 1400 may include permanent information 1420 including, for example, information specific to a user (e.g., a user's name and/or username) and/or information specific to a card (e.g., a card issue date and/or a card expiration date).

Card 1400 may include a dynamic magnetic communications device. Such a dynamic magnetic communications device may take the form of a magnetic encoder or an electromagnetic generator. A magnetic encoder may change the information located on a magnetic medium such that a magnetic stripe reader may read changed magnetic information from the magnetic medium. An electromagnetic generator may generate electromagnetic fields that directly communicate data to a magnetic stripe reader. Such an electromagnetic generator may communicate data serially to a read-head of the magnetic stripe reader.

Card 1400 may include one or more buttons, for example, buttons 1430-1434 and 1497-1499. Buttons 1430-1434 and 1497-1499 may be, for example, mechanical buttons, capacitive buttons, light sensors and/or a combination thereof.

Buttons 1497-1499 may be used, for example, to communicate information through dynamic magnetic stripe communications device 1401 indicative of a user's desire to communicate a single track of magnetic stripe information. Persons skilled in the art will appreciate that pressing a button (e.g., button 1499) may cause information to be communicated through device 1401 when an associated read-head detector detects the presence of a read-head of a magnetic stripe reader and/or at a specific frequency.

Each of buttons 1497-1499 may be utilized to communicate (e.g., after the button is pressed and after a read-head detection circuit detects a read-head of a reader) information indicative of a user selection (e.g., to communicate one or more tracks of magnetic stripe data). Multiple buttons may be provided on a card and each button may be associated with a different user selection.

Different third party features may be, for example, associated with different buttons and a particular feature may be selected by pressing an associated button. According to at least one example embodiment, each of buttons 1497-1499 may be associated with, for example, a different third party service provider feature (e.g., an application facilitating provision of a reward) and may be changed by a user at any time.

According to some example embodiments, a user may select a third party feature from a list displayed to the user. For example, the user may scroll through a list of features on a display (e.g., display 1425). A user may scroll through a list using buttons on a card (e.g., buttons 1430-1434). The list of features may be displayed to the user individually, in groups and/or all features may be simultaneously displayed.

According to some example embodiments, a third party feature associated with a button may be changed by a user, for example, on a graphical user interface (GUI) provided on a website, to allow a user to change the third party feature performed when the third party's feature button is selected by a user on the user's card or other device.

According to some example embodiments, a user may select a type of payment on card 1400 via manual input interfaces (e.g., buttons 1430-1434). The manual input interfaces may correspond to displayed options (e.g., displayed on display 1425). Selected information may be communicated to a magnetic stripe reader via a dynamic magnetic stripe communications device. Selected information may also be communicated to a device (e.g., a mobile telephonic device) including a capacitive sensor and/or other type of touch sensitive sensor. Display 1425 may allow a user to select (e.g., via buttons) options on display 1425 that instruct the card to communicate (e.g., via a dynamic magnetic stripe communications device, RFID and/or exposed IC chip) to use a debit account, credit account, pre-paid account, and/or point account for a payment transaction.

Lights 1435-1438 and 1494-1496 (e.g., light emitting diodes), may be associated with buttons 1431-1434 and 1497-1499. Each of lights 1435-1438 and 1494-1496 may indicate, for example, when a button is pressed. In a case where a button may activate card 1400 for communications, a light may begin blinking to indicate card 1400 is still active (e.g., for a period of time) while reducing power expenditure. Although not shown, a light may be provided for button 1430.

Architecture 1450 may be utilized with any card (e.g., any card 1400). Architecture 1450 may include, for example, processor 1445, display 1440, driving circuitry 1441, memory 1442, battery 1443, radio frequency identification (RFID) 1451, integrated circuit (IC) chip 1452, electromagnetic field generators 1470, 1480, and 1485, and read-head detectors 1471 and 1472.

Processor 1445 may be any type of processing device, for example, a central processing unit (CPU) and/or a digital signal processor (DSP). Processor 1445 may be, for example, an application specific integrated circuit (ASIC). Processor 1445 may include on-board memory for storing information (e.g., triggering code). Any number of components may communicate to processor 1445 and/or receive communications from processor 1445. For example, one or more displays (e.g., display 1440) may be coupled to processor 1445. Persons skilled in the art will appreciate that components may be placed between particular components and processor 1445. For example, a display driver circuit may be coupled between display 1440 and processor 1445.

Memory 1442 may be coupled to processor 1445. Memory 1442 may store data, for example, that is unique to a particular card. Memory 1442 may store any type of data. For example, memory 1442 may store discretionary data codes associated with buttons of a card (e.g., card 1400). Discretionary data codes may be recognized by remote servers to effect particular actions. For example, a discretionary data code may be stored in memory 1442 and may be used to cause a third party service feature to be performed by a remote server (e.g., a remote server coupled to a third party service such as a rewards provider). Memory 1442 may store firmware that, for example, controls triggering and/or the like.

Architecture 1450 may include any number of reader communication devices. For example, architecture 1450 may include at least one of IC chip 1452, RFID 1451 and a magnetic stripe communications device. IC chip 1452 may be used to communicate information to an IC chip reader (not illustrated). IC chip 1452 may be, for example, an EMV chip. RFID 1451 may be used to communicate information to an RFID reader. RFID 1451 may be, for example, an RFID device. A magnetic stripe communications device may be included to communicate information to a magnetic stripe reader. For example, a magnetic stripe communications device may provide electromagnetic signals to a magnetic stripe reader.

Different electromagnetic signals may be communicated to a magnetic stripe reader to provide different tracks of data. For example, architecture 1450 may include electromagnetic field generators 1470, 1480, and 1485 to communicate separate tracks of information to a magnetic stripe reader. Electromagnetic field generators 1470, 1480, and 1485 may include a coil (e.g., each may include a coil) wrapped around one or more materials (e.g., a soft-magnetic material and a non-magnetic material). Each electromagnetic field generator may communicate information, for example, serially to a receiver of a magnetic stripe reader for a particular magnetic stripe track. According to at least one example embodiment, a single coil may communicate multiple tracks of data.

According to at least one example embodiment, a magnetic stripe communications device may change the information communicated to a magnetic stripe reader at any time. Processor 1445 may, for example, communicate user-specific and card-specific information through RFID 1451, IC chip 1452, and/or electromagnetic generators 1470, 1480, and 1485 to card readers coupled to remote information processing servers (e.g., purchase authorization servers). Driving circuitry 1441 may be utilized by processor 1445, for example, to control electromagnetic generators 1470, 1480 and 1485. Driving circuitry 1441 may, for example, be implemented by discrete elements. Driving circuitry 1441 may, for example, be implemented as an application specific integrated circuit (ASIC).

Architecture 1450 may include read head detectors 1471 and 1472. Read-head detectors 1471 and 1472 may be configured to sense the presence of a magnetic stripe reader (e.g., a read-head housing of a magnetic stripe reader). Information sensed by the read-head detectors 1471 and 1472 may be communicated to processor 1445 to cause processor 1445 to communicate information serially from electromagnetic generators 1470, 1480, and 1485 to magnetic stripe track receivers in a read-head housing of a magnetic stripe reader. Read-head sensors may reduce power consumption and increase data security by communicating only within proximity of the read-head of a card reader.

Architecture 1450 may include any type of detector used to detect and/or determine the proximity of a read-head. For example, read-head detectors 1471 and 1472 may include one or more capacitive sensors, one or more inductive sensors, one or more photoelectric sensors, one or more magnetic sensors, one or more thermal sensors and/or one or more sonic (e.g., ultrasonic) sensors.

Read-head detectors 1471 and 1472 may include a first sensor to detect the proximity of an object and a second sensor to detect a type of the object. For example, a capacitive sensor, which may consume relatively low or no power, may be used to detect a large number of different materials. The materials may include several types of normally encountered materials not normally used in read-heads. For example, non-read-head materials may include materials used in credit card reader construction outside of the read-head and/or human materials (e.g., a user's finger). Accordingly, a capacitive sensor may erroneously signal the detection of a read-head and data communication may be initiated. An inductive sensor, which may consume relatively higher power (e.g., as compared to a capacitive sensor), may not detect at least some of the materials not normally used in read-heads. Accordingly, by using both a capacitive sensor and an inductive sensor, accuracy with respect to read-head detection may be increased.

For example, a capacitive sensor may indiscriminately detect both a read-head and a user's finger, and an inductive sensor may not detect a user's finger. Accordingly, where a capacitive sensor detects an object, processor 1445 may activate an inductive sensor. The inductive sensor may not detect an object. Accordingly, processor 1445 may determine that a read-head is not detected. Read-head detection error may be reduced while maintaining a relatively low power consumption and improving data security. Data security may be improved by reducing erroneous card data transmission.

Sensors may be combined in a variety of ways to improve detection accuracy and data security. For example, read-head detectors 1471 and 1472 may include a capacitive sensor, an inductive sensor and a photoelectric sensor. The capacitive sensor may be used to detect an object, the inductive sensor may be used to reduce the number of possible types of the object and the photoelectric sensor may be used to detect the absence of light. The absence of light may, for example, occur where a card is not exposed (e.g., where a card is being swiped through a reader, as in a dip reader and/or in a motorized reader). Accordingly, read-head detection and data security may be improved. Persons skilled in the art in possession of example embodiments will appreciate that different types of sensors may be employed in different combinations and numbers to reduce false read-head detections and improve data security.

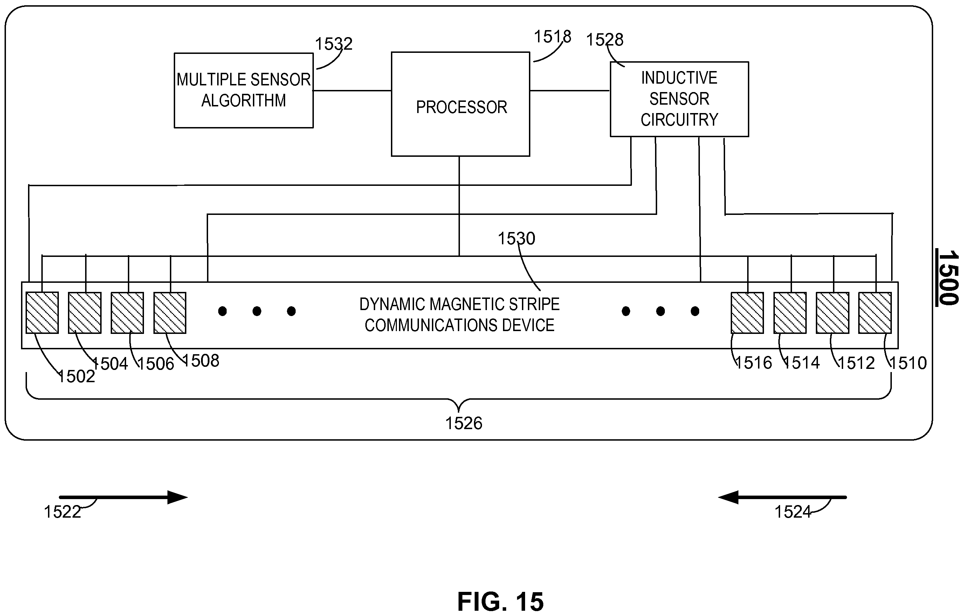

FIG. 15 shows a card with an orientation of detectors 1526 and dynamic magnetic stripe communication device 1530, whereby one or more detectors 1502-1516 and dynamic magnetic stripe communication device 1530 may be, for example, arranged along a length of card 1500.

Detectors 1502-1516 may be provided, for example, as conductive pads using, for example, an additive technique, whereby patterns of a conductive element (e.g., copper) may be applied to a PCB substrate according to a patterning mask definition layer. Detectors 1502-1516 may be provided, for example, as conductive pads using, for example, a subtractive technique whereby patterns of a conductive element (e.g., copper) may be removed from a pre-plated PCB substrate according to an etching mask definition layer. Other non-PCB fabrication techniques may be used to implement conductive pads 1502-1516 as may be required by a particular application.

Processor 1518, conductive pads 1502-1516, processor 1518, dynamic magnetic stripe communication device 1530, inductive sensor circuitry 1528 and multiple sensor algorithm 1532 may be combined to provide a multiple sensor detection system.

For example, each of conductive pads 1502-1516 may be utilized by processor 1518 as capacitive sensing pads. Processor 1518 may include the functionality to control and determine when an object is in the proximity of one or more conductive pads via a capacitive sensing technique. Dynamic magnetic stripe communications device 1530 and inductive sensor circuitry 1528 may be utilized by processor 1518 as an inductive sensing device. For example, a processor may include the functionality to independently utilize multiple portions of dynamic magnetic stripe communications device 1530 and determine when an object is in the proximity of one or more of the portions via an inductive sensing technique.

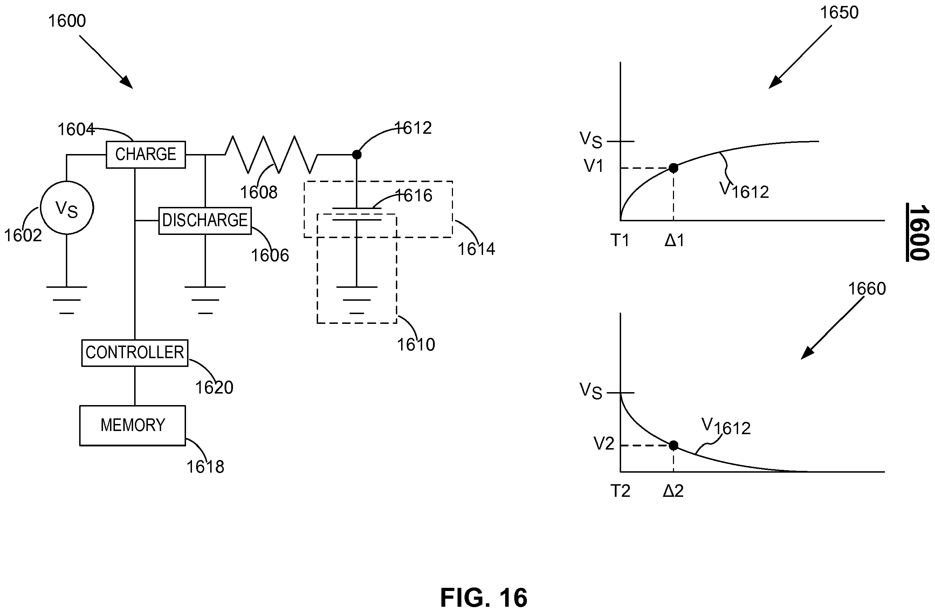

FIG. 16 shows capacitive detection circuitry 1600. A conductive pad may be utilized, for example, as a conductor of a capacitive device within a resistor/capacitor (RC) circuit to determine the capacitance of a conductive pad and determine whether the capacitance is below, equal to, or above one or more predetermined thresholds.

A conductive pad may, for example, form a portion of a capacitive element, such that plate 1616 of capacitive element 1614 may be implemented by a conductive pad and the second plate of capacitive element 1614 may be implemented by element 1610. Element 1610 may represent, for example, the device or object whose proximity or contact is sought to be detected.

The capacitance magnitude of capacitive element 1614 may exhibit, for example, an inversely proportional relationship to the distance separation between plate 1616 and device 1610. For example, the capacitance magnitude of capacitive element 1614 may be relatively low when the corresponding distance between plate 1616 and device 1610 may be relatively large. The capacitance magnitude of capacitive element 1614 may be relatively large, for example, when the corresponding distance between plate 1616 and device 1610 is relatively small.

Capacitive detection may be accomplished, for example, via circuit 1600 of FIG. 16. Through a sequence of charging and discharging events, an average capacitance magnitude for capacitive element 1614 may be determined over time. In so doing, the spatial relationship (e.g., the separation distance) between plate 1616 and device 1610 may be determined.

Charge sequence 1650, for example, may be invoked, such that charge circuit 1604 may be activated at time T1, while discharge circuit 1606 may remain deactivated. Accordingly, for example, current may flow through resistive component 1608. In doing so, for example, an electrostatic field may be generated that may be associated with capacitive component 1614. During the charge sequence, for example, the voltage at node 1612 may be monitored to determine the amount of time required (e.g., $T_{CHARGE} = \Delta1\text{-}T1$) for the voltage at node 1612, $V_{1612}$, to obtain a magnitude that is substantially equal to, below, or above a first threshold voltage (e.g., equal to V1).

Discharge sequence 1660, for example, may be invoked, such that discharge circuit 1606 may be activated at time T2, while charge circuit 1604 may remain deactivated. During the discharge sequence, for example, the electric field associated with capacitive element 1614 may be allowed to discharge through resistive component 1608 to a reference potential (e.g., ground potential). The voltage at node 1612 may be monitored to determine the amount of time required (e.g., $T_{DISCHARGE} = \Delta2\text{-}T2$) for the voltage at node 1612, $V_{1612}$, to obtain a magnitude that is substantially equal to, below, or above a second threshold voltage (e.g., equal to V2).

Once the charge time, $T_{CHARGE}$, and discharge time, $T_{DISCHARGE}$, are determined, the charge and discharge times may be utilized to calculate a capacitance magnitude that may be exhibited by capacitive element 1614. For example, given that the magnitude of voltage, V1, may be equal to approximately 63% of the magnitude of voltage, $V_S$, then a first relationship may be defined by equation (1) as:

$$\text{T}_{\text{CHARGE}} \; = \; \text{R}_{1608}\text{*C1,} \hspace{3cm} (1)$$

where $R_{1608}$ is the resistance magnitude of resistive element 1608 and C1 is proportional to a capacitance magnitude of a capacitive element (e.g., capacitive element 1614).

Similarly, for example, given that the magnitude of voltage, V2, is equal to approximately 37% of the magnitude of voltage, $V_S$, then a second relationship may be determined by equation (2) as:

$$\text{T}_{\text{DISCHARGE}} \; = \; \text{R}_{1608}\text{*C2,} \hspace{3cm} (2)$$

where C2 is proportional to a capacitance magnitude of capacitive element 1614. The capacitance magnitudes, $C_1$ and $C_2$, may then be calculated from equations (1) and (2) and averaged to determine an average capacitance magnitude that is exhibited by capacitive element 1614.

Persons skilled in the art will appreciate that circuits 1604 and 1606 may be activated and deactivated by controller 1620. Accordingly, for example, controller 1620 may control when the charge and discharge events occur. Persons skilled in the art will further appreciate that controller 1620 may adjust a frequency at which circuits 1604 and 1606 may be activated and/or deactivated, thereby adjusting a sampling rate at which the capacitance magnitudes, $C_1$ and $C_2$, may be measured. In so doing, a sampling rate (e.g., a lower sampling rate) may be selected in order to select a power consumption rate of a card (e.g., a lower power consumption rate). Controller 1620 may, for example, store capacitance magnitude measurements within memory 1618. Accordingly, for example, multiple capacitance magnitudes may be stored for subsequent access by controller 1620.

A conductive pad may be utilized, for example, as a conductor of a capacitive device within a resistor/capacitor (RC) circuit to determine the capacitance of a conductive pad and determine whether the capacitance is below, equal to, or above one or more predetermined thresholds.

Referring to FIG. 15, a series of charge and discharge sequences for pads 1502-1516 may be executed by processor 1518 to determine, for example, a relative capacitance magnitude that is exhibited by each of pads 1502-1516. A series of charge and discharge sequences for each of pads 1502-1516 may be executed by processor 1518, for example, in order to obtain a capacitance characteristic for each of pads 1502-1516 over time.

By comparing the time-based capacitance characteristic of each pad 1502-1516 to a threshold capacitance value, a determination may be made, for example, as to when pads 1502-1516 are in a proximity, or touch, relationship with a device whose presence is to be detected. For example, a sequential change (e.g., increase) in the relative capacitance magnitudes of pads 1502-1508, respectively, and/or pads 1516-1510, respectively, may be detected and a determination may be made that a device is moving substantially in direction 1522 relative to card 1500. A sequential change (e.g., increase) in the relative capacitance magnitudes of detectors 1510-1516, respectively, and/or 1508-1502, respectively, may be detected, for example, and a determination may be made that a device is moving substantially in direction 1524 relative to card 1500. Based on the detection, processor 1518 may activate inductive sensor circuitry 1528 in order to determine if the object is inductively detectable.

Persons skilled in the art will appreciate that by electrically shorting pairs of detectors together (e.g., pair 1502/1510, pair 1504/1512, pair 1506/1514, etc.) directional vectors 1522 and 1524 become insubstantial. For example, regardless of whether a device is moving substantially in direction 1522 or substantially in direction 1524 relative to card 1500, a determination may nevertheless be made that a device is close to, or touching, card 1500.

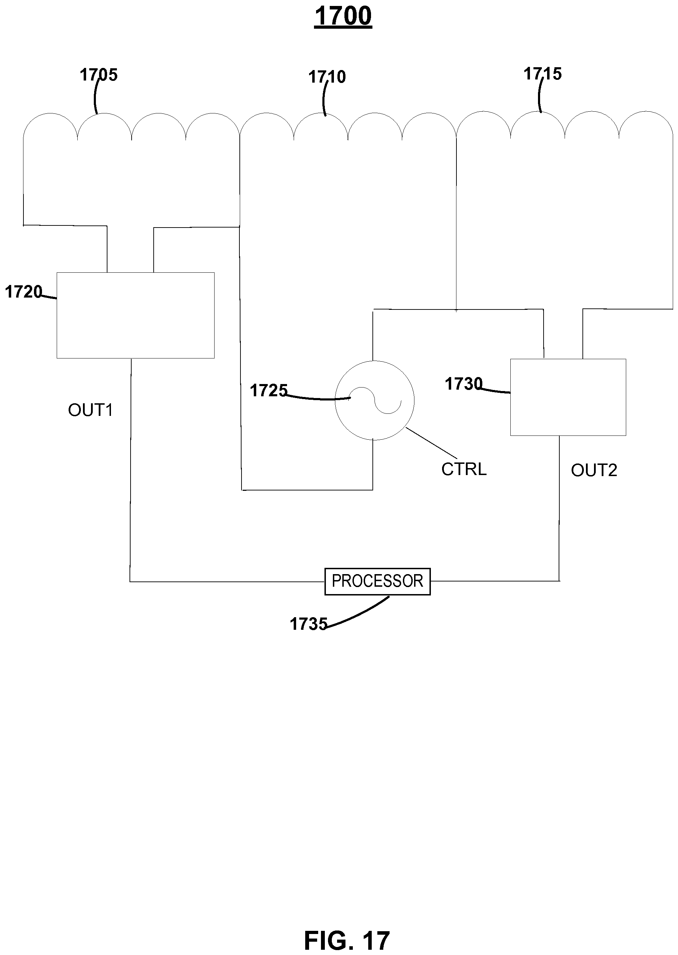

FIG. 17 shows inductive detection circuitry 1700. Referring to FIG. 17, inductive detection circuitry 1700 may include, for example, coil portions 1705-1715, amplification and detection determination devices 1720 and 1730, oscillator 1725 and processor 1735.

Coil portions 1705-1715 may be portions of a coil, for example, portions of a coil in a dynamic magnetic stripe communications device. Coil portion 1710 may be, for example, a central portion of a coil in a dynamic magnetic stripe communications device, and may be connected across oscillator 1725, or may be one or more separate coils. Oscillator 1725 may be, for example, an electronic circuit that produces a repetitive, oscillating electrical signal (e.g., an alternating current and/or voltage) and/or may be a signal from an output of a port on processor 1735. A control signal CTRL may be communicated to oscillator 1725 (e.g., by processor 1735) to initiate application of the electrical signal to coil portion 1710. A time-varying magnetic field may be generated by coil portion 1710 due to the signal. The time varying magnetic field may induce repetitive, oscillating electrical signals in each of coil potions 1705 and 1715.

Coil portions 1705 and 1715 may be, for example, side portions of a coil in a dynamic magnetic stripe communications device. Although FIG. 17 shows coil portions 1705 and 1715 adjacent to coil portion 1710, example embodiments are not so limited. Coil portions 1705-1715 may be, for example, separated by other coil portions (not shown).

Coil portion 1705 may be connected to oscillator 1725 (e.g., a high frequency oscillator), and connected across amplification and detection determination device 1720. Amplification and detection determination device 1720 may receive the oscillating signal induced in coil portion 1705 by coil portion 1710, and output a signal OUT1 to processor 1735. Coil portion 1715 may be connected to oscillator 1725, and connected across amplification and detection determination device 1730. Amplification and detection determination device 1730 may receive the oscillating signal induced in coil portion 1715 by coil portion 1710, and output a signal OUT2 to processor 1735. Signals OUT1 and OUT2 may indicate whether or not signals induced in coil portions 1705 and/or 1715 are less than, equal to or greater than a threshold signal value.

The threshold signal value may be based on the magnitude of the signals induced in coil portions 1705 and 1715 when coil portions 1705 and 1715 are adjacent to an object (e.g., a read-head of a card reader), and when coil portions 1705 and 1715 are not adjacent to an object.

Persons of ordinary skill in the art may appreciate that in the presence of a high frequency magnetic field, currents may be induced in a conductive object within the field. The currents may consume power due to resistance and energy in the field may be lost. Signal amplitude may decrease in side portions of a coil in the presence of a conductive object according to example embodiments. Accordingly, a read-head of a card reader may change the coupling between coil portion 1710, and coil portions 1705 and 1715, such that a magnitude of the signal induced in coil portions 1705 and 1715 by coil portion 1710 may decrease.

Referring to FIG. 15, inductive detection may be implemented by determining coupling responses in coil end sections and setting response threshold values. For example, an oscillating signal may be applied to a center portion of a coil in dynamic magnetic stripe communications device 1530 by processor 1518 via inductive sensor circuitry 1528. A coupling response in the coil end sections may be determined both when an object is within proximity of card 1500 and when no object is within proximity of card 1500. The coupling response may be determined by, for example, measuring a current and/or voltage across the end coil sections. Based on a difference between the coupling responses, a threshold value may be determined. Multiple sensor algorithm 1532 may utilize the threshold value to determine whether or not an object is detected.

According to at least one example embodiment, multiple threshold values may be determined in order to discriminate between multiple different objects. For example, multiple different objects may be passed in proximity to dynamic magnetic stripe communications device 1530 to determine a coupling response of the end coil sections in the presence of each of the objects. The coupling response may be determined by, for example, measuring a current and/or voltage across the end coil sections in the presence of each object. One or more threshold signal values may be determined based on the coupling responses.

For example, a human finger, a skimmer, a first type of read-head and a second type of read-head may be passed within proximity of dynamic magnetic stripe communications device 1530. A change in coupling between the center and end sections of the coil in magnetic stripe communications device 1530 for each object may be determined. One or more thresholds may be set such that during normal operation processor 1518 will activate dynamic magnetic stripe communications device 1530 to communicate data in the presence of the first and second type of read-head, but not in the presence of the skimmer or human finger.

Accordingly, if the coupling response of card 1500 in the presence of the skimmer is between that of the coupling responses of the first and second types of read-heads, and a coupling response in the presence of the human finger is less than the coupling response in the presence of any other of the objects, three separate threshold values may be set. During normal operation, by comparing the coupling response of the end sections to the one or more threshold values, a determination may be made, for example, as to when the coil end sections are in a proximity, or touch, relationship with a device whose presence is to be detected.

Inductive sensor circuitry 1528 and dynamic magnetic stripe communications device 1530 may be used in conjunction with, for example, one or more pads 1502-1516 to determine that a device (e.g., a read-head housing of a magnetic stripe reader) is in close proximity, or touching, one or more of pads 1502-1516. Processor 1518 may, for example, utilize multiple sensor algorithm 1532 to detect a device moving with respect to card 1500. For example, multiple sensor algorithm 1532 may analyze a capacitance change in one or more conductive pads to determine that a device is moving in relation to pads 1502-1516. Once a device is detected, processor 1518 may, for example, apply an oscillating signal to a center portion of dynamic magnetic stripe communication device 1530 and detect a coupling response of side portions of dynamic magnetic stripe communication device 1530. If a coupling response indicates that (e.g., inductive detection) an object is detected, processor 1518 may communicate with the detected device via dynamic magnetic stripe communications device 1528.

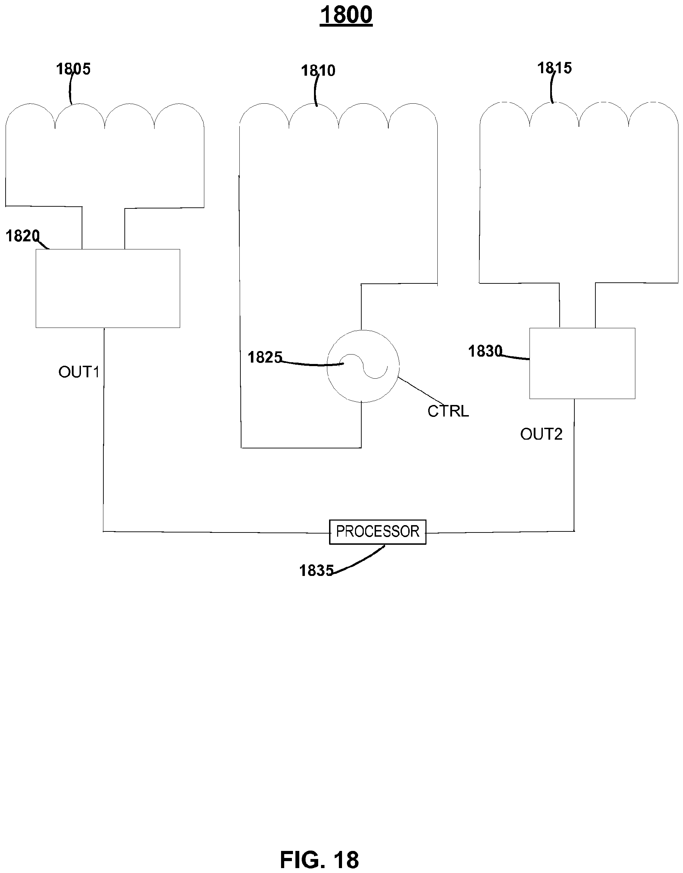

FIG. 18 shows inductive detection circuitry 1800. Referring to FIG. 18, inductive detection circuitry 1800 may include, for example, coils 1805-1815, amplification and detection determination devices 1820 and 1830, oscillator 1825 and processor 1835.

Coil 1810 may be, for example, a coil of a dynamic magnetic stripe communications device and/or a coil separate from the dynamic magnetic stripe communications device. Coil 1810 may be connected across oscillator 1825. Oscillator 1825 may be, for example, an electronic circuit that produces a repetitive, oscillating electrical signal (e.g., an alternating current and/or voltage). Oscillator 1825 may be, for example, a processor (e.g., a signal may be output from a port of a processor). A control signal CTRL may be communicated to oscillator 1825 (e.g., by processor 1835) to initiate application of the electrical signal to coil 1810. A time-varying magnetic field may be generated by coil 1810 due to the signal. The time varying magnetic field may generate repetitive, oscillating electrical signals in each of coils 1805 and 1815.

Coils 1805 and 1815 may be, for example, detection coils on opposite ends of a card. For example, coils 1805 and 1815 may be adjacent to capacitive sensors at ends of a card. Coil 1805 may be connected across amplification and detection determination device 1820. Amplification and detection determination device 1820 may receive the oscillating signal induced in coil 1805 by coil 1810, and output a signal OUT1 to processor 1835. Coil 1815 may be connected across amplification and detection determination device 1830. Amplification and detection determination device 1830 may receive the oscillating signal induced in coil 1815 by coil 1810, and output a signal OUT2 to processor 1835. Signals OUT1 and OUT2 may indicate whether or not signals induced in coil portions 1805 and/or 1815 are less than, equal to or greater than a threshold signal value indicating whether or not an object is inductively detected.

The threshold signal value may be based on the magnitude of a signal induced in coil 1805 and/or coil 1815 when coil 1805 and/or coil 1815 is adjacent to an object (e.g., a read-head of a card reader), and the magnitude of a signal when coil 1805 and 1815 are not adjacent to an object.

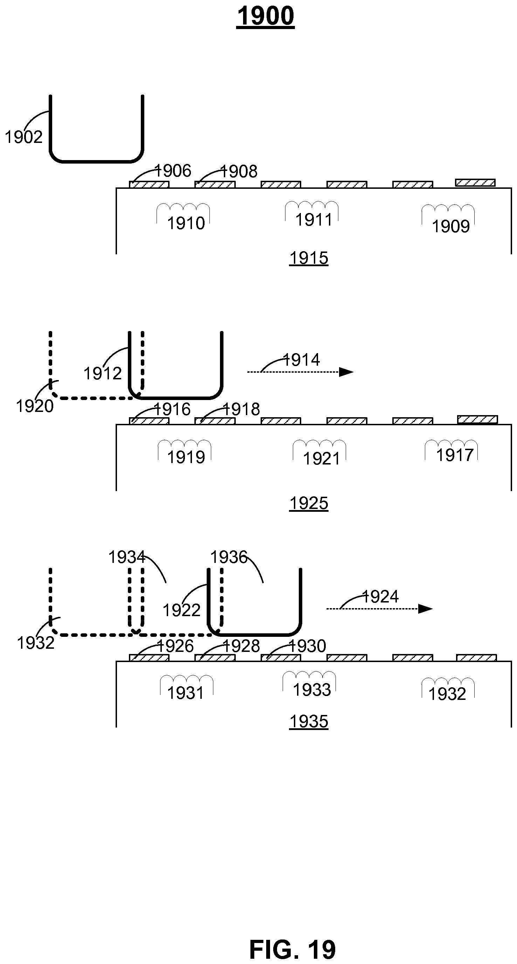

FIG. 19 shows a card that is in proximity to an object 1902. Card 1915 may be in proximity to object 1902 such that a distance between conductive pad 1906 and object 1902 is less than a distance between conductive pad 1908 and object 1902. Accordingly, for example, a capacitance magnitude that may be associated with conductive pad 1906 may be, for example, greater than a capacitance magnitude that may be associated with conductive pad 1908. Persons of ordinary skill will appreciate that capacitance values may be relative to each pad and that a capacitance magnitude of a proximate pad may be equal to or less than a pad that is farther away from an object depending on, for example, manufacturing variation. Such pads may be in any case characterized such that the detected capacitances may be used to determine which pad is closer to an object.

A processor that may be monitoring the capacitance magnitudes of conductive pads 1906 and 1908 may determine, for example, that object 1902 is close to conductive pad 1906. Based on the determination, the processor may cause a time-varying signal to be applied to coil 1911, and may monitor coils 1910 and 1909 to determine a property (e.g., relative conductivity) of object 1902 (e.g., a read-head of a magnetic stripe reader).

Card 1925 may be in proximity to a device (e.g., read-head 1912) that may have moved from position 1920 such that a distance between conductive pad 1918 and device 1912 may be slightly greater than a distance between conductive pad 1916 and device 1912. Accordingly, for example, a capacitance magnitude that may be associated with conductive pad 1916 may be, for example, slightly greater than a capacitance magnitude that may be associated with conductive pad 1918. In so doing, for example, a processor that may be monitoring the capacitance magnitudes of conductive pads 1916 and 1918 may determine that a device may be travelling in direction 1914. Further, a processor may determine that a device is slightly closer to conductive pad 1916 than to conductive pad 1918. The processor may initiate inductive detection when device 1912 is at, for example, position 1920, by applying a time-varying signal to coil 1921, and may terminate the signal upon detecting device 1912 via coil 1919 and/or 1917.

Card 1935 may be in proximity to a device (e.g., read-head 1922) that may have moved from position 1932 to 1934. Accordingly, for example, a capacitance magnitude that may be associated with conductive pad 1928 may be slightly greater than a capacitance magnitude that may be associated with conductive pad 1926. In so doing, for example, a processor that may be monitoring the capacitance magnitudes of conductive pads 1926 and 1928 may determine that a device may be travelling in direction 1924. Further, a processor may determine that a device is slightly closer to conductive pad 1928 than to conductive pad 1926. The processor may initiate inductive detection when device 1922 is at, for example, position 1934 by applying a time-varying signal to coil 1933, and may terminate the signal upon detecting device 1922 via coil 1931 and/or 1932, and/or within a period of time.

Device 1922 may move from position 1934 to position 1936. Accordingly, for example, a capacitance magnitude that may be associated with conductive pad 1930, for example, may be slightly greater than a capacitance magnitude that may be associated with conductive pad 1928. In so doing, for example, a processor that may be monitoring the capacitance magnitudes of conductive pads 1930 and 1928 may determine that a device may be travelling in direction 1924.

A processor may determine, for example, that a device is first located closest to conductive pad 1926, the device is then located closest to conductive pad 1928, and the device is then located closest to conductive pad 1930 in succession by detecting, for example, that a capacitance magnitude of conductive pad 1926 changes (e.g., increases), followed by a capacitance change (e.g., increase) of conductive pad 1928, and then followed by a capacitance change (e.g., increase) of conductive pad 1930, respectively. In response to a sequential capacitance change in pads 1926, 1928, and 1930, respectively, and a coupling response change in coil 1931, a processor may activate one or more electromagnetic field generators to initiate a communications sequence with, for example, read-head 1922. Each of the capacitance changes, the direction of movement and the inductive sensing may be used to determine that card 1935 is moving with respect to a read-head in an expected fashion, for example, a swipe through a card reader. A communication sequence may be initiated upon card 1935 determining that an expected sequence of events has occurred.

Sequences and relative timings of events may be known for various other types of readers (e.g., dip and/or motorized readers). Accordingly, data communication and data security may be improved. Persons of ordinary skill in the art will appreciate that read-head detection may occur in a similar fashion for movement in a direction opposite to direction 624.

A sequential capacitance change in conductive pads 1926-1930, respectively, may not occur. For example, a speed at which a device (e.g., read-head 1922) travels in direction 1924 relative to card 1935 may cause a processor to detect a capacitance change, for example, in conductive pad 1926 followed by a capacitance change in conductive pad 1930, but a capacitance change in conductive pad 1928 may not be detected. Accordingly, for example, a processor may execute a detection algorithm with an awareness of capacitance changes in non-adjacent conductive pads (e.g., conductive pads separated by one or more other conductive pads). In so doing, for example, a processor may nevertheless determine that a device is moving in proximity to a card and may activate a communications device in response to such a detection. A processor may, for example, detect devices moving at increased speeds (e.g., twice an average swipe speed) without sacrificing detection accuracy.

A processor may measure a magnitude of capacitance changes in conductive pads 1926-1930 that is not, for example, consistent with movement of a device in direction 1924. For example, a processor may first measure a capacitance magnitude associated with conductive pad 1926 that may be larger than a capacitance magnitude of either of conductive pads 1928 and 1930. A processor may next measure a capacitance magnitude associated with conductive pad 1930 that may be larger than a capacitance magnitude of either of conductive pads 1926 and 1928. A processor may next measure a capacitance magnitude associated with conductive pad 1928 that may be larger than a capacitance magnitude of either of conductive pads 1926 and 1930.

In so doing, for example, movement of a device in direction 1924 may be considered to be inconsistent with such a capacitance characteristic, since sequential capacitance magnitude increases may not be detected in conductive pads 1926, 1928, and 1930, respectively. A processor executing a multiple sensor algorithm may have an awareness that detected capacitance increases may be inconsistent with an actual direction of movement of a device. In so doing, for example, a processor may determine that a device is in proximity to card 1935, is not moving in direction 1924, and may not, for example, activate a communications device in response to such a detection.

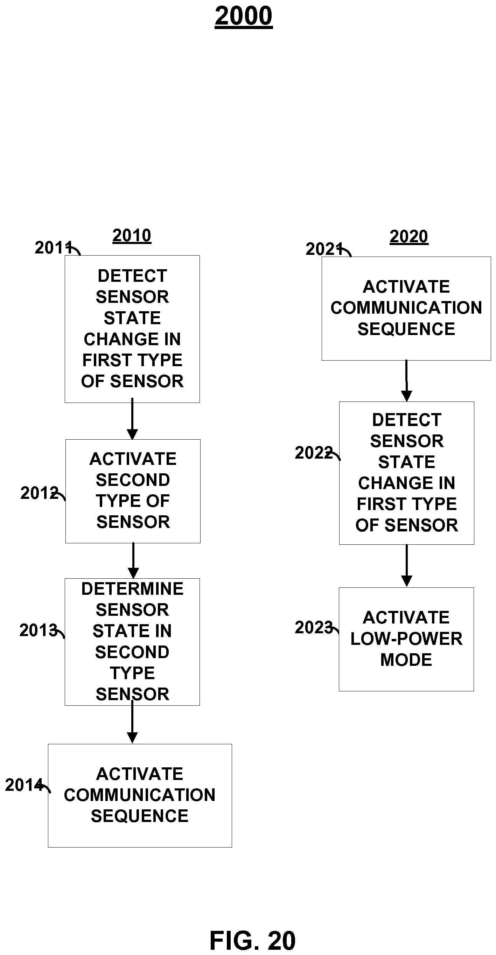

FIG. 20 shows a detection method flow diagram. Referring to sequence 2010, a sensor state change (e.g., an increased capacitance) may be detected in a first type of sensor (e.g., as in step 2011). A second type of sensor may be activated in response to the sensor state change (e.g., as in step 2012). A state of the second type of sensor (e.g., an inductive detection of a conductive object) may be determined (e.g., as in step 2013). Based on the first sensor state change and the state of the second type of sensor, a communication sequence may be activated (e.g., as in step 2014) and/or the second type of sensor may be deactivated.

A card may be fully operational (e.g., as in step 2021 of sequence 2020), whereby a communication sequence may be activated after a device is detected to be in proximity, or touching, the card. Once the communication sequence is completed, a state change of a first type of sensor (e.g., an increased capacitance) may be detected (e.g., as in step 2022). A low-power mode of a card may be activated based on the state change detection (e.g., as in step 2023).

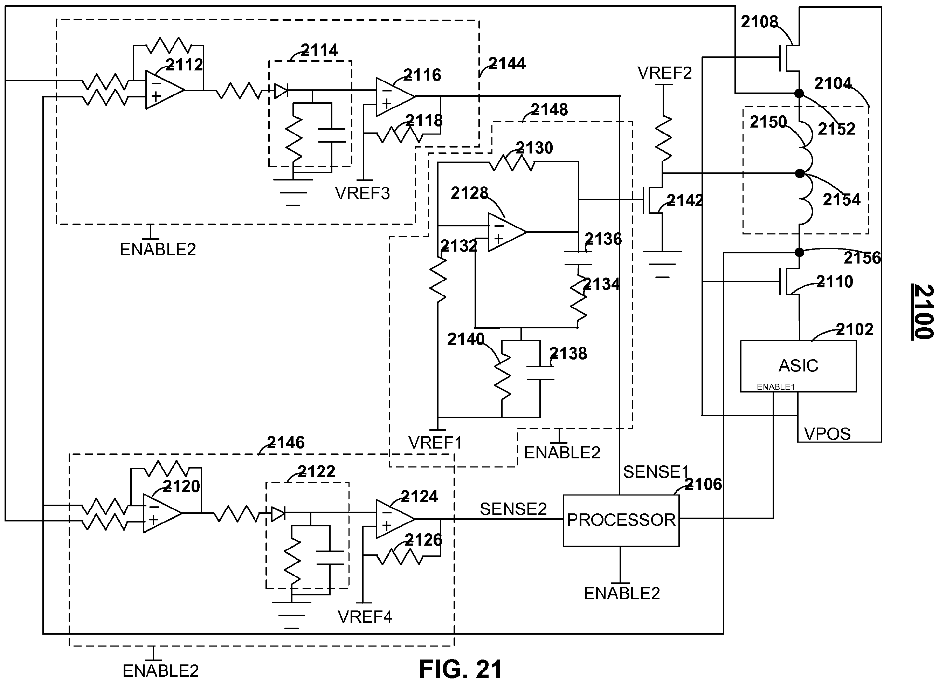

FIG. 21 shows inductive detection circuitry 2100. Inductive detection circuitry 2100 may include, for example, one or more coils (e.g., dynamic magnetic stripe communications device 2104), a coil driver (e.g., ASIC 2102), processor 2106, excitation device (e.g., oscillator 2148) and one or more sensors (e.g., sensor 2144 and/or sensor 2166). Dynamic magnetic stripe communications device 2104 may, for example, include a first coil (e.g., coil 2150) for communicating a first track of magnetic stripe information to a read head of a magnetic stripe reader, a second coil (not shown) for communicating a second track of magnetic stripe information to the read head of the magnetic stripe reader and a third coil (not shown) for communicating a third track of magnetic stripe information to the read head of the magnetic stripe reader.

Any one or more coils of dynamic magnetic stripe communications device 2104 may be used in a first mode of operation as a magnetic stripe communications device and in a second mode of operation, dynamic magnetic stripe communications device 804 may be used as a component of inductive detection circuitry 2100. In the first mode of operation, processor 2106 may activate ASIC 2102 (e.g., via assertion of signal ENABLE1 of ASIC 2102), which may in turn cause ASIC 2102 to assert a signal (e.g., ASIC 2102 may assert signal VPOS to an active high voltage level). In so doing, for example, switch devices (e.g., NFET 2108 and NFET 2110) may transition to a conductive state, thereby coupling ASIC 2102 to one or more coils of dynamic magnetic stripe communications device 2104 (e.g., node 2156 is electrically coupled to ASIC 2102 via NFET 2110 and node 2152 is electrically coupled to ASIC 2102 via NFET 2108).

In the second mode of operation, processor 2106 may deactivate ASIC 2102 (e.g., via deassertion of signal ENABLE1 of ASIC 2102), which may in turn cause ASIC 2102 to deassert a signal (e.g., ASIC 2102 may deassert signal VPOS to an inactive low voltage level). In so doing, for example, switch devices (e.g., NFET 2108 and NFET 2110) may transition to a non-conductive state, thereby decoupling ASIC 2102 from one or more coils of dynamic magnetic stripe communications device 2104 (e.g., node 2156 is electrically isolated from ASIC 2102 via NFET 2110 and node 2152 is electrically isolated from ASIC 2102 via NFET 2108). In addition, for example, processor 2106 may assert signal, ENABLE2, thereby activating oscillator 2148, sensor circuit 2144 and/or sensor circuit 2146 during the second mode of operation.

Oscillator circuit 2148 may, for example, include an operational amplifier (OP AMP 2128), a feedback network (e.g., resistors 2130 and 2132) and a frequency selection network (e.g., resistors 2134, 2140 and capacitors 2136, 2138). VREF1 may, for example, be a reference voltage (e.g., ground potential) when OP AMP 2128 operates between positive and negative power supply rails (e.g., an output signal generated by OP AMP 2128 is a signal having a direct current (DC) component at or near ground potential). VREF1 may, for example, be a reference voltage (e.g., a positive potential greater than ground potential) when OP AMP 2128 operates between a positive power supply rail and ground potential (e.g., an output signal generated by OP AMP 2128 is a signal having a direct current (DC) component at a positive potential above ground potential).

Oscillator circuit 2148 may, for example, generate a signal (e.g., a square wave signal) having a frequency that may be selected by a frequency selection network (e.g., resistors 2134, 2140 and capacitors 2136,2138), where resistors 2134, 2140 may be selected to have equivalent resistance magnitudes approximately between 1500 ohms and 5000 ohms (e.g., approximately 3300 ohms) and capacitors 2136, 2138 may be selected to have equivalent capacitance magnitudes approximately between 20 and 80 pF (e.g., approximately 47 pF). The signal frequency, $f_{osc}$, generated by oscillator circuit 2148 may be approximated as, $f_{OSC} = \frac{1}{2\pi C * R}$, where C is the capacitance magnitude of capacitors 2136, 2138 and R is the resistance magnitude of resistors 2134, 2140. Accordingly, for example, the sinusoidal frequency,

$f_{osc}$, generated by oscillator circuit 2148 may be between approximately 400 kHz and 5 MHz (e.g., approximately 500 kHz).

Feedback network (e.g., resistors 2130 and 2132) of oscillator circuit 2148 may, for example, be used to select a voltage gain of OP AMP 2128, such that the overall gain of oscillator circuit 2148 is at, or near, unity when a signal at frequency, $f_{osc}$, is being generated. Accordingly, for example, a ratio of the resistance magnitude of resistor 2130 to the resistance magnitude of resistor 2132 may be approximately between 2 and 10 (e.g., approximately equal to 5).

In the second mode of operation, for example, oscillator circuit 2148 may generate a signal to directly or indirectly excite a portion of dynamic magnetic stripe communications device 2104 (e.g., center-tap node 2154 of coil 2150). In one embodiment, for example, the signal may transition transistor 2142 between conductive and non-conductive states, thereby applying a signal (e.g., a voltage signal approximately equal to ground potential) to node 2154 when transistor 2142 is conductive and applying a signal (e.g., a voltage signal approximately equal to VREF2) to node 2154 when transistor 2142 is non-conductive. In so doing, for example, at least a portion of dynamic magnetic stripe communications device 2104 may be excited during the second mode of operation.

A signal (e.g., a voltage signal) that may be indicative of an excitation of at least one coil of dynamic magnetic stripe communications device 2104 during the second mode of operation may be sensed by sensor 2144 and/or 2146 at nodes 2152 and/or 2156, respectively. One or more differential amplifiers (e.g., amplifier 2112 and/or 2120) may, for example, be used to sense the difference between a signal present at a node (e.g., node 2152) as compared to a signal present at a different node (e.g., node 2156).

In the absence of a proximity, or touch, relationship with an object (e.g., a read head of a magnetic stripe reader) during the second mode of operation, for example, the sensed difference between a signal present at node 2152 as compared to a signal present at node 2156 may be substantially equal to zero. Accordingly, sensors 2144 and/or 2146 may provide a difference signal (e.g., a signal indicative of a zero difference) to indicate that no object may be in a touch, or proximity, relationship to dynamic magnetic stripe communications device 2104 during the second mode of operation.

In the presence of a proximity, or touch, relationship with an object (e.g., a read head of a magnetic stripe reader) during the second mode of operation, for example, the sensed difference between a signal present at node 2152 as compared to a signal present at node 2156 may be substantially non-zero. Accordingly, sensors 2144 and/or 2146 may provide a difference signal (e.g., a signal indicative of a non-zero difference) to indicate that an object may be in a touch, or proximity, relationship to dynamic magnetic stripe communications device 804 during the second mode of operation.

Differential amplifier 2112 of sensor 2144 may, for example, provide a difference signal that is indicative of a magnitude of a signal present at node 2152 subtracted from a magnitude of a signal present at node 2156. Differential amplifier 2120 of sensor 2146 may, for example, provide a difference signal that is indicative of a magnitude of a signal present at node 2156 subtracted from a magnitude of a signal present at node 2152.

Peak detector 2114 may, for example, receive a difference signal generated by differential amplifier 2112 and/or peak detector 2122 may, for example, receive a difference signal generated by differential amplifier 2120. Excursions (e.g., maximum positive excursions) of the difference signal generated by differential amplifier 2112 and/or differential amplifier 2120 may, for example, forward bias a diode of peak detector 2114 and/or 2122, which may allow a capacitor of peak detector 2114 and/or 2122 to charge to a voltage indicative of such a maximum positive excursion, where the voltage may be maintained by the capacitor for a period of time (e.g., time enough for the difference signal generated by differential amplifier 2112 and/or differential amplifier 2120 to be sensed and processed by processor 2106). A resistance may, for example, be placed in parallel with the capacitor of peak detector 2114 and/or 2122 in order to allow the capacitor of peak detector 2114 and/or 2122 to discharge after a period of time (e.g., after the difference signal generated by differential amplifier 2112 and/or differential amplifier 2120 has been sensed and processed by processor 2106).

Comparators 2116 and 2124 of sensors 2144 and 2146, respectively, may compare the maximum positive signal excursions as may be generated by peak detectors 2114 and 2122, respectively, to a reference potential (e.g., VREF3 and VREF4, respectively). Comparator 2116 may, for example, compare a maximum of the difference signal, $V_{2156}-V_{2152}$, as may be generated by peak detector 2114, to VREF3, where $V_{2156}$ is the voltage at node 2156 and $V_{2152}$ is the voltage at node 2152. If the difference signal is below VREF3, then an output of comparator 2116 (e.g., signal SENSE1) may be at a logic high level, whereas if the difference signal is above VREF3, then an output of comparator 2116 (e.g., signal SENSE1) may be at a logic low level. Resistor 2118 may be used to provide hysteresis, so that an output of comparator 2116 does not oscillate when a magnitude of the difference signal present at the inverting input to comparator 2116 is at, or near, the magnitude of VREF3.

Similarly, comparator 2124 may, for example, compare a maximum of the difference signal, $V_{2152}-V_{2156}$, as may be generated by peak detector 2122, to VREF4, where $V_{2156}$ is the voltage at node 2156 and $V_{2152}$ is the voltage at node 2152. If the difference signal is below VREF4, then an output of comparator 2124 (e.g., signal SENSE2) may be at a logic high level, whereas if the difference signal is above VREF4, then an output of comparator 2116 (e.g., signal SENSE2) may be at a logic low level. Resistor 2126 may be used to provide hysteresis, so that an output of comparator 2124 does not oscillate when a magnitude of the difference signal present at the inverting input to comparator 2124 is at, or near, the magnitude of VREF4.

Processor 2106 may, for example, monitor signals, SENSE1 and/or SENSE2, as may be produced by sensors 2144 and/or 2146, respectively, to make a determination as to whether an object (e.g., a read head of a magnetic stripe reader) is in a proximity, or touch, relationship to dynamic magnetic stripe communications device 2104 during the second mode of operation.

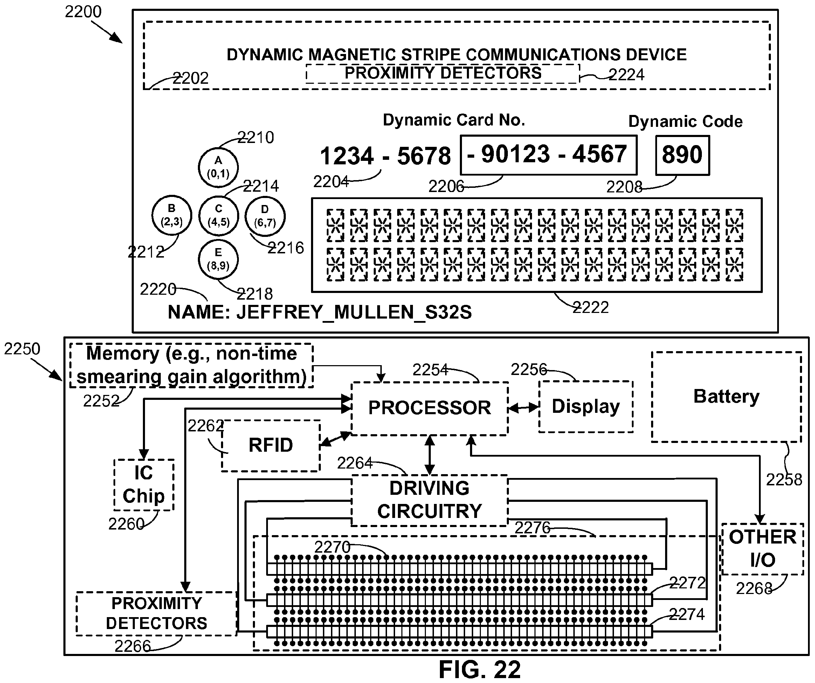

FIG. 22 shows card 2200 that may include, for example, a dynamic number that may be entirely, or partially, displayed using a display (e.g., display 2206). A dynamic number may include a permanent portion such as, for example, permanent portion 2204 and a dynamic portion such as, for example, dynamic portion 2206. Card 2200 may include a dynamic number having permanent portion 2204 and permanent portion 2204 may be incorporated on card 2200 so as to be visible to an observer of card 2200. For example, labeling techniques, such as printing, embossing, laser etching, etc., may be utilized to visibly implement permanent portion 2204.

Card 2200 may include a second dynamic number that may be entirely, or partially, displayed via a second display (e.g., display 2208). Display 2208 may be utilized, for example, to display a dynamic code such as a dynamic security code. Card 2200 may include third display 2222 that may be used to display graphical information, such as logos and barcodes. Third display 2222 may be utilized to display multiple rows and/or columns of textual and/or graphical information.

Persons skilled in the art will appreciate that any one or more of displays 2206, 2208, and/or 2222 may be implemented as a bi-stable display. For example, information provided on displays 2206, 2208, and/or 2222 may be stable in at least two different states (e.g., a powered-on state and a powered-off state). Any one or more of displays 2206, 2208, and/or 2222 may be implemented as a non-bi-stable display. For example, the display is stable in response to operational power that is applied to the non-bi-stable display. Other display types, such as LCD or electrochromic, may be provided as well.

Other permanent information, such as permanent information 2220, may be included within card 2200, which may include user specific information, such as the cardholder's name or username. Permanent information 2220 may, for example, include information that is specific to card 2200 (e.g., a card issue date and/or a card expiration date). Information 2220 may represent, for example, information that includes information that is both specific to the cardholder, as well as information that is specific to card 2200.

Card 2200 may accept user input data via any one or more data input devices, such as buttons 2210-2218. Buttons 2210-2218 may be included to accept data entry through mechanical distortion, contact, or proximity. Buttons 2210-2218 may be responsive to, for example, induced changes and/or deviations in light intensity, pressure magnitude, or electric and/or magnetic field strength. Such information exchange may then be determined and processed by a processor of card 2200 as data input.

Two or more detectors 2224 may be implemented to detect, for example, the proximity, or actual contact, of an object, such as a read-head housing of a magnetic stripe reader. Proximity detectors 2224 may be utilized, for example, to detect a magnetic stripe reader during a transaction (e.g., a card-based financial transaction) when card 2200 is swiped through a read-head housing of the magnetic stripe reader. During such a transaction, dynamic magnetic stripe communications device 2202 may be activated in response to such a detection to provide one or more tracks of magnetic stripe data to the detected magnetic stripe reader.

Card 2200 may be implemented using architecture 2250, which may include one or more processors 2254. One or more processors 2254 may be configured to utilize external memory 2252, internal memory of processor 2254, or a combination of external memory 2252 and internal memory for storing information, such as executable machine language, related dynamic machine data, non-time smearing gain algorithms and user input data values.

One or more of the components shown in architecture 2250 may be configured to transmit information to processor 2254 and/or may be configured to receive information as transmitted by processor 2254. For example, one or more displays 2256 may be coupled to receive data from processor 2254. The data received from processor 2254 may include, for example, at least a portion of dynamic numbers and/or dynamic codes. The data to be displayed on the display may be displayed on one or more displays 2256.

One or more displays 2256 may be, for example, touch sensitive and/or proximity sensitive. For example, objects such as fingers, pointing devices, etc., may be brought into contact with displays 2256, or in proximity to displays 2256. Detection of object proximity or object contact with displays 2256 may be effective to perform any type of function (e.g., transmit data to processor 2254). Displays 2256 may have multiple locations that are able to be determined as being touched, or determined as being in proximity to an object.

Input and/or output devices may be implemented on architecture 2250. For example, integrated circuit (IC) chip 2260 (e.g., an EMV chip) may be included on architecture 2250, that can communicate information with a chip reader (e.g., an EMV chip reader). Radio frequency identification (RFID) module 2262 may be included within architecture 2250 to enable the exchange of information with an RFID reader.

Other input and/or output devices 2268 may be included on architecture 2250, for example, to provide any number of input and/or output capabilities. For example, other input and/or output devices 2268 may include an audio device capable of receiving and/or transmitting audible information.

Other input and/or output devices 2268 may include a device that exchanges analog and/or digital data using a visible data carrier. Other input and/or output devices 2268 may include a device, for example, that is sensitive to a non-visible data carrier, such as an infrared data carrier or electromagnetic data carrier.

Persons skilled in the art will appreciate that a card (e.g., card 2200 of FIG. 22) may, for example, be a self-contained device that derives its own operational power from one or more batteries 2258. Furthermore, one or more batteries 2258 may be included, for example, to provide operational power for a period of time (e.g., approximately 2-4 years). One or more batteries 2258 may be included, for example, as rechargeable batteries.

Electromagnetic field generators 2270-2274 may be included on architecture 2250 to communicate information to, for example, a read-head of a magnetic stripe reader via, for example, electromagnetic signals. For example, electromagnetic field generators 2270-2274 may be included to communicate one or more tracks of electromagnetic data to read-heads of a magnetic stripe reader. Electromagnetic field generators 2270-2274 may include, for example, a series of electromagnetic elements, where each electromagnetic element may be implemented as a coil wrapped around one or more materials (e.g., a magnetic material and/or a non-magnetic material). Additional materials may be placed outside the coil (e.g., a magnetic material and/or a non-magnetic material).

Electrical excitation by processor 2254 of one or more coils of one or more electromagnetic elements via, for example, driving circuitry 2264 may be effective to generate electromagnetic fields from one or more electromagnetic elements. One or more electromagnetic field generators 2270-2274 may be utilized to communicate electromagnetic information to, for example, one or more read-heads of a magnetic stripe reader.

Timing aspects of information exchange between the various I/O devices implemented on architecture 2250 may be determined by processor 2254. One or more proximity detectors 2266 may be utilized, for example, to sense the proximity, mechanical distortion, or actual contact, of an external device, which in turn, may trigger the initiation of a communication sequence by processor 2254. The sensed presence, mechanical distortion, or touch of the external device may be effective to, for example, determine the type of device or object detected.

For example, the detection may include the detection of, for example, a read-head housing of a magnetic stripe reader. The detection may include a detection of a read-head housing as it moves at a high rate of speed and/or a changing rate of speed in relation to a card (e.g., card 2200 of FIG. 22). In response, processor 2254 may activate one or more electromagnetic field generators 2270-2274 to initiate a communications sequence with, for example, one or more read-heads of the magnetic stripe reader.

Persons skilled in the art will appreciate that processor 2254 may provide user-specific and/or card-specific information through utilization of any one or more of buttons 2210-2218, RFID 2262, IC chip 2260, electromagnetic field generators 2270-2274, and other input and/or output devices 2268.

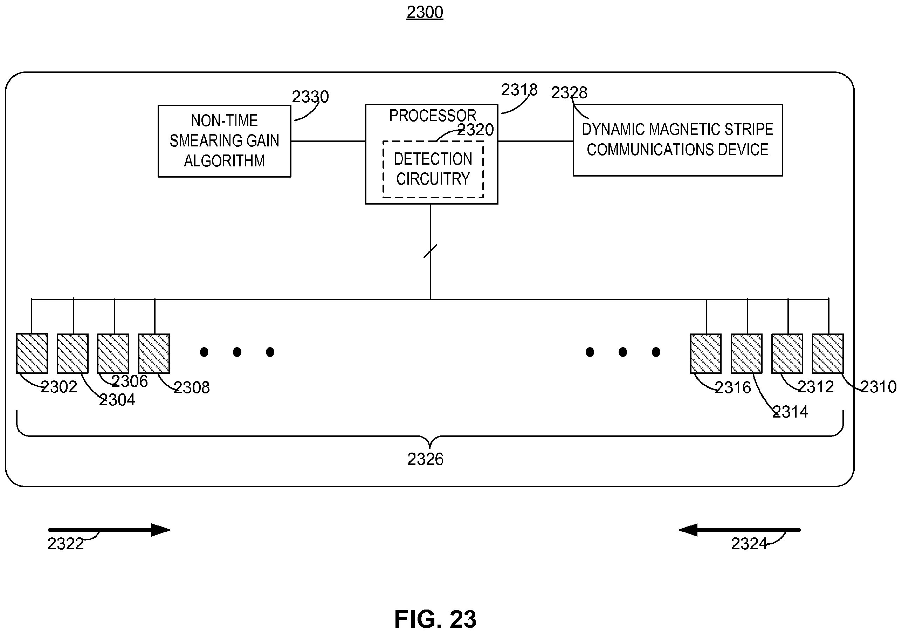

Turning to FIG. 23, a card is shown having an orientation of detectors 2326, whereby one or more detectors 2302-2316 may be, for example, arranged along a length of card 2300. Detectors 2302-2316 may be provided, for example, as conductive pads using, for example, an additive technique, whereby patterns of a conductive element (e.g., copper) may be applied to a PCB substrate according to a patterning mask definition layer. Detectors 2302-2316 may be provided, for example, as conductive pads using, for example, a subtractive technique whereby patterns of a conductive element (e.g., copper) may be removed from a pre-plated PCB substrate according to an etching mask definition layer. Other non-PCB fabrication techniques may be used to implement conductive pads 2302-2316 as may be required by a particular application.

Detection circuitry 2320 of processor 2318, conductive pads 2302-2316, processor 2318, and non-time smearing gain algorithm 2330 may be combined to provide a detection system. Persons skilled in the art will appreciate that any number of conductive pads may be utilized by a processor as capacitive sensing pads. Particularly, a processor may include the functionality to control a detection system to determine when an object is in the proximity of one or more conductive pads via a capacitive sensing technique.

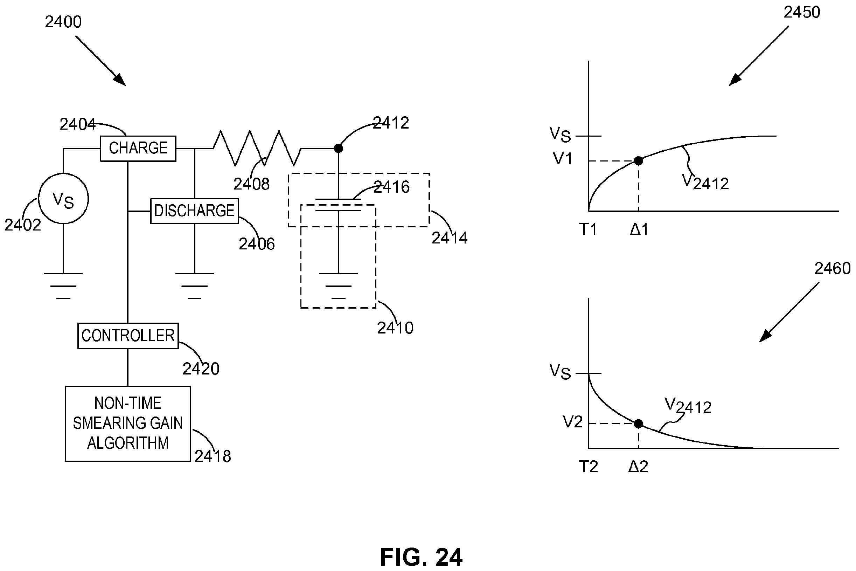

FIG. 24 shows detection circuitry 2400. A conductive pad may be utilized, for example, as a conductor of a capacitive device within a resistor/capacitor (RC) circuit to determine the capacitance of a conductive pad and determine whether the capacitance is below, equal to, or above one or more predetermined thresholds.

A conductive pad may, for example, form a portion of a capacitive element, such that plate 2416 of capacitive element 2414 may be implemented by a conductive pad and the second plate of capacitive element 2414 may be implemented by element 2410. Element 2410 may represent, for example, the device or object whose proximity or contact is sought to be detected.

The capacitance magnitude of capacitive element 2414 may exhibit, for example, an inversely proportional relationship to the distance separation between plate 2416 and device 2410. For example, the capacitance magnitude of capacitive element 2414 may be relatively low when the corresponding distance between plate 2416 and device 2410 may be relatively large. The capacitance magnitude of capacitive element 2414 may be relatively large, for example, when the corresponding distance between plate 2416 and device 2410 is relatively small.

Detection may be accomplished, for example, via circuit 2400 of FIG. 24. Through a sequence of charging and/or discharging events, a capacitance magnitude change for capacitive element 2414 may be monitored over a given period of time. In so doing, for example, the spatial relationship (e.g., the separation distance) between plate 2416 and device 2410 may be approximated.

Charge sequence 2450 may, for example, be optionally invoked, such that charge circuit 2404 may be activated at time T1, while discharge circuit 2406 may remain deactivated. Accordingly, for example, current may flow through resistive component 2408. In doing so, for example, an electrostatic field may be generated that may be associated with capacitive component 2414. During the charge sequence, for example, the voltage at node 2412 may be monitored to determine the amount of time required (e.g., $T_{CHARGE} = \Delta1-T1$) for the voltage at node 2412, $V_{2412}$, to obtain a magnitude that is substantially equal to, below, or above a first threshold voltage (e.g., equal to V1).

Discharge sequence 2460 may, for example, be optionally invoked, such that discharge circuit 2406 may be activated at time T2, while charge circuit 2404 may remain deactivated. During the discharge sequence, for example, the electric field associated with capacitive element 2414 may be allowed to discharge through resistive component 2408 to a reference potential (e.g., ground potential). The voltage at node 2412 may be monitored to determine the amount of time required (e.g., $T_{DISCHARGE} = \Delta2-T2$) for the voltage at node 2412, $V_{2412}$, to obtain a magnitude that is substantially equal to, below, or above a second threshold voltage (e.g., equal to V2).

Once the charge time, $T_{CHARGE}$, and/or discharge time, $T_{DISCHARGE}$, are determined, the charge and/or discharge times may be utilized to calculate a capacitance magnitude that may be exhibited by capacitive element 2414. For example, given that the magnitude of voltage, V1, may be equal to approximately 63% of the magnitude of voltage, $V_S$, then a first relationship may be defined by equation (3) as:

$$T_{CHARGE} \; = \; R_{2408} {}^\star C1, \qquad\qquad (3)$$

where $R_{2408}$ is the resistance magnitude of resistive element 2408 and C1 is proportional to a capacitance magnitude of a capacitive element (e.g., capacitive element 2414).

Similarly, for example, given that the magnitude of voltage, V2, is equal to approximately 37% of the magnitude of voltage, $V_S$, then a second relationship may be determined by equation (4) as:

$$T_{DISCHARGE} \; = \; R_{2408} {}^\star C2, \qquad\qquad (4)$$

where C2 is proportional to a capacitance magnitude of capacitive element 2414. The capacitance magnitudes, $C_1$ or $C_2$, may then be calculated from equations (3) or (4), respectively, and taken by themselves to determine a capacitance magnitude that may be exhibited by capacitive element 2414. Alternatively, for example, capacitance magnitudes, $C_1$ and $C_2$, may be calculated from equations (3) and (4), respectively, and averaged to determine a capacitance magnitude that may be exhibited by capacitive element 2414.

Persons skilled in the art will appreciate that circuits 2404 and/or 2406 may be activated and deactivated by controller 2420. Accordingly, for example, controller 2420 may control when the charge and/or discharge events occur. Persons skilled in the art will further appreciate that controller 2420 may adjust a frequency at which circuits 2404 and 2406 may be activated and/or deactivated, thereby adjusting a sampling rate at which the capacitance magnitudes, $C_1$ and/or $C_2$, may be measured. Accordingly, for example, controller 2420 may implement a detection algorithm (e.g., non-time smearing gain algorithm 2418) to determine a position, velocity and/or an acceleration of an object based on the processing of relative capacitance magnitude variations of a series of pads over time in accordance with such an algorithm.

Turning back to FIG. 23, for example, a series of charge and/or discharge cycles for pads 2302-2316 may be executed by processor 2318 to determine, for example, a relative capacitance magnitude that may be exhibited by each of pads 2302-2316. A series of charge and/or discharge cycles for each of pads 2302-2316 may be executed by processor 2318, for example, in order to obtain a capacitance characteristic for each of pads 2302-2316 over time, thereby determining whether an object (e.g., a read-head housing of a magnetic stripe reader) is within a proximity to card 2300, whether that object is moving with respect to card 2300 and if so, what direction that object is moving and/or whether that object is accelerating with respect to card 2300.

Processor 2318 may, for example, measure the charge time (e.g., $T_{CHARGE}$ of equation (3)) and/or the discharge time (e.g., $T_{DISCHARGE}$ of equation (4)) by counting a number of periods of an oscillation signal (e.g., an oscillation signal generated within processor 2318) that are required to achieve the respective voltage threshold values (e.g., V1 and/or V2 of FIG. 24) for each of pads 2302-2316 over a period of time. Processor 2318 may, for example, implement a filtering/averaging algorithm in accordance with equation (5) to compute a number of periods, Count[n], of an oscillation signal that are required to achieve the respective voltage threshold value for the $n^{th}$ pad of an array of N pads over a period of time.

$$Count[n(t)] = Count[n(t-1)] + New\ Count - (Count[n(t-1)] + 1)/2 \quad (5)$$

where Count[n(t-1)] is the number of periods of an oscillation signal that were required for the $n^{th}$ pad of a pad array having N pads to achieve its respective voltage threshold level during the previous charge and/or discharge cycle and where New Count is the number of periods of an oscillation signal that were required for the $n^{th}$ pad of a pad array having N pads to achieve its respective voltage threshold level during a subsequent charge and/or discharge cycle.

The algorithm of equation (5) may, for example, filter out capacitance detection variations for the $n^{th}$ pad of an N pad array due to noise (e.g., detection sensitivity variation, quantization noise and power supply noise). However, the algorithm of equation (5) may also tend to smear detection results across adjacent time periods by using the previous detection results in a calculation of the current detection results, thereby providing an artificial "lengthening" of each detection pad.

Accordingly, for example, as swipe speeds increase, an alternate algorithm (e.g., non-time smearing algorithm 2330) may be implemented to eliminate the time-smearing effects that may prohibit an accurate detection of the position, velocity and/or acceleration of an object (e.g., a read-head housing of a magnetic stripe reader) that may be in proximity to card 2300. For example, a non-time smearing algorithm in accordance with equation (6) may be used to obtain a more accurate count for specific pads of interest in real time.

$$Count[n(t)] = New\ Count * Gain\ Value, \qquad (6)$$

where New Count is the number of periods of an oscillation signal that were required for the $n^{th}$ pad of a pad array having N pads to achieve its respective voltage threshold level during the current charge and/or discharge cycle and Gain Value is an integer multiplier (e.g., 2, 4, 8 or 16).

By comparing the time-based capacitance characteristic of each pad 2302-2316, as may be approximated by equations (5) or (6), to a threshold capacitance value, a determination may be made, for example, as to when pads 2302-2316 are in a proximity, or touch, relationship with a device whose presence is to be detected. For example, a sequential change (e.g., increase) in the relative capacitance magnitudes of pads 2302-2308, respectively, and/or pads 2316-2310, respectively, may be detected and a determination may be made that a device is moving substantially in direction 2322 relative to card 2300. A sequential change (e.g., increase) in the relative capacitance magnitudes of detectors 2310-2316, respectively, and/or 2308-2302, respectively, may be detected, for example, and a determination may be made that a device is moving substantially in direction 2324 relative to card 2300.

Persons skilled in the art will appreciate that by electrically shorting pairs of detectors together (e.g., pair 2302/2310, pair 2304/2312, pair 2306/2314, etc.) directional vectors 2322 and 2324 become insubstantial. For example, regardless of whether a device is moving substantially in direction 2322 or substantially in direction 2324 relative to card 2300, a determination may nevertheless be made that a device is close to, or touching, card 2300.

Detection circuitry 2320 of processor 2318 may be used in conjunction with, for example, one or more pads 2302-2316 to determine that a device (e.g., a read-head housing of a magnetic stripe reader) is in close proximity, or touching, one or more of pads 2302-2316. Processor 2318 may, for example, utilize non-time smearing gain algorithm 2330 to detect a device when that device is moving at a relatively high rate of speed with respect to card 2300. For example, non-time smearing gain algorithm 2330 may detect a capacitance change in a conductive pad during a time period, without consideration of a capacitance change in that conductive pad during previous time periods, to determine that a device is moving in relation to pads 2302-2316. Once a device is detected, processor 2318 may, for example, communicate with the detected device via dynamic magnetic stripe communications device 2328.

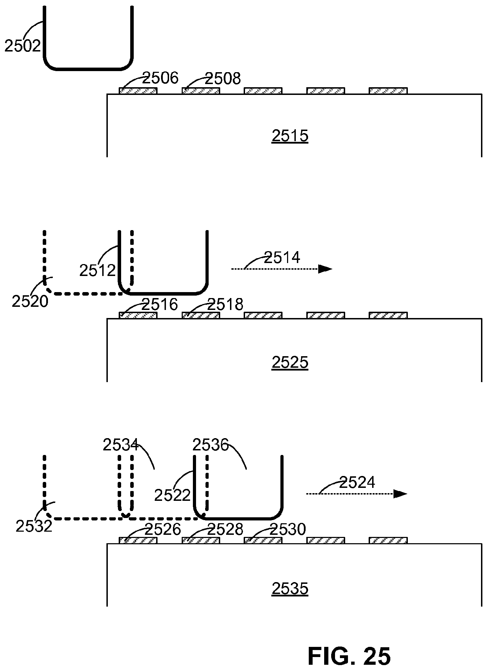

FIG. 25 shows a card that is in proximity to a device (e.g., a read-head of a magnetic stripe reader). Card 2515 may be in proximity to a device such that a distance between conductive pad 2506 and read-head 2502 is less than a distance between conductive pad 2508 and read-head 2502. Accordingly, for example, a relative capacitance magnitude that may be associated with conductive pad 2506 may be, for example, greater than a relative capacitance magnitude that may be associated with conductive pad 2508. In so doing, for example, a processor that may be monitoring the relative capacitance magnitudes of conductive pads 2506 and 2508 may determine that a device is closer to conductive pad 2506 than to conductive pad 2508 by applying a non-time smearing gain algorithm to more accurately detect a capacitance change in pads 2506 and 2508 without applying any capacitance change results that may have been detected for pads 2506 and 2508 in previous time periods.

Card 2525 may be in proximity to a device (e.g., read-head 2512) that may have moved from position 2520 such that a distance between conductive pad 2518 and device 2512 may be slightly greater than a distance between conductive pad 2516 and device 2512. Accordingly, for example, a capacitance magnitude that may be associated with conductive pad 2516 may be, for example, slightly greater than a capacitance magnitude that may be associated with conductive pad 2518. In so doing, for example, a processor that may be monitoring the capacitance magnitudes of conductive pads 2516 and 2518 may determine that a device may be travelling in direction 2514. Further, a processor may determine that a device is slightly closer to conductive pad 2516 than to conductive pad 2518 by applying a non-time smearing gain algorithm to more accurately detect a capacitance change in pads 2516 and 2518 without applying any capacitance change results that may have been detected for pads 2516 and 2518 in previous time periods.

Card 2535 may be in proximity to a device (e.g., read-head 2522) that may have moved from position 2532 to 2534. Accordingly, for example, a capacitance magnitude that may be associated with conductive pad 2528 may be slightly greater than a capacitance magnitude that may be associated with conductive pad 2526. In so doing, for example, a processor that may be monitoring the capacitance magnitudes of conductive pads 2526 and 2528 may determine that a device may be travelling in direction 2524. Further, a processor may determine that a device is slightly closer to conductive pad 2528 than to conductive pad 2526 by applying a non-time smearing gain algorithm to more accurately detect a capacitance change in pads 2526 and 2528 without applying any capacitance change results that may have been detected for pads 2526 and 2528 in previous time periods.

Device 2522 may move from position 2534 to position 2536. Accordingly, for example, a capacitance magnitude that may be associated with conductive pad 2530, for example, may be slightly greater than a capacitance magnitude that may be associated with conductive pad 2528. In so doing, for example, a processor that may be monitoring the capacitance magnitudes of conductive pads 2530 and 2528 may determine that a device may be travelling in direction 2524.

Further, a processor may determine, for example, that a device is first located closest to conductive pad 2526, the device is then located closest to conductive pad 2528, and the device is then located closest to conductive pad 2530 in succession by detecting, for example, that a capacitance magnitude of conductive pad 2526 changes (e.g., increases), followed by a capacitance change (e.g., increase) of conductive pad 2528 by applying a non-time smearing gain algorithm to more accurately detect a capacitance change in pads 2526 and 2528 without applying any capacitance change results that may have been detected for pads 2526 and 2528 in previous time periods, and then followed by a capacitance change (e.g., increase) of conductive pad 2530 by applying a non-time smearing gain algorithm to more accurately detect a capacitance change in pads 2528 and 2530 without applying any capacitance change results that may have been detected for pads 2528 and 2530 in previous time periods. In response to a sequential capacitance change in pads 2526, 2528, and 2530, respectively, a processor may activate one or more electromagnetic field generators to initiate a communications sequence with, for example, read-head 2522.

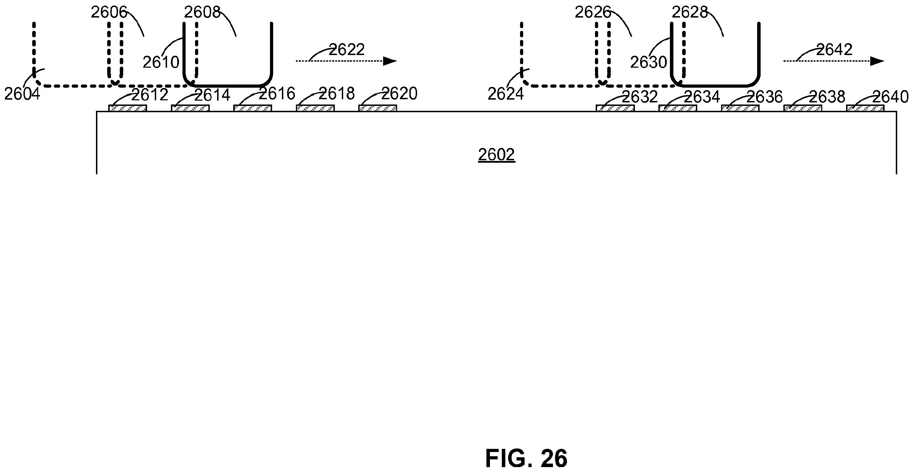

FIG. 26 shows a card that is in proximity to a device (e.g., read-head 2610 of a magnetic stripe reader). Card 2602 may provide a first set of conductive pads (e.g., pads 2612-2620) that may be used by a processor of card 2602, for example, to initially detect a device (e.g., read-head 2610) that may be in proximity to card 2602 or that may be touching card 2602. Further, a processor of card 2602 may detect movement of read-head 2610 in direction 2622 at locations 2604, 2606, and 2608 by applying a non-time smearing gain algorithm to more accurately detect a capacitance change in pads 2614 and 2616, for example, without applying any capacitance change results that may have been detected in previous time periods for pads 2612 and 2614, respectively. In response, a processor of card 2602 may be placed on standby and thereby readied to activate one or more electromagnetic field generators to initiate a communications sequence with, for example, read-head 2610.

Card 2602 may provide a second set of conductive pads (e.g., pads 2632-2640) that may be used, for example, to provide detection verification of a device (e.g., read-head 2630). Accordingly, for example, a presence of a device may be twice detected, for example, so as to confirm that a device was accurately detected and a processor of card 2602 may then commence communications with that device.

Post-detection verification may be useful, for example, to reduce false alarm detections of a device. For example, a processor of card 2602 may verify through post-detection verification that a presence of a device (e.g., a read head of a magnetic stripe reader as opposed to any other type of device) was reliably detected and that a communication sequence with the device may then commence. In so doing, for example, a processor of card 2602 may reduce power consumption by requiring a second detection in succession to a first detection before establishing communications with the device.

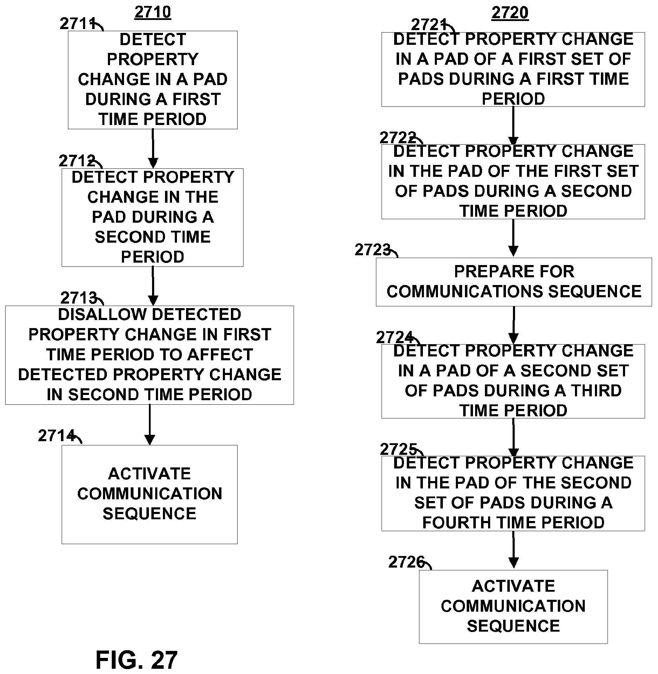

A flow diagram of a detection activity is shown in FIG. 27. Step 2711 of sequence 2710 may initiate a detection operation, for example, where a property change (e.g., an increased capacitance) associated with a conductive pad is detected during a first time period. A property change (e.g., a capacitance increase) may then be detected in the conductive pad during a second time period (e.g., as in step 2712). A relative property change detected in the first time period is not allowed to affect a relative property change detected in the second time period (e.g. as in step 2713) by applying a non-time smearing gain algorithm. In so doing, a detection activity may be sensitive to property changes detected in a conductive pad during a time period that is independent of property changes detected in the conductive pad during one or more previous time periods.

In step 2721 of sequence 2720, a property change (e.g., an increased capacitance) associated with a pad of a first set of pads may be detected during a first time period. A property change (e.g., a capacitance increase) may then be detected in the pad of the first set of pads during a second time period (e.g., as in step 2722), where a relative capacitance change detected in the first time period is not allowed to affect a relative capacitance change detected in the second time period by applying a non-time smearing gain algorithm. In step 2723, a processor may prepare a dynamic magnetic stripe communications device for communication, but may refrain from activating the dynamic magnetic stripe communications device until a verification detection occurs.

In step 2724, a property change (e.g., an increased capacitance) associated with a pad of a second set of pads may be detected during a third time period. A property change (e.g., a capacitance increase) may then be detected in the pad of the second set of pads during a fourth time period (e.g., as in step 2725), where a relative capacitance change detected in the third time period is not allowed to affect a relative capacitance change detected in the fourth time period by applying a non-time smearing gain algorithm. In step 2726, after two detections in succession, a processor may activate a communication sequence (e.g., a dynamic magnetic stripe communications device may communicate a first, a second and/or a third track of magnetic stripe information to a detected read head of a magnetic stripe reader).

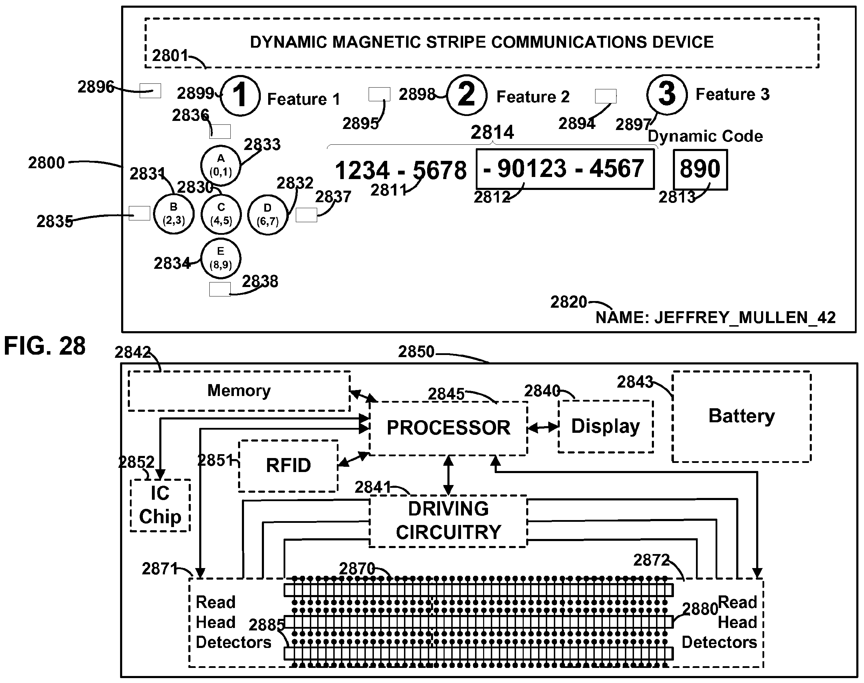

FIG. 28 shows card 2800 that may include, for example, dynamic magnetic stripe communications device 2801, one or more displays (e.g., displays 2812 and 2813), permanent information 2820, one or more buttons (e.g., buttons 2830-2834 and 2897-2899), lights 2835-2838 and 2894-2896, and dynamic number 2814 which may include a permanent portion 2811. Permanent portion 2811 may be, for example, printed, embossed and/or laser etched on card 2800.

Multiple displays may be provided on card 2800 for various purposes. For example, display 2812 may display a dynamic number entirely, and/or partially. Display 2813 may be utilized to display a dynamic code (e.g., a dynamic security code). A display may display logos, barcodes, and/or one or more lines of information (not shown).

Card 2800 may include permanent information 2820 including, for example, information specific to a user (e.g., a user's name and/or username) and/or information specific to a card (e.g., a card issue date and/or a card expiration date).

Card 2800 may include a dynamic magnetic communications device. Such a dynamic magnetic communications device may include a magnetic encoder or an electromagnetic field generator. A magnetic encoder may change the information located on a magnetic medium such that a magnetic stripe reader may read changed magnetic information from the magnetic medium. An electromagnetic field generator may generate electromagnetic fields that directly communicate data to a magnetic stripe reader. Such an electromagnetic field generator may communicate data serially to a read-head of the magnetic stripe reader.

Card 2800 may include one or more buttons, for example, buttons 2830-2834 and 2897-2899. Buttons 2830-2834 and 2897-2899 may be, for example, mechanical buttons, capacitive buttons, light sensors and/or a combination thereof.

Buttons 2897-2899 may be used, for example, to communicate information through dynamic magnetic stripe communications device 2801 indicative of a user's desire to communicate a single track of magnetic stripe information. Persons skilled in the art will appreciate that pressing a button (e.g., button 2899) may cause information to be communicated through device 2801 when an associated read-head detector detects the presence of a read-head of a magnetic stripe reader and/or at a specific frequency.

Each of buttons 2897-2899 may be utilized to communicate (e.g., after the button is pressed and after a read-head detection circuit detects a read-head of a reader) information indicative of a user selection (e.g., to communicate one or more tracks of magnetic stripe data). Multiple buttons may be provided on a card and each button may be associated with a different user selection.

Different third party features may be, for example, associated with different buttons and a particular feature may be selected by pressing an associated button. According to at least one example embodiment, each of buttons 2897-2899 may be associated with, for example, a different third party service provider feature (e.g., an application facilitating provision of a reward) and may be changed by a user at any time.

According to some example embodiments, a user may select a third party feature from a list displayed to the user. For example, the user may scroll through a list of features on a display. A user may scroll through a list using buttons on a card (e.g., buttons 2830-2834). The list of features may be displayed to the user individually, in groups and/or all features may be simultaneously displayed.

According to some example embodiments, a third party feature associated with a button may be changed by a user, for example, on a graphical user interface (GUI) provided on a website, to allow a user to change the third party feature performed when the third party's feature button is selected by a user on the user's card or other device.

According to some example embodiments, a user may select a type of payment on card 2800 via manual input interfaces (e.g., buttons 2830-2834). The manual input interfaces may correspond to displayed options. Selected information may be communicated to a magnetic stripe reader via a dynamic magnetic stripe communications device. Selected information may also be communicated to a device (e.g., a mobile telephonic device) including a capacitive sensor and/or other type of touch sensitive sensor. A display may allow a user to select (e.g., via buttons) options on the display that instruct the card to communicate (e.g., via a dynamic magnetic stripe communications device, RFID and/or exposed IC chip) to use a debit account, credit account, pre-paid account, and/or point account for a payment transaction (not shown).

Lights 2835-2838 and 2894-2896 (e.g., light emitting diodes), may be associated with buttons 2831-2834 and 2897-2899. Each of lights 2835-2838 and 2894-2896 may indicate, for example, when a button is pressed. In a case where a button may activate card 2800 for communications, a light may begin blinking to indicate card 2800 is still active (e.g., for a period of time) while reducing power expenditure. Although not shown, a light may be provided for button 2830.

Architecture 2850 may be utilized with any card (e.g., any card 2800). Architecture 2850 may include, for example, processor 2845, display 2840, driving circuitry 2841, memory 2842, battery 2843, radio frequency identification (RFID) 2851, integrated circuit (IC) chip 2852, electromagnetic field generators 2870, 2880, and 2885, and read-head detectors 2871 and 2872.

Processor 2845 may be any type of processing device, for example, a central processing unit (CPU) and/or a digital signal processor (DSP). Processor 2845 may be, for example, an application specific integrated circuit (ASIC). Processor 2845 may include on-board memory for storing information (e.g., triggering code). Any number of components may communicate to processor 2845 and/or receive communications from processor 2845. For example, one or more displays (e.g., display 2840) may be coupled to processor 2845. Persons skilled in the art will appreciate that components may be placed between particular components and processor 2845. For example, a display driver circuit may be coupled between display 2840 and processor 2845.

Memory 2842 may be coupled to processor 2845. Memory 2842 may store data, for example, data that is unique to a particular card. Memory 2842 may store any type of data. For example, memory 2842 may store discretionary data codes associated with buttons of a card (e.g., card 2800). Discretionary data codes may be recognized by remote servers to effect particular actions. For example, a discretionary data code may be stored in memory 2842 and may be used to cause a third party service feature to be performed by a remote server (e.g., a remote server coupled to a third party service such as a rewards provider). Memory 2842 may store firmware that, for example, includes operational instruction sets.

Architecture 2850 may include any number of reader communication devices. For example, architecture 2850 may include at least one of IC chip 2852, RFID 2851 and a magnetic stripe communications device. IC chip 2852 may be used to communicate information to an IC chip reader (not illustrated). IC chip 2852 may be, for example, an EMV chip. RFID 2851 may be used to communicate information to an RFID reader. RFID 2851 may be, for example, an RFID device. A magnetic stripe communications device may be included to communicate information to a magnetic stripe reader. For example, a magnetic stripe communications device may provide electromagnetic signals to a magnetic stripe reader.

Different electromagnetic signals may be communicated to a magnetic stripe reader to provide different tracks of data. For example, architecture 2850 may include electromagnetic field generators 2870, 2880, and 2885 to communicate separate tracks of information to a magnetic stripe reader. Electromagnetic field generators 2870, 2880, and 2885 may include a coil (e.g., each may include a coil) wrapped around one or more materials (e.g., a soft-magnetic material and/or a non-magnetic material). Each electromagnetic field generator may communicate information, for example, serially to a receiver of a magnetic stripe reader for a particular magnetic stripe track. According to at least one example embodiment, a single coil may communicate multiple tracks of data.

According to some example embodiments, a magnetic stripe communications device may change the information communicated to a magnetic stripe reader at any time. Processor 2845 may, for example, communicate user-specific and card-specific information through RFID 2851, IC chip 2852, and/or electromagnetic field generators 2870, 2880, and 2885 to card readers coupled to remote information processing servers (e.g., purchase authorization servers). Driving circuitry 2841 may be utilized by processor 2845, for example, to control electromagnetic field generators 2870, 2880 and 2885.

Architecture 2850 may include read head detectors 2871 and 2872. Read-head detectors 2871 and 2872 may be configured to sense the presence of a magnetic stripe reader (e.g., a read-head housing of a magnetic stripe reader). Information sensed by the read-head detectors 2871 and 2872 may be communicated to processor 2845 to cause processor 2845 to communicate information serially from electromagnetic field generators 2870, 2880, and 2885 to magnetic stripe track receivers in a read-head housing of a magnetic stripe reader. Read-head sensors may reduce power consumption and increase data security by causing communications only within proximity of the read-head of a card reader.

Architecture 2850 may include any type of detector used to detect and/or determine the proximity of a read-head. For example, read-head detectors 2871 and 2872 may include one or more capacitive sensors, one or more inductive sensors, one or more photoelectric sensors, one or more magnetic sensors, one or more thermal sensors and/or one or more sonic (e.g., ultrasonic) sensors.

Read-head detectors 2871 and 2872 may include a first sensor to detect the proximity of an object and a second sensor to detect a type of the object. For example, a capacitive sensor, which may consume relatively low or no power, may be used to detect a large number of different materials. The materials may include several types of normally encountered materials not normally used in read-heads. For example, non-read-head materials may include materials used in credit card reader construction outside of the read-head and/or human materials (e.g., a user's finger). Accordingly, a capacitive sensor may erroneously signal the detection of a read-head and data communication may be initiated. An inductive sensor, which may consume relatively higher power (e.g., as compared to a capacitive sensor), may not detect at least some of the materials not normally used in read-heads. Accordingly, by using both a capacitive sensor and an inductive sensor, accuracy with respect to read-head detection may be increased.

For example, a capacitive sensor may indiscriminately detect both a read-head and a user's finger, and an inductive sensor may not detect a user's finger. Accordingly, where a capacitive sensor detects an object, processor 2845 may activate an inductive sensor. The inductive sensor may not detect an object. Accordingly, processor 2845 may determine that a read-head is not detected. Read-head detection error may be reduced while maintaining a relatively low power consumption and improving data security. Data security may be improved by reducing erroneous card data transmission.

Sensors may be combined in a variety of ways to improve detection accuracy and data security. For example, read-head detectors 2871 and 2872 may include a capacitive sensor, an inductive sensor and a photoelectric sensor. The capacitive sensor may be used to detect an object, the inductive sensor may be used to detect possible types of the object and the photoelectric sensor may be used to detect the absence of light. The absence of light may, for example, occur where a card is not exposed (e.g., where a card is being swiped through a reader, is in a dip reader and/or in a motorized reader). Accordingly, read-head detection and data security may be improved. Persons skilled in the art in possession of example embodiments will appreciate that different types of sensors may be employed in different combinations and numbers to reduce false read-head detections and improve data security.

Card 2800 may not be a physical card and may be represented virtually on, for example, an electronic device (not shown). Physical elements of card 2800 and architecture 2850 may be incorporated into the electronic device. For example, a mobile phone may display a virtual card and communicate information to a reader using an RFID, EMV chip and/or dynamic magnetic communications device.

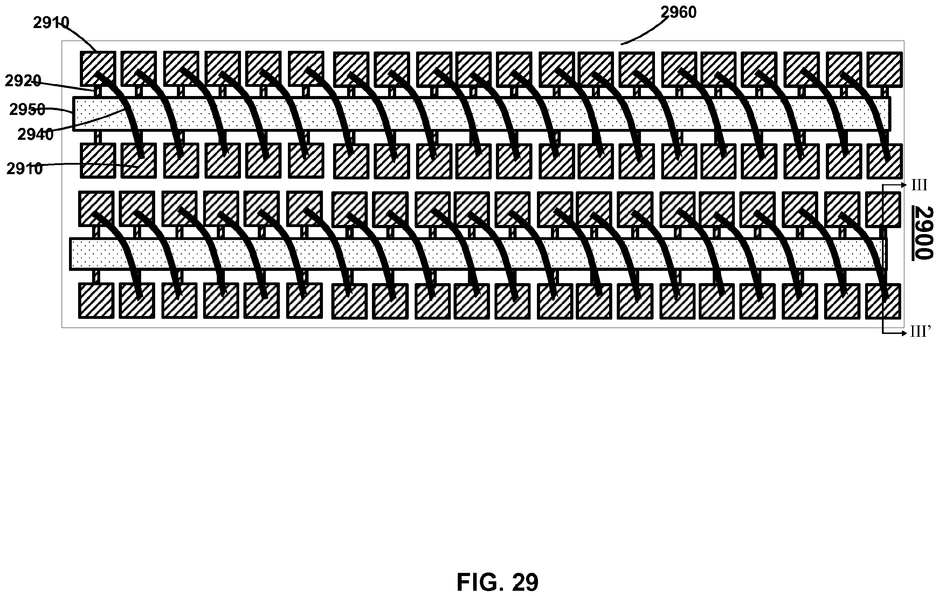

FIG. 29 shows a plan view of electromagnetic field generators 2900 that may be included in a dynamic magnetic stripe communication device constructed in accordance with the principles of the present invention. Referring to FIG. 29, an electromagnetic field generator may include, for example, bonding pads 2910, connection pads 2920, bonding wires 2940, material 2950 (e.g., a core material) and/or substrate material 2960.

Bonding pads 2910 of electromagnetic field generator 2900 may be on a substrate material 2960 in a plurality of rows and columns, and aligned with respect to each other. Connection pads 2920 may connect (e.g., electrically connect), for example, a bonding pad 2910 of one row with the nearest bonding pad 2910 of a different row (e.g., in a same column). Bonding wires 2940 may connect (e.g., electrically connect), for example, a bonding pad 2910 of one row with a nearest bonding pad 2910 in a different row and column (e.g., diagonally connect bonding pads in different columns in one direction). The bonding pads 2910, connection pads 2920 and bonding wires 2940 may be connected in the form of an eccentric coil.

Material 2950 may be between connection pads 2920 and bonding wires 2940 (e.g., within the eccentric coil). Material 2950 may be centered on connection pads 2920 and/or may be offset from center. Bonding pads 2910, connection pads 2920, bonding wire 2940 and material 2950 may be on substrate material 2960 (e.g., a flexible printed circuit board). According to at least one example embodiment, no material 2950 and/or substrate material 2960 may be included.

According to at least one example embodiment, bonding pads 2910 of a single electromagnetic field generator may be in three or more rows and a plurality of columns, and aligned with respect to each other (not shown). Connection pads 2920 may connect, for example, each bonding pad 2910 in a column (e.g., 3 or more bonding pads). Bonding wires 2940 may connect, for example, an outer bonding pad 2910 of an outer row with an outer bonding pad 2910 of a different outer row. The bonding pads 2910 connected by a bonding wire 2940 may be, for example, in different columns (e.g., bonding wire 2940 may diagonally connect bonding pads). The bonding pads 2910, connection pads 2920 and bonding wires 2940 may be connected in the form of a wide eccentric coil. A width of the eccentric coil may vary, for example, based on a number of bonding pads in a column.

Material 2950 may be between connection pads 2920 and bonding wires 2940 (e.g., within the wide eccentric coil) and/or may not be between connection pads 2920 and bonding wires 2940 (e.g., outside the wide eccentric coil). Material 2950 may be centered on connection pads 2920 and/or may be offset from center. According to at least one example embodiment, a plurality of materials 2950 may be between connection pads 2920 and bonding wires 2940 (not shown).

FIG. 29 illustrates 40 bonding pads 2910, 20 connection pads 2920, 19 bonding wires 2940 and a single material 2950 per electromagnetic field generator. However, example embodiments are not so limited. The number of bonding pads 2910, connection pads 2920, bonding wires 2940 and materials 2950 may vary according to, for example, a desired electromagnetic field. FIG. 29 illustrates 2 electromagnetic field generators. However, example embodiments are not so limited. One or more electromagnetic field generators may be included. For example, three electromagnetic field generators may be included to correspond to magnetic stripe track data of a card. As another example, a card may include portions of a magnetic stripe and multiple electromagnetic field generators of varying size (e.g., different numbers and/or sizes of bonding pads 2910, connection pads 2920 and/or bonding wires). As yet another example, the two electromagnetic field generators of FIG. 29 may be connected (e.g., by one or more bonding wires).

Bonding pads 2910 and connection pads 2920 may include a conductive material. For example, bonding pads 2910 and/or connection pads 2920 may include aluminum, nickel, gold, copper, silicon, palladium silver, palladium gold, platinum, platinum silver, platinum gold, tin, kovar (e.g., nickel-cobalt ferrous alloy), stainless steel, iron, ceramic, brass, conductive polymer, zinc and/or carbide. The conductive material of a bonding pad 2910 and/or a connection pad 2920 may be a solder, a flexible printed circuit board trace and/or the like.

Bonding pads 2910 and/or connection pads 2920 may be deposited, for example, by thin or thick film deposition (e.g., plating, electroplating, physical vapor deposition (evaporation, sputtering and/or reactive PVD), chemical vapor deposition (CVD), plasma enhanced CVD, low pressure CVD, atmosphere pressure CVD, metal organic CVD, spin coating, conductive ink printing and/or the like. Bonding pads 2910 may be, for example, magnetic, paramagnetic, solid, perforated, conformal, non-conformal and/or the like. Bonding pads 2910 may each include a same or different material. Connection pads 2920 may each include a same or different material. A material of a bonding pad 2910 may be the same or different from a material of a connection pad 2920. Each of bonding pads 2910 and connection pads 2920 may be multi-layer pads including one or more materials.

Bonding wires 2940 may include a conductive material. For example, bonding wires 2940 may include aluminum, nickel, gold, copper, silicon, palladium silver, palladium gold, platinum, platinum silver, platinum gold, tin, kovar (e.g., nickel-cobalt ferrous alloy), stainless steel, iron, ceramic, brass, conductive polymer, zinc and/or carbide. The conductive material of a bonding wire 2940 may be coated (e.g., with an insulating material to reduce shorting and/or a conductive material). The material of a bonding wire 2940 may be, for example, magnetic, paramagnetic, solid, perforated, stranded, braided, and/or the like.

Bonding wires 2940 may be wire bonded to bonding pads 2910. Wire bonding may be performed using any wire bonding method. For example, wire bonding may include hand bonding, automated bonding, ball bonding, wedge bonding, stitch bonding, hybrid bonding, a combination of bonding methods and/or the like. Bonding wires 2940 may each include a same or different material. A material of a bonding wire 2940 may be the same or different from a material of a bonding pad 2910 and/or connection pad 2920. Each of bonding wires 2940 may include one or more materials and/or layers.

Material 2950 may include, for example, a soft magnetic material. For example, material 2950 may include an iron-nickel alloy, iron-silicon alloys, iron and/or the like). Material 2950 may be coated (e.g., with an insulating material and/or a conductive material). The coating may be deposited, for example, by thin or thick film deposition (e.g., plating, electroplating, physical vapor deposition (evaporation, sputtering and/or reactive PVD), chemical vapor deposition (CVD), plasma enhanced CVD, low pressure CVD, atmosphere pressure CVD, metal organic CVD, spin coating and/or the like. As one non-limiting example, the coating of material 2950 may be an ultra-thin coating with a thickness of, for example, about 0.00025 inches to about 0.00050 inches, and may be deposited by vapor deposition.

A material of material 2950 may be the same or different from a material of a bonding pad 2910, bonding wire 2940 and/or connection pad 2920. An electromagnetic field generator may include any number of materials 2950. Each material 2950 may include one or more materials and/or layers.

An electromagnetic field generator may include substrate material 2960. For example, substrate material 2960 may be a printed circuit board including biaxially-oriented polyethylene terephthalate (BoPET such as Mylar™ polyester film) and conductive circuit traces. According to at least one example embodiment, bonding pads 2910 and connection pads 2920 may be circuit traces of a printed circuit board. The printed circuit board may be, for example, a flexible printed circuit board.

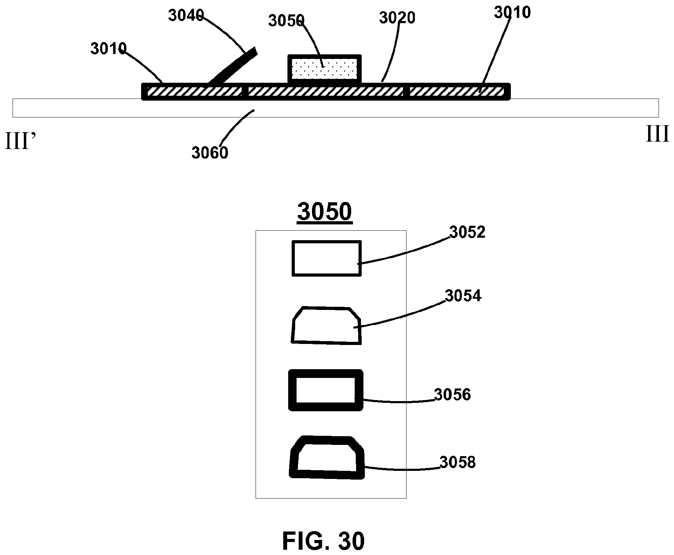

FIG. 30 shows a cross-sectional view of an electromagnetic field generator taken along line III-III' of FIG. 29. Referring to FIG. 30, an electromagnetic field generator may include bonding pads 3010, connection pad 3020, bonding wire 3040, material 3050 and substrate material 3060. According to example embodiments, connection pad 3020 and/or bonding pads 3010 may be between material 3050 and substrate material 3060. According to at least one example embodiment, material 3050 may be between connection pad 3020 and/or bonding pads 3010, and substrate material 3060 (not shown).

An electromagnetic field generator may be encapsulated. FIG. 30 may illustrate a case where an opaque encapsulant is included and bonding wire 3040 is only partially visible in a cross-sectional view. According to some example embodiments, a transparent encapsulant or no encapsulant may be included in an electromagnetic field generator and all of one or more bonding wires may be visible in cross-section (not shown).

Material 3050 may be about rectangular (e.g., according to 3052) and may be coated (e.g., according to 3056). Material 3050 may be shaped to improve an electromagnetic field characteristic. Material 3050 may be beveled, for example, chamfered and/or radius (e.g., according to 3054). A shaped material 3050 may be coated (e.g., according to 3058). A shape of material 3050 is not limited and, for example, may be circular, multi-faceted (e.g., hexagonal), triangular, square, rectangular, trapezoidal, cylindrical and/or the like.

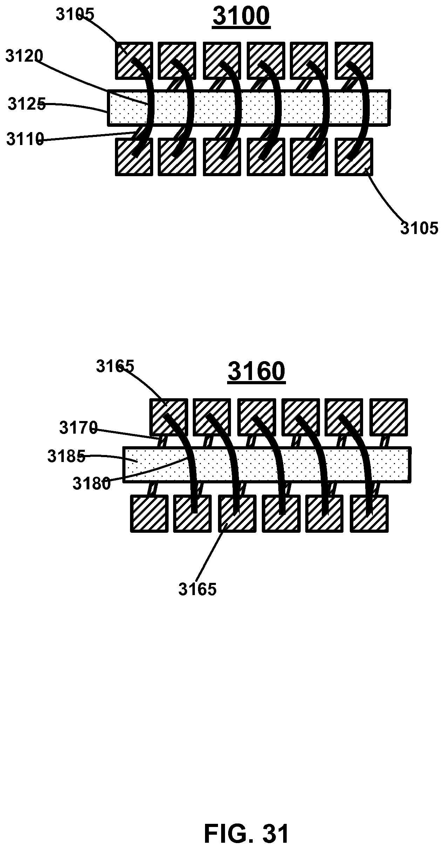

FIG. 31 shows plan views of electromagnetic field generators 3100 and 3160 that may be included in dynamic magnetic stripe communication devices constructed in accordance with the principles of the present invention. Referring to FIG. 31, electromagnetic field generator 3100 may include bonding pads 3105, connection pads 3110, bonding wires 3120 and/or material 3125. Bonding pads 3105 may be, for example, aligned in a plurality of rows and a plurality of columns. Bonding pads 3105 in a same column may be connected by a bonding wire 3120. Bonding pads 3105 in different rows and different columns (e.g., adjacent columns) may be connected by a connection pad 3110. For example, connection pads 3110 may diagonally connect bonding pads 3105. Bonding pads 3105, connection pads 3110 and bonding wires 3120 may be connected in the form of an eccentric coil.

Material 3125 may be, for example, between connection pads 3110 and bonding wires 3120 (e.g., within the eccentric coil), and/or may not be between connection pads 3110 and bonding wires 3120 (e.g., outside the eccentric coil). Material 3125 may be centered on connection pads 3110 and/or may be offset from center. According to at least one example embodiment, a plurality of materials 3125 may be included (not shown). Bonding pads 3105, connection pads 3110, bonding wires 3120 and material 3125 may be on a substrate material, for example, a flexible printed circuit board (not shown).

Electromagnetic field generator 3160 may include bonding pads 3165, connection pads 3170, bonding wires 3180 and/or material 3185. Bonding pads 3165 may be, for example, in a plurality of rows. Bonding pads 3165 in one row may be offset with respect to bonding pads 3165 in a different row. For example, bonding pads 3165 in a first row may be aligned to spaces between bonding pads 3165 in second row.

Bonding wires 3180 and connection pads 3170 may alternate along a row direction to connect bonding pads 3165 in a zigzag pattern. For example, connection pads 3170 may be in parallel and may each diagonally connect a bonding pad 3165 of one row to the nearest bonding pad 3165 of a different row in a first direction. Each bonding wire 3180 may be between, and not in parallel with, a pair of connection pads 3170, and may diagonally connect bonding pads 3165 that are not connected by connection pads 3170 (e.g., in a second direction). Bonding pads 3165, connection pads 3170 and bonding wires 3180 may be connected in the form of an eccentric coil.

Material 3185 may be, for example, between connection pads 3170 and bonding wires 3180 (e.g., within the eccentric coil), and/or may not be between connection pads 3170 and bonding wires 3180 (e.g., outside the eccentric coil). Material 3185 may be centered on connection pads 3170 and/or may be offset from center. According to at least one example embodiment, a plurality of materials 3185 may be included (not shown). Bonding pads 3165, connection pads 3170, bonding wires 3180 and material 3185 may be on a substrate material, for example, a flexible printed circuit board (not shown).

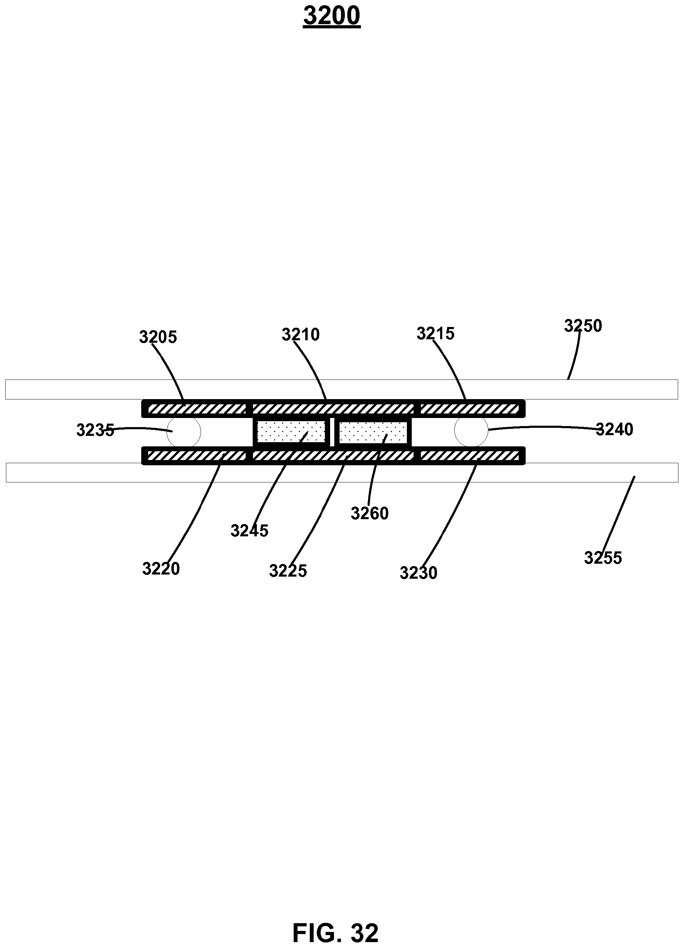

FIG. 32 shows a cross-sectional view of an electromagnetic field generator 3200 that may be included in a dynamic magnetic stripe communication device constructed in accordance with the principles of the present invention. Referring to FIG. 32, electromagnetic field generator 3200 may include bonding pads 3205, 3215, 3220 and 3230, connection pads 3210 and 3225, substrate materials 3250 and 3255, core materials 3245 and 3260, and connection materials 3235 and 3240.

Bonding pads 3205 and 3215 may be connected by connection pad 3210 on a substrate material 3250. Bonding pads 3220 and 3230 may be connected by connection pad 3225 on a substrate material 3255. Connection material 3235 may connect bonding pad 3205 on substrate material 3250 to bonding pad 3220 on substrate material 3255. Connection material 3240 may connect bonding pad 3215 on substrate material 3250 to bonding pad 3230 on substrate material 3255. Bonding pads 3205, 3215, 3220 and 3230, connection pads 3210 and 3225, and connection materials 3235 and 3240 may be connected as at least a part of an eccentric coil.

Core materials 3245 and 3260 may be between connection materials 3235 and 3240. According to at least one example embodiment, a lesser or greater number of core materials may be included in electromagnetic field generator 3200. For example, no core materials may be present, one core material may be present, and/or 3 or more core materials may be present. Core material 3245 may be a same or different material from core material 3260. Each of core materials 3245 and 3260 may be shaped and/or coated (not shown). According to example embodiments, core materials 3245 and 3260 may be a same or different shape from each other.

According to example embodiments, one or both of core materials 3245 and 3260 may be coated, or neither of core materials 3245 and 3260 may be coated. Core materials 3245 and 3260 may be centered on connection pads 3210 and 3225 and/or may be offset from center. Core materials 3245 and 3260 may be multilayered and/or stacked (not shown). According to at least one example embodiment, one or more of core materials 3245 and 3260 may be between one of substrate materials 3250 and 3255, and both of connection pads 3210 and 3225 (not shown).

Substrate materials 3250 and 3255 may be, for example, printed circuit boards (e.g., flexible printed circuit boards). According to some example embodiments, bonding pads 3205, 3215, 3220 and 3230, and connection pads 3210 and 3225, may be conductive traces (e.g., copper patterns) on printed circuit boards. The conductive traces may be deposited, etched from a material, drawn, silkscreened, pad-printed, sprayed and/or the like. As one non-limiting example, bonding pads 3205, 3215, 3220 and 3230, and/or connection pads 3210 and 3225, may include conductive polymer ink on substrate materials 3250 and 3255. The conductive ink may be applied using pad-print equipment and precision clichés patterns that may be multiplexed (e.g., ganged) onto sheets. The sheets may be excised by, for example, laser scribing, mechanical scribing, break-apart equipment and/or the like.

Substrate materials 3250 and 3255 may include polyvinyl chloride (PVC), polytetrafluoroethylene (PTFE), polyester, biaxially-oriented polyethylene terephthalate (BoPET; e.g., Mylar™ polyester film)), a poly-carbonate, a conductive material with a non-conductive coating and/or a magnetic material. For example, substrate material 3250 may include PVC, PTFE, polyester, and/or a poly-carbonate, and substrate material 3250 may include BoPET, a conductive material with a non-conductive coating and/or a magnetic material. An adhesive may be used to physically and/or electrically connect substrate material 3250 to substrate material 3255 (e.g., an anisotropic conductive adhesive (ACA)).

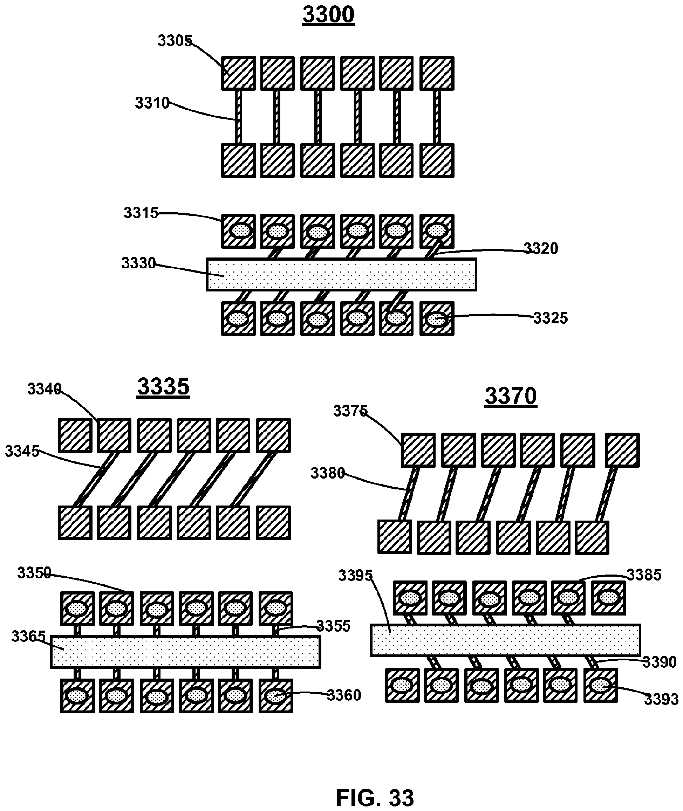

FIG. 33 shows plan views of electromagnetic field generators 3300, 3335 and 3370 that may be included in a dynamic magnetic stripe communication devices constructed in accordance with the principles of the present invention. Each plan view may include two portions that may be, for example, superimposed and connected in the form of an eccentric coil. Referring to FIG. 33, electromagnetic field generator 3300 may include bonding pads 3305 and 3315, connection pads 3310 and 3320, core material 3330 and connection materials 3325.

Bonding pads 3305 may be aligned in a plurality of rows and a plurality of columns in a first portion of electromagnetic field generator 3300. Bonding pads 3305 in a same column may be connected by a connection pad 3310. Bonding pads 3315 may be aligned in a plurality of rows and a plurality of columns in a second portion of electromagnetic field generator 3300. Bonding pads 3315 in different rows and different columns (e.g., adjacent columns) may be connected by a connection pad 3320. For example, connection pads 3320 may diagonally connect bonding pads 3315. Connection materials 3325 may connect the first and second portions of electromagnetic field generator 3300. For example, connection materials 3325 may connect bonding pads 3305 to bonding pads 3315. Bonding pads 3305 and 3315, connection pads 3310 and 3320, and connection materials 3325 may be connected in the form of an eccentric coil.

Core material 3330 may be, for example, between connection pads 3310 and connection pads 3320 (e.g., within the eccentric coil), and/or may not be between connection pads 3310 and connection pads 3320 (e.g., outside the eccentric coil). Core material 3330 may be centered on connection pads 3310 and 3320, and/or may be offset from center. According to at least one example embodiment, a plurality of core materials 3330 may be included (not shown). Bonding pads 3305 and connection pads 3310 may be on a substrate material, for example, a flexible printed circuit board (not shown). Bonding pads 3315 and connection pads 3320 may be on a substrate material, for example, a different flexible printed circuit board (not shown).

Electromagnetic field generator 3335 may include bonding pads 3340 and 3350, connection pads 3345 and 3355, core material 3365 and connection materials 3360. Bonding pads 3350 may be aligned in a plurality of rows and a plurality of columns in a first portion of electromagnetic field generator 3335. Bonding pads 3350 in a same column may be connected by a connection pad 3355. Bonding pads 3340 may be aligned in a plurality of rows and a plurality of columns in a second portion of electromagnetic field generator 3335. Bonding pads 3340 in different rows and different columns (e.g., adjacent columns) may be connected by a connection pad 3345. For example, connection pads 3345 may diagonally connect bonding pads 3340. Connection materials 3360 may connect the first and second portions of electromagnetic field generator 3335. For example, connection materials 3360 may connect bonding pads 3350 to bonding pads 3340. Bonding pads 3340 and 3350, connection pads 3345 and 3355, and connection materials 3360 may be connected in the form of an eccentric coil.

Core material 3365 may be, for example, between connection pads 3345 and connection pads 3350 (e.g., within the eccentric coil), and/or may not be between connection pads 3345 and connection pads 3350 (e.g., outside the eccentric coil). Core material 3365 may be centered on connection pads 3345 and 3350, and/or may be offset from center. According to at least one example embodiment, a plurality of core materials 3365 may be included (not shown). Bonding pads 3340 and connection pads 3345 may be on a substrate material, for example, a first flexible printed circuit board (not shown). Bonding pads 3350 and connection pads 3355 may be on a substrate material, for example, a second flexible printed circuit board (not shown).

Electromagnetic field generator 3370 may include bonding pads 3375 and 3385, connection pads 3380 and 3390, connection materials 3393 and/or core material 3395. Bonding pads 3375 may be, for example, in a plurality of rows in a first portion of electromagnetic field generator 3370. Bonding pads 3375 in one row may be offset with respect to bonding pads 3375 in a different row. For example, bonding pads 3375 in a first row may be aligned to spaces between bonding pads 3375 in second row. Connection pads 3380 may be in parallel and may each diagonally connect a bonding pad 3375 of one row to the nearest bonding pad 3375 of a different row in a first direction.

Bonding pads 3385 may be, for example, in a plurality of rows in a second portion of electromagnetic field generator 3370. Bonding pads 3385 in one row may be offset with respect to bonding pads 3385 in a different row. For example, bonding pads 3385 in a first row may be aligned to spaces between bonding pads 3385 in a second row. Connection pads 3390 may be in parallel and may each diagonally connect a bonding pad 3385 of one row to the nearest bonding pad 3385 of a different row in a second direction (e.g., a second direction crossing the first direction). Connection materials 3393 may connect the first and second portions of electromagnetic field generator 3370. For example, connection materials 3393 may connect bonding pads 3375 to bonding pads 3385. Bonding pads 3375 and 3385, connection pads 3380 and 3390, and connection materials 3393 may be connected in the form of an eccentric coil.

Material 3395 may be, for example, between connection pads 3380 and 3390 (e.g., within the eccentric coil), and/or may not be between connection pads 3380 and 3390 (e.g., outside the eccentric coil). Material 3395 may be centered on connection pads 3380 and 3390, and/or may be offset from center. According to at least one example embodiment, a plurality of materials 3395 may be included (not shown). Bonding pads 3375 and connection pads 3380 may be on a substrate material, for example, a first flexible printed circuit board (not shown). Bonding pads 3385 and connection pads 3390 may be on a substrate material, for example, a second flexible printed circuit board (not shown).

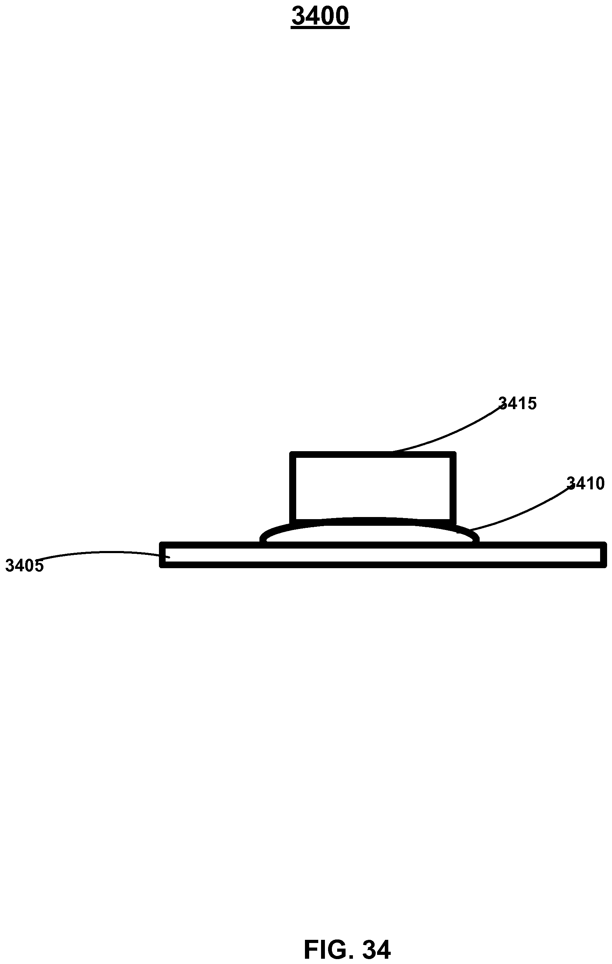

FIG. 34 shows a partial cross-section of an electromagnetic field generator constructed in accordance with the principles of the present invention. Referring to FIG. 34, an electromagnetic field generator may include core material 3415, connection material 3410 and substrate material 3405 (e.g., a flexible printed circuit board). Connection material 3410 may connect core material 3415 to substrate material 3405. For example, connection material 3410 may be an adhesive. Connection material 3410 may occupy spaces between, for example, connection pads on a substrate.

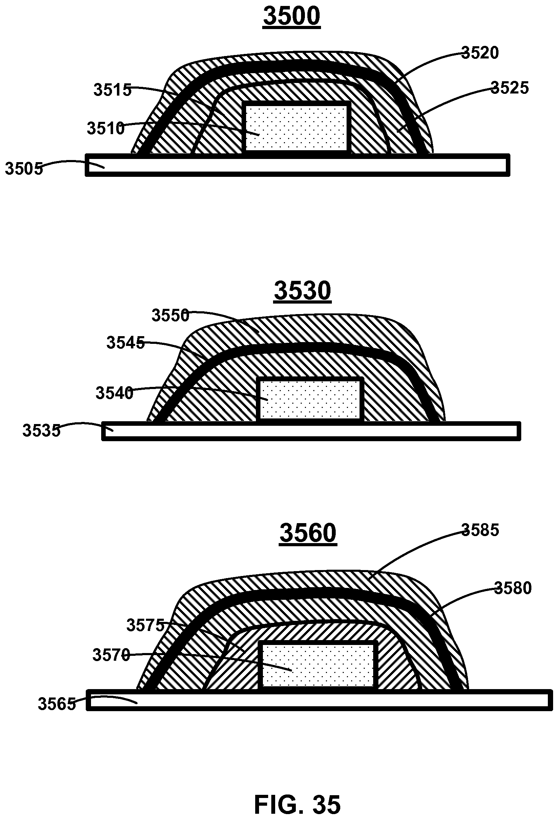

FIG. 35 shows partial cross-sections of electromagnetic field generators 3500, 3530 and 3560 constructed in accordance with the principles of the present invention. Referring to FIG. 35, an electromagnetic field generator 3500 may include substrate material 3505, core material 3510, bonding wire 3520, and encapsulant layers 3515 and 3525. Bonding wire 3520 may be, for example, connected to substrate material 3505 in a plurality of locations (e.g., bonding pads of substrate material 3505). Core material 3510 may be, for example, between bonding wire 3520 and substrate material 3505 (e.g., may be on connection pads of substrate material 3505).

Encapsulant layers 3515 and 3525 may insulate and support the structure of electromagnetic field generator 3500. A material of encapsulant layer 3515 may be the same as a material of encapsulant layer 3525. Encapsulant layer 3515 may be deposited prior to bonding of bonding wire 3520 to substrate material 3505. For example, the material of encapsulant layer 3515 may be deposited as a glob top material in a space between connection pads of electromagnetic field generator 3500. The glob top may be forced into the structures of electromagnetic field generator 3500 using, for example, manual or robotic articulation. Encapsulant layer 3525 may be deposited, for example, after bonding.

Electromagnetic field generator 3530 may include substrate material 3535, core material 3540, bonding wire 3545, and encapsulant layer 3550. Bonding wire 3545 may be, for example, connected to substrate material 3535 in a plurality of locations. Core material 3540 may be, for example, between bonding wire 3545 and substrate material 3535. Encapsulant layer 3550 may insulate and support the structure of electromagnetic field generator 3530. Encapsulant layer 3550 may be deposited after the bonding of bonding wire 3545 to substrate material 3535.

Electromagnetic field generator 3560 may include substrate material 3565, core material 3570, bonding wire 3580, and encapsulant layers 3575 and 3585. Bonding wire 3580 may be, for example, connected to substrate material 3565 in a plurality of locations. Core material 3570 may be, for example, between bonding wire 3580 and substrate material 3565 (e.g., may be on connection pads of substrate material 3565).

Encapsulant layers 3575 and 3585 may insulate and support the structure of electromagnetic field generator 3560. A material of encapsulant layer 3575 may be different from a material of encapsulant layer 3585. Encapsulant layer 3575 may be deposited prior to bonding of bonding wire 3520 to substrate material 3505. Encapsulant layer 3525 may be deposited, for example, after bonding.

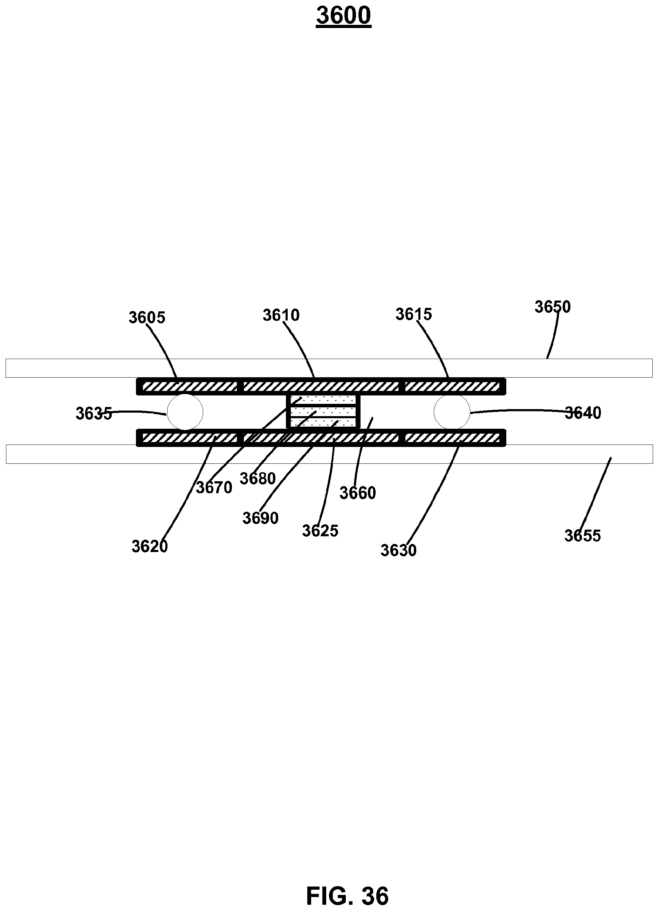

FIG. 36 shows a cross-sectional view of an electromagnetic field generator 3600 that may be included in a dynamic magnetic stripe communication device constructed in accordance with the principles of the present invention. Referring to FIG. 36, electromagnetic field generator 3600 may include bonding pads 3605, 3615, 3620 and 3630, connection pads 3610 and 3625, substrate materials 3650 and 3655, connection materials 3635 and 3640, and core materials 3670, 3680 and 3690.

Bonding pads 3605 and 3615 may be connected by connection pad 3610 on a substrate material 3650. Bonding pads 3620 and 3630 may be connected by connection pad 3625 on a substrate material 3655. Connection material 3635 may connect bonding pad 3605 on substrate material 3650 to bonding pad 3620 on substrate material 3655. Connection material 3640 may connect bonding pad 3615 on substrate material 3650 to bonding pad 3630 on substrate material 3655. Bonding pads 3605, 3615, 3620 and 3630, connection pads 3610 and 3625, and connection materials 3635 and 3640 may be connected as at least a part of an eccentric coil.

Core materials 3670, 3680 and 3690 may be stacked between connection materials 3635 and 3640. According to at least one example embodiment, a lesser or greater number of core materials may be included in electromagnetic field generator 3600. Core materials 3670, 3680 and 3690 may be the same or different from each other. Each of core materials 3670, 3680 and 3690 may be shaped and/or coated (not shown). According to example embodiments, core materials 3670, 3680 and 3690 may be a same or different shape from each other.

Core materials 3670, 3680 and 3690 may be centered on connection pads 3610 and 3625 and/or may be offset from center. Core materials 3670, 3680 and 3690 may be multilayered. Core materials may be, for example, next to stacked core materials 3670, 3680 and 3690 (not shown). According to at least one example embodiment, one or more of core materials 3670, 3680 and 3690 may be between one of substrate materials 3650 and 3655, and both of connection pads 3610 and 3625 (not shown).

Substrate materials 3650 and 3655 may be, for example, printed circuit boards (e.g., flexible printed circuit boards). According to some example embodiments, bonding pads 3605, 3615, 3620 and 3630, and connection pads 3610 and 3625, may be conductive traces (e.g., copper patterns) on printed circuit boards.

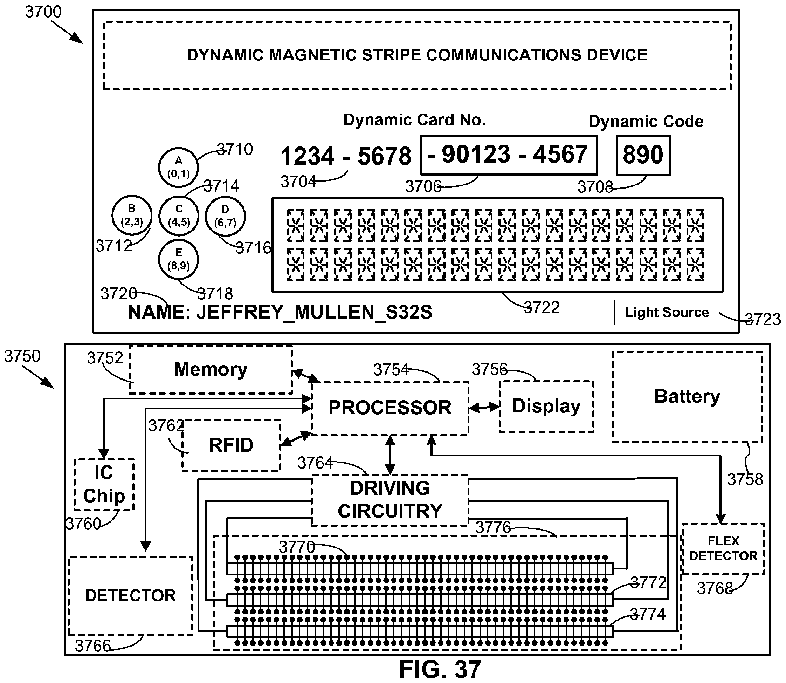

FIG. 37 shows card 3700. Referring to FIG. 37, a card 3700 may include, for example, a dynamic number that may be entirely, or partially, displayed using a display (e.g., display 3706). A dynamic number may include a permanent portion such as, for example, permanent portion 3704 and a dynamic portion such as, for example, a number displayed by display 3706. Card 3700 may include a dynamic number having permanent portion 3704 and permanent portion 3704 may be incorporated on card 3700 so as to be visible to an observer of card 3700. For example, labeling techniques, such as printing, embossing, laser etching, etc., may be utilized to visibly implement permanent portion 3704.

Card 3700 may include a second dynamic number that may be entirely, or partially, displayed via a second display (e.g., display 3708). Display 3708 may be utilized, for example, to display a dynamic code such as a dynamic security code. Card 3700 may also include third display 3722 that may be used to display, for example, graphical information, such as logos and barcodes. Third display 3722 may also be utilized to display multiple rows and/or columns of textual and/or graphical information.

Persons skilled in the art will appreciate that any one or more of displays 3706, 3708, and/or 3722 may be implemented as a bi-stable display. For example, information provided on displays 3706, 3708, and/or 3722 may be stable in at least two different states (e.g., a powered-on state and a powered-off state). Any one or more of displays 3706, 3708, and/or 3722 may be implemented as a non-bi-stable display. For example, the display is stable in response to operational power that is applied to the non-bi-stable display. Other display types, such as LCD or electro-chromic, may be provided as well.

Other permanent information, such as permanent information 3720, may be included within card 3700, which may include user specific information, such as the cardholder's name or username. Permanent information 3720 may, for example, include information that is specific to card 3700 (e.g., a card issue date and/or a card expiration date). Information 3720 may represent, for example, information that includes information that is both specific to the cardholder, as well as information that is specific to card 3700.

Card 3700 may accept user input data via any one or more data input devices, such as buttons 3710-3718. Buttons 3710-3718 may be included to accept data entry through, for example, mechanical distortion, contact, and/or proximity. Buttons 3710-3718 may be responsive to, for example, induced changes and/or deviations in light intensity, pressure magnitude, or electric and/or magnetic field strength. Such information exchange may then be determined and processed by a processor of card 3700 as data input.

Card 3700 may be flexible. Card 3700 may, for example, contain hardware and/or software (e.g., flex code stored in memory 3752) that when executed by a processor of card 3700 may detect when card 3700 is being flexed. Flex code may be, for example, processor executable applications and/or may be one or more application specific integrated circuits, that may detect a change in operation of card 3700 based on the flexed condition of card 3700 and may alter functions of card 3700 based on the detected change in operation.

According to at least one example embodiment, a processor of card 3700 may receive a signal from a distortion detection element indicating an amount of flexure of card 3700. A distortion detection element may be, for example, a microelectricalmechanical system (MEMS), such as a MEMS capacitor. A degree of flexure may be determined according to a signal from the MEMS (e.g., a signal representing a capacitance of the MEMS capacitor). Light Source 3723 may provide an indication to a user of the level of flexure of card 3700 based on the MEMS signal. For example, light source 3723 may be a multicolored light emitting diode (LED) emitting light during flexure of card 3700. A color of light source 3723 may indicate whether a degree of flexure may result in damage to card 3700 (e.g., green for acceptable flexure, yellow for borderline flexure and red for potentially damaging flexure).

FIG. 37 shows architecture 3750, which may include one or more processors (e.g., processor 3754 which may be a plurality of stacked processors). Processor 3754 may be configured to utilize external memory 3752, internal memory of processor 3754, or a combination of external memory 3752 and internal memory for dynamically storing information, such as executable machine language (e.g., flex code), related dynamic machine data, and user input data values. Processor 3754 may, for example, execute code contained within memory 3752 to detect when a card (e.g., card 3700 of FIG. 37) is being flexed. The executed code may, for example, change the operation of a card (e.g., card 3700 of FIG. 37) based on the detected change in operation and/or indicate a flexure state to a user (e.g., light source 3723 of FIG. 37).

Processor 3754 may be a single die, or a combination of two or more die stacked on top of one another. A die may be a thin die attached to a thin and flexible substrate and/or to another die. For example, stacked dies may be flexibly adhered to a mechanical carrier (e.g., a flexible printed circuit board (PCB)), and to each other, using flexible, non-anaerobic, low ionic adhesive. A low ionic adhesive may be an adhesive that includes relatively little (e.g., less than about 20ppm) or no ionic species that may affect device operation (e.g., migratory species in semiconductor devices) and/or that acts as a barrier to such ionic species.

In the case of a stacked arrangement, a bottom die may exhibit a larger diameter than a die stacked on top of the bottom die. Accordingly, for example, interconnections (e.g., wire bonds) may be placed from one die to another die and/or from each die to the underlying PCB. According to some example embodiments, processor 3754 may be a flip-chip combination, where die-to-die and/or die-to-PCB connections may be established using through-die connections and associated interconnections (e.g., a ball grid array (BGA)) with a flexible adhesive between bumps. In so doing, for example, each of the stacked die may exhibit the same or different diameters.

A flexible adhesive may mechanically connect surfaces, or mechanically and electrically connect surfaces, as desired. For example, a conductive, flexible adhesive may electrically connect a die to a conductive pad of a flexible substrate for bulk or body biasing of the die. As another example, an insulating, flexible adhesive may electrically isolate components of a die-to-substrate interface (e.g., BGA isolation).

One or more of the components shown in architecture 3750 may be configured to transmit information to processor 3754 and/or may be configured to receive information communicated by processor 3754. For example, one or more displays 3756 may be coupled to receive data from processor 3754. The data received from processor 3754 may include, for example, at least a portion of dynamic numbers and/or dynamic codes.

One or more displays 3756 may be, for example, touch sensitive, signal sensitive and/or proximity sensitive. For example, objects such as fingers, pointing devices, and the like may be brought into contact with displays 3756, or in proximity to displays 3756. Objects such as light and/or sound emitting device may be aimed at displays 3756. Detection of signals, object proximity or object contact with displays 3756 may be effective to perform any type of function (e.g., communicate data to processor 3754). Displays 3756 may have multiple locations that are able to be determined as being touched, or determined as being in proximity to an object. As one non-limiting example, display 3756 may be a thin film transistor (TFT) array (e.g., semiconductor oxide TFT array) configured to receive and emit light.

Input and/or output devices may be implemented on architecture 3750. For example, integrated circuit (IC) chip 3760 (e.g., an EMV chip) may be included within architecture 3750, that may communicate information to a chip reader (e.g., an EMV chip reader). Radio frequency identification (RFID) module 3762 may be included within architecture 3750 to enable the exchange of information with an RFID reader/writer.

Other input and/or output devices may be included within architecture 3750, for example, to provide any number of input and/or output capabilities. For example, input and/or output devices may include an audio and/or light device operable to receive and/or communicate audible and/or light-based information. Input and/or output devices may include a device that exchanges analog and/or digital data using a visible data carrier. Input and/or output devices may include a device, for example, that is sensitive to a non-visible data carrier, for example, an infrared data carrier or an electromagnetic data carrier.

Persons skilled in the art will appreciate that a card (e.g., card 3700 of FIG. 37) may, for example, include components (including other die components) on a mechanical carrier other than processor 3754. RFID 3762, IC chip 3760, memory 3753, a charge coupled device (CCD) (not shown), a semiconductor sensor (e.g., a complementary oxide semiconductor (CMOS) sensor)(not shown), a transducer (not shown), an accelerometer (not shown) and/or flex detector 3768 may, for example, each be flexibly adhered with a flexible adhesive to a flexible substrate, and/or to another component.

Flex detector 3768 may detect flexure of a device (e.g., card 3700). For example, flex detector 3768 may include a distortion detection element operable to detect an amount of flexure of a device. Flex detector 3768 may be, for example, a MEMS detector, piezoelectric element, detection circuitry, and/or the like.

Two or more device components may be stacked and interconnected. For example, two or more die may be flexibly adhered to each other and interconnected via wire-bonding, ball grid array, or other connection types. Accordingly, for example, surface area on the PCB may be conserved by adding components in vertical fashion rather than adding components laterally across the surface area of the PCB.

Persons skilled in the art will further appreciate that a card (e.g., card 3700 of FIG. 37) may, for example, be a self-contained device that derives its own operational power from one or more batteries 3758. One or more batteries 3758 may be included, for example, to provide operational power for a period of time (e.g., approximately 2-4 years). One or more batteries 3758 may be included, for example, as rechargeable batteries.

Electromagnetic field generators 3770-3774 of dynamic magnetic stripe communications device 3776 may be included within architecture 3750 to communicate information to, for example, a read-head of a magnetic stripe reader via, for example, electromagnetic signals. For example, electromagnetic field generators 3770-3774 may be included to communicate one or more tracks of electromagnetic data to read-heads of a magnetic stripe reader. Electromagnetic field generators 3770-3774 may include, for example, a series of electromagnetic elements. Each electromagnetic element may be implemented as a coil encircling one or more materials (e.g., a magnetic material and/or a non-magnetic material). Additional materials may be outside the coil (e.g., a magnetic material and/or a non-magnetic material).

Electrical excitation by processor 3754 of one or more coils of one or more electromagnetic elements via, for example, driving circuitry 3764 may generate electromagnetic fields from the one or more electromagnetic elements. One or more electromagnetic field generators 3770-3774 may be utilized to communicate electromagnetic information to, for example, one or more read-heads of a magnetic stripe reader.

Timing aspects of information exchange between architecture 3750 and the various I/O devices implemented within architecture 3750 may be determined by processor 3754. Detector 3766 may be utilized, for example, to sense the proximity and/or actual contact, of an external device, which in turn, may trigger the initiation of a communication sequence. The sensed presence and/or touch of the external device may then be communicated to a controller (e.g., processor 3754), which in turn may direct the exchange of information between architecture 3750 and the external device. The sensed presence and/or touch of the external device may be effective to, for example, determine the type of device or object detected.

For example, the detection may include the detection of a read-head of a magnetic stripe reader. In response, processor 3754 may activate one or more electromagnetic field generators 3770-3774 to initiate a communications sequence with, for example, one or more read-heads of a magnetic stripe reader. The timing relationships associated with communications between one or more electromagnetic field generators 3770-3774 and one or more read-heads of a magnetic stripe reader may be based on a detection of the magnetic stripe reader.

Persons skilled in the art will appreciate that processor 3754 may provide user-specific and/or card-specific information through utilization of any one or more of buttons 3710-3718, RFID 3762, IC chip 3760, electromagnetic field generators 3770-3774, and/or other input and/or output devices.

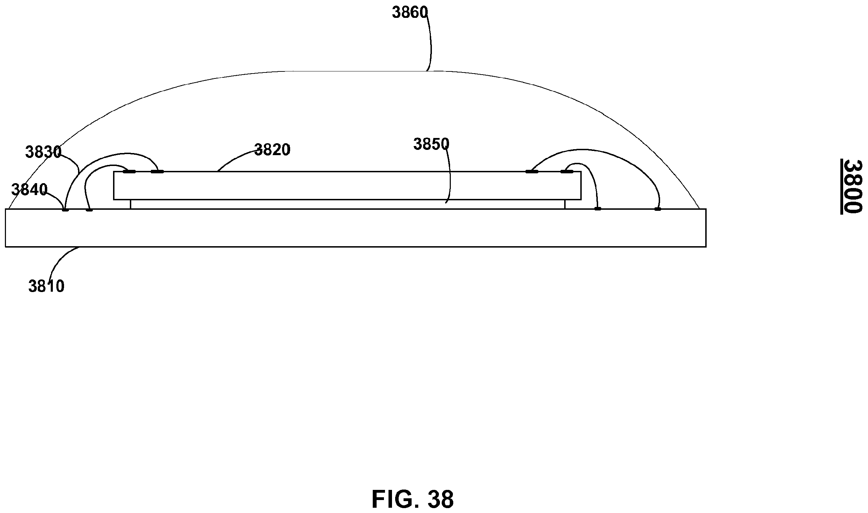

FIG. 38 shows a flexible assembly 3800 of a flexible device (e.g., a flexible powered card, mobile phone, computer, and/or the like). Referring to FIG. 38, flexible assembly 3800 may, for example, include flexible substrate 3810, die component 3820, bond wires 3830, bond pads 3840, flexible adhesive 3850 and encapsulant 3860.

Die component 3820 may include, for example, a thin monocrystalline semiconductor chip in packaged or unpackaged form. Die component 3820 may be, for example, a processors, ASIC, mixed-signal device, transistor device, and any other device. Die component 3820 may be thinned to increase flexibility and/or decrease thickness (e.g., by a grinding or polishing process). A thinning process may reduce a thickness of die component 3820 to a thickness of about 20 microns to 0.00025 inches. A thickness of die component 3820 in a stacked configuration may be, for example, about 0.00025 inches to 0.008 inches (e.g., approximately 0.004 inches). A thickness of an unstacked die may be about 0.0018 inches to about 0.0065 inches.

Flexible substrate 3810 may be a flexible printed circuit board (PCB) with, for example, a thickness of about 0.001 inches to about 0.003 inches (e.g., without PIC coatings). A material of flexible substrate 3810 may include, for example, polyimide, polyester, an organic polymer thermoplastic, laminate material (e.g., FR-4), a liquid crystal polymer, a combination of these materials and/or the like.

Die cracks may be a mode of device failure during flexure. Die cracks may occur due to, for example, flexing of dies adhered to substrates, wrinkled substrates causing uneven force transfer during device flexure and/or a failure to achieve a solid cure/bond between a die and a substrate.

Die component 3820 may be adhered to flexible substrate 3810 by flexible adhesive 3850. Properties of flexible adhesive 3850 may include no/low ionic contamination (e.g., less than about 20ppm for anions or cations, for example, Na+, K+, Cl-, F- and the like), low modulus (e.g., about 0.2 to about 0.05 GPa at 25 degrees centigrade), high stability (e.g., a coefficient of thermal expansion of about 20 to about 100 ppm per degree centigrade) and robust glass transition properties (e.g., a $T_G$ of below about 0 degrees centigrade). Flexible adhesive 3850 may be non-anaerobic. A non-anaerobic adhesive may be an adhesive with a bonding strength that is generally independent of oxygen contaminants at a bonding surface. Flexible adhesive 3850 may be conductive and/or non-conductive, and may be, for example, about 0.0008 to about .0012 inches thick.

Flexible adhesive 3850 may flexibly adhere die component 3820 (or a non-die component) to flexible substrate 3810 such that force transfer to die component 3820 may be attenuated during bending of a device including flexible assembly 3800 (e.g., a powered card and/or flexible mobile phone).

A material of flexible adhesive 3850 may change physical state (e.g., change from a liquid substance to a solid substance) when cured by one or more conditions (e.g., air, heat, pressure, light, and/or chemicals) for a period of time. Flexible adhesive 3850 may be cured, but may remain flexible, so that flexible substrate 3810 may be flexed to exhibit either of a convex or concave shape, while returning to a substantially flat orientation once flexing ceases. Flexure of die component 3820 and/or force transfer by flexible substrate 3810 to die component 3820, may be reduced.

Mechanical and/or electrical interconnections between die component 3820 and flexible substrate 3810 may, for example, include bond wires 3830. Bond wires 3830 may be connected to, for example, bond pads 3840 on flexible substrate 3810, and bond pads 3840 on die component 3820. Electrical and/or mechanical interconnections between die component 3820 and flexible substrate 3810 may, for example, include solder balls (not shown). Electrical and/or mechanical interconnections between die component 3820 and flexible substrate 3810 may, for example, include flip-chip solder balls of a ball grid array.

Bond pads 3840 may include a conductive material. For example, bond pads 3840 may include aluminum, nickel, gold, copper, silicon, palladium silver, palladium gold, platinum, platinum silver, platinum gold, tin, kovar (e.g., nickel-cobalt ferrous alloy), stainless steel, iron, ceramic, brass, conductive polymer, zinc and/or carbide. The conductive material of a bond pad 3810 may be a solder, a flexible printed circuit board trace and/or the like. According to one non-limiting example embodiment, bond pads 3840 may be a multi-layer structure (not shown) including a copper (Cu) layer on flexible substrate 3810, a nickel (Ni) layer on the Cu layer and a gold (Au) layer on the Ni layer.

Bond pads 3840 may be deposited, for example, by thin or thick film deposition (e.g., plating, electroplating, physical vapor deposition (evaporation, sputtering and/or reactive PVD), chemical vapor deposition (CVD), plasma enhanced CVD, low pressure CVD, atmosphere pressure CVD, metal organic CVD, spin coating, conductive ink printing and/or the like. Bond pads 3840 may be, for example, magnetic, paramagnetic, solid, perforated, conformal, non-conformal and/or the like. Bond pads 3840 may each include a same or different material.

Bond wires 3830 may include a conductive material. For example, bond wires 3830 may include aluminum, nickel, gold, copper, silicon, palladium silver, palladium gold, platinum, platinum silver, platinum gold, tin, kovar (e.g., nickel-cobalt ferrous alloy), stainless steel, iron, ceramic, brass, conductive polymer, zinc and/or carbide. The conductive material of a bond wire 3830 may be coated (e.g., with an insulating material to reduce shorting and/or a conductive material). The material of a bond wire 3830 may be, for example, magnetic, paramagnetic, solid, perforated, stranded, braided, and/or the like.

Bond wires 3830 may be wire bonded to bond pads 3840. Wire bonding may be performed using any wire bonding method. For example, wire bonding may include hand bonding, automated bonding, ball bonding, wedge bonding, stitch bonding, hybrid bonding, a combination of bonding methods and/or the like. Bond wires 3830 may each include a same or different material. A material of a bond wire 3830 may be the same or different from a material of a bonding pad 3840. Each of bond wires 3830 may include one or more materials and/or layers.

Through-die vias may, for example, provide electrical connectivity between die component 3820, flexible substrate 3810 and other components (not shown). For example, electrical signals may be communicated between die component 3820, flexible substrate 3810 and other components using conductive vias that may extend through die component 3820.

Flexible assembly 3800 may include encapsulant 3860, which may include a layer of material (e.g., a material including one or more polyurethane-based and/or silicon-based substances). A material of encapsulant 3860 may be a substance that changes its physical state (e.g., changes from a liquid substance to a solid substance) when cured by one or more conditions (e.g., air, heat, pressure, light, and/or chemicals) for a period of time. Encapsulant 3860 may be hardened, but may remain flexible, so that flexible assembly 3800 may be flexed to exhibit either of a convex or concave shape, while returning to a substantially flat orientation once flexing ceases.

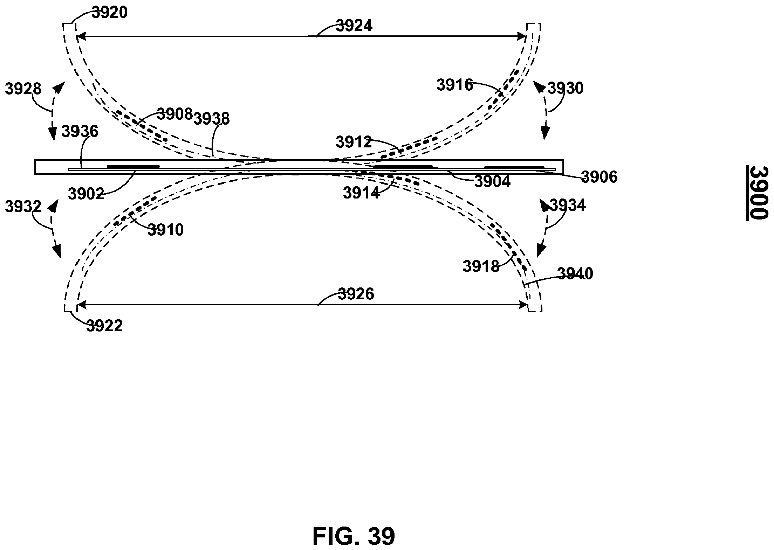

FIG. 39 shows device 3900. Referring to FIG. 39, device 3900 may, for example, be a laminated assembly including flexible substrate 3936, top and bottom layers of a material (e.g., polymer top and bottom layers), and components 3902, 3904 and 3906.

Components 3902-3906 may be dies (e.g., stacked or non-stacked dies) and/or other components (e.g., a photosensitive device, a sensor, a transducer and/or an accelerometer). Components 3902-3906 may be flexibly adhered to flexible substrate 3936 and/or encapsulated with a flexible material. The encapsulant and/or adhesive may be cured (e.g., hardened) such that device 3900 may be rigid, yet flexible, while attenuating force transfer to components 3902-3906 during flexure.

Components 3902-3906 may be thinned components. Thinning of components 3902-3906 (e.g., via a grinding or polishing process) may increase the flexibility of components 3902-3906 and may, for example, decrease a bend radius at which damage to a component begins to occur.

When device 3900 is flexed, an amount of force exerted on components 3902-3908 may be less than an amount of force exerted on flexible substrate 3936 and/or outer layers of device 3900. When device 3900 is flexed, an amount of flexure of components 3902-3908 may be less than an amount of flexure of flexible substrate 3936 and/or outer layers of device 3900.

One or more detectors (not shown) may be placed within device 3900 to detect an amount of flexure of device 3900 and generate a signal in response. Based on the signal, a light source may be turned on or off, and/or operation of device 3900 may be altered.

Device 3900 may be flexed in direction 3928 and/or 3930 to bend device 3900 into a concave orientation having minimum bend radius 3924. Components 3902-3906 may assume positions 3908-3916, respectively, and flexible substrate 3936 may assume position 3938, as a result of such flexing. Components 3902-3906 may be flexibly adhered to flexible substrate 3936, encapsulated with a flexible material and/or thinned such that flexing may not destroy the operation of components 3902-3906, and a change in the operation of components 3902-3906 due to flexure may be reduced.

Device 3900 may be flexed in direction 3932 and/or 3934 to bend device 3900 into a convex orientation having minimum bend radius 3926. Components 3902-3906 may assume positions 3910-3918, respectively, and flexible substrate 3936 may assume position 3940, as a result of such flexing. Components 3902-3906 may be flexibly adhered to flexible substrate 3936, encapsulated with a flexible material and/or thinned such that flexing may not destroy the operation of components 3902-3906, and a change in the operation of components 3902-3906 due to flexure may be reduced.

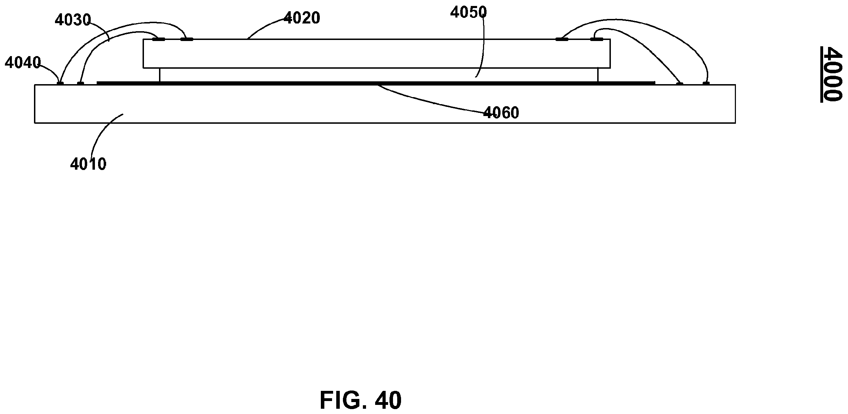

FIG. 40 shows a flexible assembly 4000 of a flexible device (e.g., a flexible card, mobile phone, computer, and/or the like). Referring to FIG. 40, flexible assembly 4000 may, for example, include a flexible substrate 4010, die component 4020, bond wires 4030, bond pads 4040, flexible adhesive 4050 and conductive pad 4060.

Die component 4020 may include, for example, a semiconductor chip in packaged or unpackaged form. Die component 4020 may be, for example, a processors, ASIC, mixed-signal device, thin-film transistor device, and any other device. Die component 4020 may be thinned, for example, by a grinding or polishing process. A thinning process may reduce a thickness of die component 4020 to a thickness of about 20 microns to 0.00025 inches. A thickness of die component 4020 in a stacked configuration may be, for example, about 0.00025 inches to .008 inches (e.g., approximately 0.004 inches). Die component 4020 may be attached to a mechanical carrier.

Flexible substrate 4010 may be a flexible printed circuit board (PCB). A material of flexible substrate 4010 may include, for example, polyimide, polyester, an organic polymer thermoplastic, laminate material (e.g., FR-4), liquid crystal polymer, a combination of these materials and/or the like. Conductive pad 4060 may be on flexible substrate 4010, and may include one or more conductive materials. For example, conductive pad 4060 may be a multi-layer structure (not shown) including a copper (Cu) layer on flexible substrate 4010, a nickel (Ni) layer on the Cu layer and a gold (Au) layer on the Ni layer.

Die component 4020 may be adhered to conductive pad 4060 by flexible adhesive 4050. Properties of flexible adhesive 4050 may include no/low ionic contamination, low modulus, high stability and robust glass transition properties.

Flexible adhesive 4050 may flexibly adhere die component 4020 (or a non-die component) to conductive pad 4060 such that force transfer may be attenuated during bending of a device including flexible assembly 4000 (e.g., a flexible computing device). Flexible adhesive 4050 may be conductive and/or non-conductive. For example, die component 4020 may be a body/bulk biased component conductively adhered to conductive pad 4060 by a conductive flexible adhesive 4050.

A material of flexible adhesive 4050 may change physical state (e.g., change from a liquid substance to a solid substance) when cured by one or more conditions (e.g., air, heat, pressure, light, and/or chemicals) for a period of time. Flexible adhesive 4050 may be cured, but may remain flexible, so that flexible substrate 4010 may be flexed to exhibit either of a convex or concave shape, while returning to a substantially flat orientation once flexing ceases. Flexure of die component 4020 and/or force transfer by flexible substrate 4010 to die component 4020, may be reduced.

Mechanical and/or electrical interconnections between die component 4020 and flexible substrate 4010 may, for example, include bond wires 4030. Bond wires 4030 may be connected to, for example, bond pads 4040 on flexible substrate 4010 and die component 4020. Electrical and/or mechanical interconnections between die component 4020 and flexible substrate 4010 may, for example, include solder balls (not shown). Electrical and/or mechanical interconnections between die component 4020 and flexible substrate 4010 may, for example, include flip-chip solder balls of a ball grid array.

Through-die vias may, for example, provide electrical connectivity between die component 4020, flexible substrate 4010 and other components (not shown). For example, electrical signals may be communicated between die component 4020, flexible substrate 4010 and other components using conductive vias that may extend through die component 4020, and may be electrically interconnected via solder balls of a ball grid array. Flexible assembly 4000 may include an encapsulant (not shown).

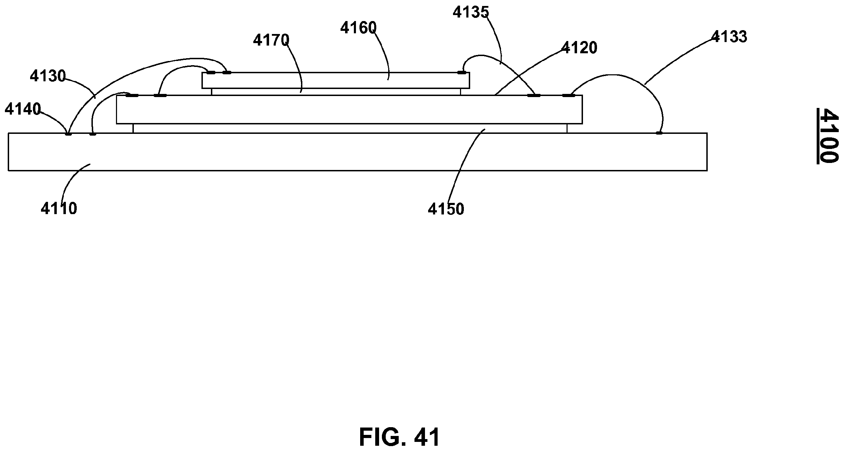

FIG. 41 shows a flexible assembly 4100 of a flexible device (e.g., a flexible processing device). Referring to FIG. 41, flexible assembly 4100 may, for example, include a flexible substrate 4110, stacked components 4120 and 4160 (e.g., stacked dies), bond wires 4130, 4133 and 4135, bond pads 4140, and flexible adhesives 4150 and 4170.

Flexible assembly 4100 may include stacked components 4120 and 4160 (e.g., stacked dies). Stacked components 4120 and 4160 may, for example, include one or more processors, ASICs, mixed-signal devices, transistor devices, light sensing devices, wafer sensors, transducers, accelerometers and the like. Stacked components 4120 and 4160 may, for example, be thinned (e.g., via a grinding or polishing process). Such a thinning process may reduce a thickness of stacked components 4120 and 4160 to a thickness of about 20 microns to 0.010 inches. A thickness of a component (e.g., a die) may be thinned to about 0.00025 inches to 0.008 inches (e.g., approximately 0.004 inches).

Flexible substrate 4110 may be, for example, a flexible printed circuit board (PCB). A material of flexible substrate 4110 may include, for example, polyimide, polyester, an organic polymer thermoplastic, laminate materials (e.g., FR-4), liquid crystal polymer, a combination of these materials and/or the like.

Stacked component 4120 may or may not be a flexible component, and may be adhered to flexible substrate 4110 by flexible adhesive 4150. Flexible adhesive 4150 may be a flexible, non-anaerobic, low ionic, flexible adhesive. Properties of flexible adhesive 4150 may include no/low ionic contamination, low modulus, high stability and robust glass transition properties. Stacked component 4160 may or may not be a flexible component, and may be adhered to stacked component 4120 by flexible adhesive 4170. Flexible adhesive 4170 may be the same adhesive as, or a different adhesive from, flexible adhesive 4150, and may be a flexible, non-anaerobic, low ionic, flexible adhesive.

Mechanical and/or electrical interconnections between stacked components 4120 and 4160, and flexible substrate 4110 may, for example, include bond wires 4130 and 4133. Mechanical and/or electrical interconnections between stacked component 4120 and stacked component 4160 may, for example, include bond wires 4135.

Stacked component 4160 may be of a smaller diameter as compared to stacked component 4120. Bond wire connections between stacked components 4120 and 4160, between stacked component 4120 and flexible substrate 4110, and between component 4160 and flexible substrate 4110 may be facilitated. A plan view (not shown) of component 4120, component 4160, and flexible substrate 4110 may, for example, illustrate that bond pads 4140 associated with bond wires 4130, 4133 and 4135 may be staggered so as to substantially reduce a possibility of shorting bond wires to interconnect pads not associated with such bond wires.

Electrical and/or mechanical interconnections between stacked component 4120, stacked component 4160 and flexible substrate 4110 may, for example, include solder balls (not shown), conductive pads (not shown) and/or the like. Accordingly, for example, stacked components 4120 and 4160 may be of the same, or different, diameters. Persons of ordinary skill in the art in possession of example embodiments will appreciate that although FIG. 41 shows two stacked components, example embodiments are not so limited. Any number of components may be stacked and flexibly adhered.

Through-component vias (e.g., through-die vias) may, for example, provide electrical connectivity between any one or more of stacked components 4120 and 4160, and flexible substrate 4110. For example, electrical signals may be communicated between stacked components 4120 and 4160, and between any one or more of stacked components 4120 and 4160, and flexible substrate 4110, using conductive vias that may extend through components 4120 and 4160.

Flexible assembly 4100 may include a flexible encapsulant (not shown). Accordingly, for example, flexible assembly 4100 may be cured, but may remain flexible, so that a flexible device including flexible assembly 4100 may be flexed to exhibit either a convex or concave shape, while returning to a substantially flat orientation once flexing ceases, and reducing and/or eliminating damage to components.

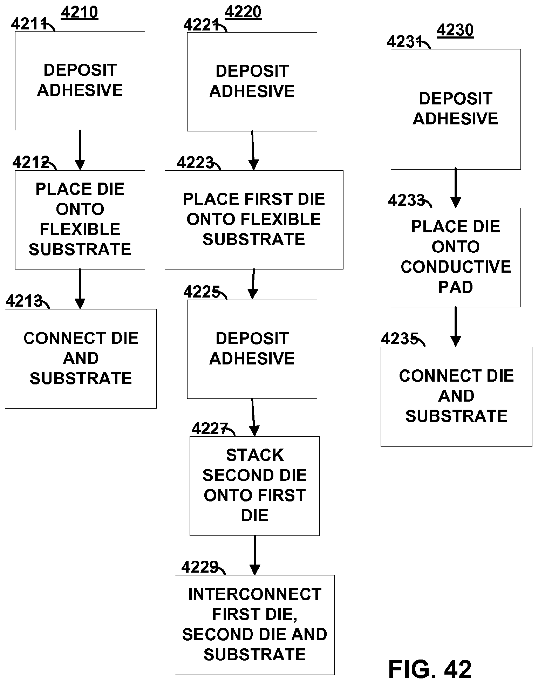

FIG. 42 shows a flow diagram of process sequences. Referring to FIG. 42, step 4211 of sequence 4210 may include, for example, depositing a flexible, non-anaerobic, low ionic adhesive on a flexible substrate. For example, the material of the flexible adhesive may be deposited as a glob top material on the flexible substrate and/or by selectively depositing the flexible adhesive on the flexible substrate. According to some example embodiments, the flexible adhesive may be deposited onto a die and not the flexible substrate, or onto the die and the flexible substrate.

A die may be placed onto the flexible substrate (e.g., using pick and place) as in step 4212. The flexible adhesive between the flexible substrate and the die may not extend beyond the edges of the die after placement. The die may be connected to the flexible substrate via bond pads and wires, and/or solder bumps as in step 4213.

Step 4221 of sequence 4220 may, for example, include depositing a first flexible, non-anaerobic, low ionic adhesive onto a flexible substrate. For example, the material of the first flexible adhesive may be deposited as a glob top material on the flexible substrate and/or by selectively depositing the first flexible adhesive onto the flexible substrate. According to some example embodiments, the first flexible adhesive may be deposited onto a first die and not the flexible substrate, and/or onto the first die and the flexible substrate.

A first die may be placed onto the flexible substrate (e.g., using pick and place) as in step 4223. The flexible adhesive between the flexible substrate and the first die may not extend beyond the edges of the die after placement.

A second flexible, non-anaerobic, low ionic adhesive may be deposited onto the first die as in step 4225. For example, the material of the second flexible adhesive may be deposited as a glob top material onto an opposite side of the first die from the first flexible adhesive and/or by selectively depositing the second flexible adhesive onto the opposite side. According to some example embodiments, the second flexible adhesive may be deposited onto a second die and not the first die, and/or onto the first die and the second die.

A second die, of a smaller width than a width of the first die, may be placed onto the first die (e.g., using pick and place), within the footprint of the first die, as in step 4227. The flexible adhesive between the first die and the second die may not extend beyond the edges of the second die after placement. The first die, second die and flexible substrate may be interconnected via bond pads and wires, and/or solder bumps as in step 4229.

According to some example embodiments, stacked dies may be of reduced thickness (e.g., by utilizing a grinding and/or polishing process) to accommodate stacking. For example, a die containing a processor may be placed onto the flexible substrate and another die containing an ASIC may be stacked on top of the die containing the processor. Yet another die (e.g., a die containing mixed-mode electronics or other circuitry) may be stacked onto the die containing the ASIC to yield a three-die stack. Accordingly, for example, by stacking die, surface area of the PCB may be conserved. Such a stacked-die arrangement may be used to produce devices, such as a powered card, a telephonic device (e.g., a cell phone), an electronic tablet, a watch, or any other device. Such a stacked-die arrangement may be encapsulated between two layers of laminate material (e.g., polymer material), injected with an encapsulant, and hardened to produce a rigid, yet flexible device.

Each of the stacked die may be interconnected to each other and/or one or more of the stacked die may be interconnected to signal traces on the flexible substrate. By way of example, such interconnections may be implemented via wire bonds, whereby wires may be attached to interconnect pads of each die. Such wire bonding may be facilitated by placing larger diameter die at the bottom of the stack while placing smaller diameter die in order of decreasing diameter on top of the larger diameter die. In addition, interconnect pads may be staggered (e.g., no interconnect pads of any die or substrate may be directly adjacent to one another in a plan view) to reduce a possibility that wire bonds may make electrical contact with interconnect pads not intended for that wire bond. According to at least one example embodiment, for example, each stacked die may be substantially the same diameter and may be interconnected to each other and the PCB using through-die vias and ball grid array interconnections.

Step 4231 of sequence 4230 may, for example, include depositing a flexible, non-anaerobic, low ionic adhesive onto a conductive pad of a flexible substrate. For example, the material of the flexible adhesive may be deposited as a glob top material on the conductive pad and/or by selectively depositing the flexible adhesive on the conductive pad. According to some example embodiments, the flexible adhesive may be deposited onto a die and not the conductive pad, and/or onto the die and the conductive pad.

A die may be placed onto the conductive pad of the flexible substrate (e.g., using pick and place) as in step 4233. The flexible adhesive between the conductive pad and the die may not extend beyond the edges of the die after placement. The die may be connected to the flexible substrate away from the conductive pad via bond pads and wires, and/or solder bumps as in step 4235.

Persons skilled in the art will appreciate that the present invention is not limited to only the embodiments described. Instead, the present invention more generally involves dynamic information and the exchange thereof. Persons skilled in the art will also appreciate that the apparatus of the present invention may be implemented in other ways than those described herein. All such modifications are within the scope of the present invention, which is limited only by the claims that follow.

**Claims**

1. A method, comprising:

   detecting, by a card, an object (1610) with a capacitive sensor (1614);
   activating an inductive sensor (1528); and
   detecting conductivity, by the card, using the inductive sensor.

2. The method of claim 1, further comprising:

   activating a third type of sensor; and
   detecting an ambient property using the third type of sensor.

3. The method of claim 1, further comprising:

   activating a third type of sensor; and
   detecting an ambient property using the third type of sensor,
   wherein the third type of sensor is a photoelectric sensor.

4. The method of any preceding claim, further comprising:

   activating a dynamic magnetic stripe communications device (1530) upon the detection of the object (1610) by the capacitive sensor (1614) and the detection of the conductivity by the inductive sensor (1528).

5. A card, comprising:

   a capacitive sensor (1614) operable to detect an external object (1610);
   an inductive sensor (1528) operable to detect conductivity of the external object; and
   a processor (1518) operable to communicate data based on the detection of the external object (1610) and the conductivity of the external object (1610).

6. The card of claim 5, further comprising:

   a dynamic magnetic stripe communications device (1530),
   wherein the processor (1518) is operable to communicate data via the dynamic magnetic stripe communications device (1530), and
   the inductive sensor (1528) includes at least a portion of the dynamic magnetic stripe communications device (1530).

7. The card of claim 5, further comprising:

a dynamic magnetic stripe communications device (1530),
wherein the processor (1518) is operable to communicate data via the dynamic magnetic stripe communications device (1530),
the dynamic magnetic stripe communications device (1530) includes at least one coil, and
the inductive sensor (1528) includes at least a portion of one coil selected from the group consisting of the at least one coil and a separate coil.

8. The card of any of claims 5 to 7, wherein the inductive sensor (1528) includes at least two coils.

9. The card of claim 5, further comprising:

a third sensor,
wherein the third sensor is a type of sensor selected from the group consisting of a photoelectric sensor, a magnetic sensor, a thermal sensor and a sonic sensor.

10. The card of any of claims 5 to 9, further comprising an oscillator.

11. The card of any of claims5 to 10, further comprising an amplification and detection determination device (1720, 1730).

12. The card of any of claims 5 to 10, further comprising:

at least one amplification and detection determination device (1720, 1730),
wherein the processor (1518) is operable to communicate data based on an output of the at least one amplification and detection determination device (1720, 1730).

13. The card of any of claims 5 to 12, further comprising:

a display; and
a button.

14. The card of any of claims 5 to 13, further comprising:

an RFID; and
an EMV chip.

**Patentansprüche**

1. Verfahren, umfassend:

Erfassen eines Objekts (1610) mit einem kapazitiven Sensor (1614) durch eine Karte;
Aktivieren eines induktiven Sensors (1528); und
Erfassen einer Leitfähigkeit durch die Karte unter Verwendung des induktiven Sensors.

2. Verfahren gemäß Anspruch 1, ferner aufweisend:

Aktivieren eines dritten Typs eines Sensors; und
Erfassen einer Umgebungseigenschaft unter Verwendung des dritten Sensortyps.

3. Verfahren gemäß Anspruch 1, ferner umfassend:

Aktivieren eines dritten Typs eines Sensors; und
Erfassen einer Umgebungseigenschaft unter Verwendung des dritten Sensortyps,
wobei der dritte Sensortyp ein photoelektrischer Sensor ist.

4. Verfahren gemäß einem der vorhergehenden Ansprüche, ferner umfassend:

Aktivieren einer dynamischen Magnetstreifenkommunikationsvorrichtung (1530) ausgehend von der Erfassung des Objekts (1610) durch den kapazitiven Sensor (1614) und der Erfassung der Leitfähigkeit durch den induktiven Sensor (1528).

5. Karte, aufweisend:

einen kapazitiven Sensor (1614) zum Erfassen eines externen Objekts (1610);
einen induktiven Sensor (1528) zum Erfassen einer Leitfähigkeit des externen Objekts; und
einen Prozessor (1518) zum Kommunizieren von Daten basierend auf der Erfassung des externen Objekts (1610) und der Leitfähigkeit des externen Objekts (1610).

6. Karte gemäß Anspruch 5, ferner aufweisend:

eine dynamische Magnetstreifenkommunikationsvorrichtung (1530),
wobei der Prozessor (1518) ausgelegt ist, um Daten mittels der dynamischen Magnetstreifenkommunikationsvorrichtung (1530) zu kommunizieren, und
der induktive Sensor (1528) mindestens einen Abschnitt der dynamischen Magnetstreifenkommunikationsvorrichtung (1530) beinhaltet.

7. Karte gemäß Anspruch 5, ferner aufweisend:

eine dynamische Magnetstreifenkommunikationsvorrichtung (1530),
wobei der Prozessor (1518) ausgelegt ist, um Daten mittels der dynamischen Magnetstreifenkommunikationsvorrichtung (1530) zu kommunizieren,
die dynamische Magnetstreifenkommunikationsvorrichtung (1530) mindestens eine Spule beinhaltet, und
der induktive Sensor (1528) mindestens einen Abschnitt einer Spule beinhaltet, die von der Gruppe ausgewählt wird, die aus der mindestens einen Spule und einer separaten Spule besteht.

8. Karte gemäß einem der Ansprüche 5 bis 7, wobei der induktive Sensor (1528) mindestens zwei Spulen beinhaltet.

9. Karte gemäß Anspruch 5, ferner aufweisend:

einen dritten Sensor,
wobei der dritte Sensor ein Typ eines Sensors ist, der von der Gruppe ausgewählt wird, die aus einem photoelektrischen Sensor, einem Magnetsensor, einem thermischen Sensor und einem Schallsensor besteht.

10. Karte gemäß einem der Ansprüche 5 bis 9, ferner einen Oszillator aufweisend.

11. Karte gemäß einem der Ansprüche 5 bis 10, ferner eine Verstärkungs- und Erfassungsbestimmungsvorrichtung (1720, 1730) aufweisend.

12. Karte gemäß einem der Ansprüche 5 bis 10, ferner aufweisend:

mindestens eine Verstärkungs- und Erfassungsbestimmungsvorrichtung (1720, 1730),
wobei der Prozessor (1518) ausgelegt ist, um Daten basierend auf einer Ausgabe der mindestens einen Verstärkungs- und Erfassungsbestimmungsvorrichtung (1720, 1730) zu kommunizieren.

13. Karte gemäß einem der Ansprüche 5 bis 12, ferner aufweisend:

eine Anzeige; und
eine Taste.

14. Karte gemäß einem der Ansprüche 5 bis 13, ferner aufweisend:

eine RFID; und
einen EMV-Chip.

**Revendications**

1.  Procédé comprenant :

    la détection, par une carte, d'un objet (1610) avec un capteur capacitif (1614) ;
    l'activation d'un capteur inductif (1528) ; et
    la détection d'une conductivité, par la carte, en utilisant le capteur inductif.

2.  Procédé selon la revendication 1, comprenant en outre :

    l'activation d'un troisième type de capteur ; et
    la détection d'une propriété ambiante en utilisant le troisième type de capteur.

3.  Procédé selon la revendication 1, comprenant en outre :

    l'activation d'un troisième type de capteur ; et
    la détection d'une propriété ambiante en utilisant le troisième type de capteur, dans lequel le troisième type de capteur est un capteur photoélectrique.

4.  Procédé selon l'une quelconque des revendications précédentes, comprenant en outre :

    l'activation d'un dispositif de communication à bande magnétique dynamique (1530) lors de la détection de l'objet (1610) par le capteur capacitif (1614) et la détection de la conductivité par le capteur inductif (1528).

5.  Carte comprenant :

    un capteur capacitif (1614) utilisable pour détecter un objet externe (1610) ;
    un capteur inductif (1528) utilisable pour détecter une conductivité de l'objet externe ; et
    un processeur (1518) utilisable pour communiquer des données sur la base de la détection de l'objet externe (1610) et la conductivité de l'objet externe (1610).

6.  Carte selon la revendication 5, comprenant en outre :

    un dispositif de communication à bande magnétique dynamique (1530),
    dans lequel le processeur (1518) est utilisable pour communiquer des données par le biais du dispositif de communication à bande magnétique dynamique (1530), et
    le capteur inductif (1528) comprend au moins une portion du dispositif de communication à bande magnétique dynamique (1530).

7.  Carte selon la revendication 5, comprenant en outre :

    un dispositif de communication à bande magnétique dynamique (1530),
    dans lequel le processeur (1518) est utilisable pour communiquer des données par le biais du dispositif de communication à bande magnétique dynamique (1530),
    le dispositif de communication à bande magnétique dynamique (1530) comprend au moins une bobine, et
    le capteur inductif (1528) comprend au moins une portion d'une bobine sélectionnée à partir du groupe comprenant l'au moins une bobine et une bobine séparée.

8.  Carte selon l'une quelconque des revendications 5 à 7, dans laquelle le capteur inductif (1528) comprend au moins deux bobines.

9.  Carte selon la revendication 5, comprenant en outre :

    un troisième capteur,
    dans lequel le troisième capteur est un type de capteur sélectionné à partir du groupe comprenant un capteur photoélectrique, un capteur magnétique, un capteur thermique et un capteur à ultrasons.

10. Carte selon l'une quelconque des revendications 5 à 9, comprenant en outre un oscillateur.

**11.** Carte selon l'une quelconque des revendications 5 à 10, comprenant en outre un dispositif de détermination de détection et d'amplification (1720, 1730).

**12.** Carte selon l'une quelconque des revendications 5 à 10, comprenant en outre :

au moins un dispositif de détermination de détection et d'amplification (1720, 1730), dans lequel le processeur (1518) est utilisable pour communiquer des données sur la base d'une sortie de l'au moins un dispositif de détermination de détection et d'amplification (1720, 1730).

**13.** Carte selon l'une quelconque des revendications 5 à 12, comprenant en outre :

un dispositif d'affichage ; et
un bouton.

**14.** Carte selon l'une quelconque des revendications 5 à 13, comprenant en outre :

une RFID ; et
une puce EMV.

EP 2 805 348 B1

**100**

DYNAMIC MAGNETIC STRIPE COMMUNICATIONS DEVICE

102

Memory (e.g., flex code) 149

Dynamic Card No.          Dynamic Code

A
(0,1)    110

**1234 - 5678** **- 90123 - 4567**    **890**

104          106          108

B
(2,3)    C
(4,5)    114    D
(6,7)

112          116

E
(8,9)

120    118    122

**NAME: JEFFREY_MULLEN_S32S**

---

**150**

152    Memory
(e.g., flex code)    154    156

STACKED-DIE
PROCESSOR    Display    Battery

162    RFID

IC
Chip    164    DRIVING
CIRCUITRY

160    170    176

158

DETECTOR    172    OTHER
I/O

174    168

166

**FIG. 1**

**200**

FIG. 2

**300**

FIG. 3

**400**

FIG. 4

**FIG. 5**

**610**

611 — REDUCE THICKNESS OF DIE

612 — ROLL DIE ONTO TAPE REEL

613 — RETRIEVE DIE FROM TAPE REEL DURING PICK AND PLACE

**620**

621 — PLACE REDUCED THICKNESS DIE ONTO CARRIER

622 — STACK REDUCED THICKNESS DIE ONTO OTHER DIE

623 — INTERCONNECT DIE

**630**

631 — PLACE REDUCED THICKNESS DIE ONTO CARRIER

632 — MONITOR OPERATION OF DIE

633 — DETECT A FLEXING EVENT BASED ON CHANGED OPERATION OF DIE

634 — REACT TO THE DETECTED CHANGE IN OPERATION

**FIG. 6**

**FIG. 7**

700

DYNAMIC MAGNETIC STRIPE COMMUNICATIONS DEVICE

705

710 ① ② 720     730 ③ ④ 735

Feature 1   Feature 2      Feature 3   Feature 4

7242 - 7464 - 84139 - 0000   | 890 |

740     745

747   NAME: JEFFREY_MULLEN_42

787

753 Memory   755   757 Display   760 Battery

763   765 RFID

IC Chip

767 DRIVING CIRCUITRY

PROCESSOR

790

770 Read Head Detect   773   775   780 Read Head Detect

750   777

785

**800**

FIG. 8

**900**

FIG. 9

**1000**

**FIG. 10**

**1100**

FIG. 11

**FIG. 12**

**FIG. 13**

EP 2 805 348 B1

FIG. 14

EP 2 805 348 B1

**FIG. 15**

EP 2 805 348 B1

**FIG. 16**

EP 2 805 348 B1

## 1700

1705  1710  1715

1720

OUT1

1725  CTRL  1730  OUT2

PROCESSOR

1735

# FIG. 17

## 1800

1805

1810

1815

1820

OUT1

1825

CTRL

1830

OUT2

PROCESSOR

1835

# FIG. 18

## 1900

FIG. 19

## 2000

**2010**

2011 — DETECT SENSOR STATE CHANGE IN FIRST TYPE OF SENSOR

2012 — ACTIVATE SECOND TYPE OF SENSOR

2013 — DETERMINE SENSOR STATE IN SECOND TYPE SENSOR

2014 — ACTIVATE COMMUNICATION SEQUENCE

**2020**

2021 — ACTIVATE COMMUNICATION SEQUENCE

2022 — DETECT SENSOR STATE CHANGE IN FIRST TYPE OF SENSOR

2023 — ACTIVATE LOW-POWER MODE

## FIG. 20

**FIG. 21**

EP 2 805 348 B1

FIG. 22

EP 2 805 348 B1

2300

NON-TIME
SMEARING GAIN
ALGORITHM

2330

PROCESSOR

2318  2328

2320

DETECTION
CIRCUITRY

DYNAMIC MAGNETIC STRIPE
COMMUNICATIONS DEVICE

2302
2304
2306
2308

• • • •

• • • •

2316
2314
2312
2310

2326

2322 →

← 2324

**FIG. 23**

EP 2 805 348 B1

FIG. 24

FIG. 25

FIG. 26

## 2710

**2711** — DETECT PROPERTY CHANGE IN A PAD DURING A FIRST TIME PERIOD

**2712** — DETECT PROPERTY CHANGE IN THE PAD DURING A SECOND TIME PERIOD

**2713** — DISALLOW DETECTED PROPERTY CHANGE IN FIRST TIME PERIOD TO AFFECT DETECTED PROPERTY CHANGE IN SECOND TIME PERIOD

**2714** — ACTIVATE COMMUNICATION SEQUENCE

## 2720

**2721** — DETECT PROPERTY CHANGE IN A PAD OF A FIRST SET OF PADS DURING A FIRST TIME PERIOD

**2722** — DETECT PROPERTY CHANGE IN THE PAD OF THE FIRST SET OF PADS DURING A SECOND TIME PERIOD

**2723** — PREPARE FOR COMMUNICATIONS SEQUENCE

**2724** — DETECT PROPERTY CHANGE IN A PAD OF A SECOND SET OF PADS DURING A THIRD TIME PERIOD

**2725** — DETECT PROPERTY CHANGE IN THE PAD OF THE SECOND SET OF PADS DURING A FOURTH TIME PERIOD

**2726** — ACTIVATE COMMUNICATION SEQUENCE

**FIG. 27**

FIG. 28

EP 2 805 348 B1

FIG. 29

EP 2 805 348 B1

3040 3050 3020 3010

3010

III'  III

3060

3050

3052

3054

3056

3058

FIG. 30

**FIG. 31**

## 3200

**FIG. 32**

**FIG. 33**

## <u>3400</u>

FIG. 34

**FIG. 35**

## 3600

**FIG. 36**

3700

DYNAMIC MAGNETIC STRIPE COMMUNICATIONS DEVICE

Dynamic Card No.                    Dynamic Code

A
(0,1)   3710

1234 - 5678   - 90123 - 4567   890

3704            3706            3708

B        C        D
(2,3)   (4,5)   (6,7)

3712    3714    3716

E
(8,9)

3720    3718

NAME: JEFFREY_MULLEN_S32S          3722    Light Source   3723

3750    3752   Memory          3754    3756

PROCESSOR   ←→   Display        Battery

3762   RFID

IC
Chip              DRIVING
CIRCUITRY        3758

3760    3764        3776

3770        FLEX
DETECTOR

DETECTOR              3772   3768

3766                  3774

FIG. 37

**3800**

FIG. 38

3900

FIG. 39

**4000**

FIG. 40

**4100**

FIG. 41

**4230**

4231 — DEPOSIT ADHESIVE → 4233 — PLACE DIE ONTO CONDUCTIVE PAD → 4235 — CONNECT DIE AND SUBSTRATE

**4220**

4221 — DEPOSIT ADHESIVE → 4223 — PLACE FIRST DIE ONTO FLEXIBLE SUBSTRATE → 4225 — DEPOSIT ADHESIVE → 4227 — STACK SECOND DIE ONTO FIRST DIE → 4229 — INTERCONNECT FIRST DIE, SECOND DIE AND SUBSTRATE

**4210**

4211 — DEPOSIT ADHESIVE → 4212 — PLACE DIE ONTO FLEXIBLE SUBSTRATE → 4213 — CONNECT DIE AND SUBSTRATE

**FIG. 42**

**EP 2 805 348 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20040179718 A1
- US 20090159663 A1